# EUROPEAN PATENT SPECIFICATION

(11) **EP 1 615 118 B1**
(45) Date of publication and mention of the grant of the patent: **29.11.2017**
(21) Application number: 05254080.4
(22) Date of filing: 29.06.2005
(51) Int. Cl.: G06F 3/033, G06F 9/44

(54) **Management of multiple window panels with a graphical user interface**
Verwaltung von mehreren Fenstern in einer Grafischen Benutzeroberfläche
Gestion de plusieurs fenêtres dans une interface utilisateur graphique

(30) Priority: 29.06.2004 US 881650
(43) Date of publication of application: 11.01.2006
(60) Divisional application: 13185626.2
(73) Proprietor: ACD Systems International Inc., Victoria, BC V9B 4L5 (CA)
(72) Inventor: Landman, Philip, Davie, FL 33328 (US); De Soto, Joaquin, Coral Gables, FL 33143 (US)
(74) Representative: Taylor, Adam David

(56) References cited:
- US-A- 5 801 699
- US-A- 5 977 973
- "Inside Mac OS X, Handling Carbon Windows and Controls" September 2002 (2002-09), APPLE COMPUTER, INC. , CUPERTINO, CA, USA , XP002536251 * page 101 - page 105 *
- E. KANDOGAN, B. SHNEIDERMAN: "Elastic Windows: evaluation of multi-window operations" PROCEEDINGS OF THE SIGCHI CONFERENCE ON HUMAN FACTORS IN COMPUTING SYSTEMS, [Online] 22 March 1997 (1997-03-22), pages 250-257, XP002536250 New York, NY, USA ISBN: 0-89791-802-9 Retrieved from the Internet: URL:http://portal.acm.org/citation.cfm?id= 258720> [retrieved on 2009-07-09]
- D. ROSENTHAL, S. W. MARKS: "Inter-Client Communication Conventions Manual - Section 4: Client to Window Manager Communication" [Online] September 2002 (2002-09), SUN MICROSYSTEMS, INC. , XP002536252 Retrieved from the Internet: URL:http://tronche.com/gui/x/icccm/> [retrieved on 2009-07-09] * section 4 *
- "The Windows Interface Guidelines for Software Design" May 1995 (1995-05), MICROSOFT PRESS , XP002561843 ISBN: 1556156790 * page 277 - page 337 *
- Microsoft: "Windows XP - Guidelines for Applications" 5 March 2002 (2002-03-05), XP002561842 Retrieved from the Internet: URL:http://www.microsoft.com/whdc/System/p latform/pcdesign/XPguidelines.mspx> [retrieved on 2009-12-09]

## Description

The present invention relates to management of window panels generated within software applications.

Professional software applications generally offer a lot of special features. Graphics applications, for example, operate through objects and layers. Objects typically include vector primitives such as character fonts, points, lines and areas, as well as raster images. Layers include one or more objects, and are composited together in a variety of ways. User actions are applied through tools for curves, rectangles, ellipses, text, brush strokes, color fills, erasers, and much more. Tools may have many controls associated therewith, for setting and adjusting properties such as size, thickness, shape, color and opacity. Objects are generated and modified using palettes.

Users taking advantage of the many features of professional software applications quickly find themselves buried with window panels on the display screen.

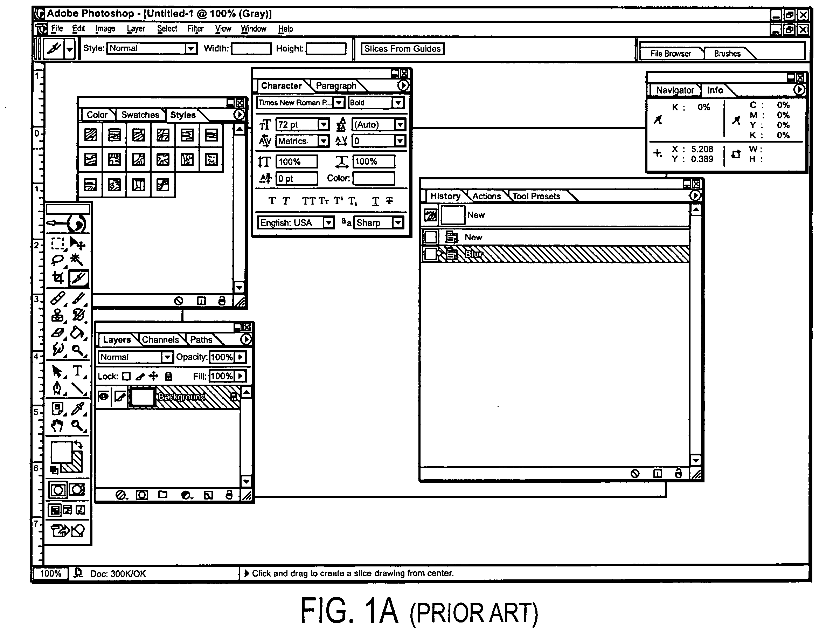

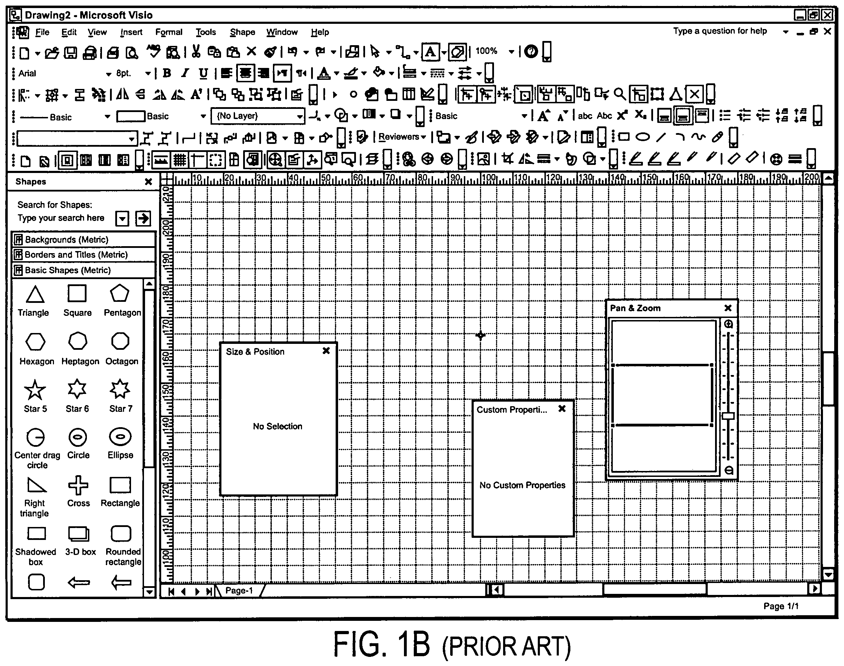

FIGS. 1A and 1B are two examples of graphic applications, illustrating an abundance of window panels for tools and palettes that are accessible. As can be seen, the window panels confine and clutter a user's working space, and the user spends a lot of time and effort in moving the window panels around.

There is therefore a need for a systematic way to manage multiple window panels for software applications so as to maintain their accessibility, while making it easy for a user to use them to perform tasks within the software applications.

Another drawback of professional software applications is that although a wide variety of controls are available, for each state that the application is in, only a subset of controls is relevant. As states dynamically change, a user often needs help in finding the appropriate subset of controls for a current state.

There is therefore also a need for a systematic way to manage controls, so that an appropriate subset of controls for a current state of the application is always readily available to the user.

Professional software applications such as graphics programs often provide a variety of features through the use of palettes and toolboxes. Palettes are used to provide alternatives for a specific type of user action. A familiar example of a palette is a color palette, used to provide a user with choices of a color for filling in an area of a graphic, or for a background, or for a border, or for other parts of an object. Another example of a palette is a combine palette, used to provide different alternative ways to combine two objects that overlap one on top of the other. Generally, each palette is displayed within its own window panel of an application program, and professional applications may provide so many different palettes, that management of the window panels can become complicated and difficult.

Toolboxes are used to provide many tools for use within an application, such as a tool for brush strokes, a tool for generating curves, a tool for generating rectangles, a tool for generating circles, a tool for erasers and a tool for text. In turn, some of the tools within a toolbox may themselves use a variety of specific sub-tools. Similar to window panels for palettes, window panels for toolboxes can also become complicated and difficult to manage.

"The Windows Interface Guidelines for Software Design", May 1995, Microsoft Press, XP002561843, ISBN 1556156790 discloses a user interface with an object sensitive menu bar.

The present invention provides a method as defined in claim 1, a user interface as defined in claim 5 and a computer readable storage medium storing program code as defined in claim 9. Certain preferred embodiments of the present invention will now be described by way of example only and with reference to the accompanying drawings in which:
FIGS. 1A and 1B are prior art illustrations of window panels displayed within a graphics software application;
FIGS. 2A - 2D are illustrations of docking window panels;
FIGS. 3A - 3J are illustrations of fastening window panels together;
FIGS. 4A - 4G are illustrations of fastening parent and child window panels together and locking the child window panels;
FIGS. 5A - 5D are illustrations of a multi-page property bar;
FIG. 5E is a prior art illustration of a property bar displayed within a software application;
FIGS. 6A - 6F are illustrations of a context-dependent property bar, in accordance with a preferred embodiment of the present invention; and
FIG. 7 is a simplified block diagram of a system for managing context-dependent property bars, in accordance with a preferred embodiment of the present invention.

The appendices listed below are included as part of the description, and for convenience are placed at the end of the main body of the description.

Appendix A is a detailed listing of computer source code written in the C++ programming language for implementing a preferred embodiment for managing window panels that can be fastened together in unions, and in conjunction with a Microsoft Windows™ operating system.

Appendix B is a detailed listing of computer source code written in the C++ programming language for implementing a preferred embodiment for managing window panels that can have parent-child relationships, and in conjunction with a Microsoft Windows operating system.

Appendix C is a detailed listing of computer source code written in the C++ programming language for implementing a preferred embodiment for managing context-sensitive property bars and multi-page property bars, in accordance with the present invention, and in conjunction with a Microsoft Windows™ operating system

The present invention provides a method and system for managing multiple window panels within a software application. Using the present invention, a large number of window panels can be made readily accessible as a user works within the software application, without confining the user's workspace and cluttering up a display screen.

The present invention is preferably implemented within a conventional computing device including a central processing unit, memory units for storing programs and data, input devices including a mouse and keyboard, and an output display device. Preferably, the central processing unit, memory units, and device drivers for the mouse, keyboard and display are coupled communicatively together using a conventional data bus. It may be appreciated, however, from the description hereinbelow, that the present invention may also be implemented within nonconventional computing devices, as long as such devices include processing means, program and data storage means, and input and display means that inter-communicate. The present invention can be implemented within a standalone computer, or within one or more networked computers.

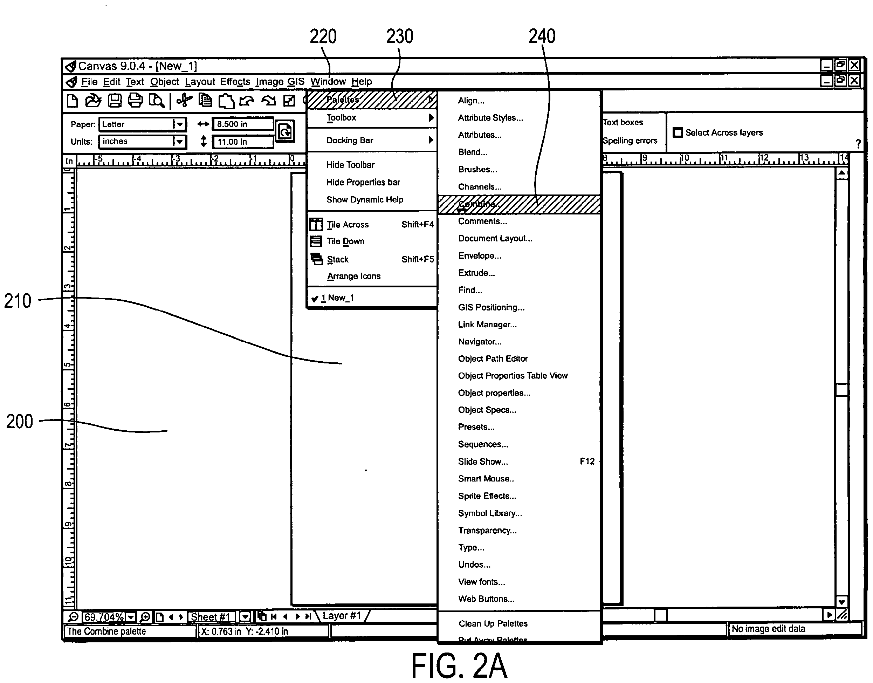

Reference is now made to FIGS. 2A - 2C, which are illustrations of docking window panels Shown in FIG. 2A is a master window 200 for a software application manufactured and marketed by ACD Systems, Inc. named Canvas™. Canvas is a professional graphics program that provides a wide range of graphics capabilities, generally accessed through tools and palettes.

As shown in FIG. 2A, a user has opened a blank document 210 and selected "Window" 220 in the menu bar. Upon clicking on "Window" 220, a first pop up list is displayed, and the user has selected "Palettes" 230. Upon clicking on "Palettes" a second pop up list is displayed, including a list of many palettes. The user has selected a "Combine" palette 240.

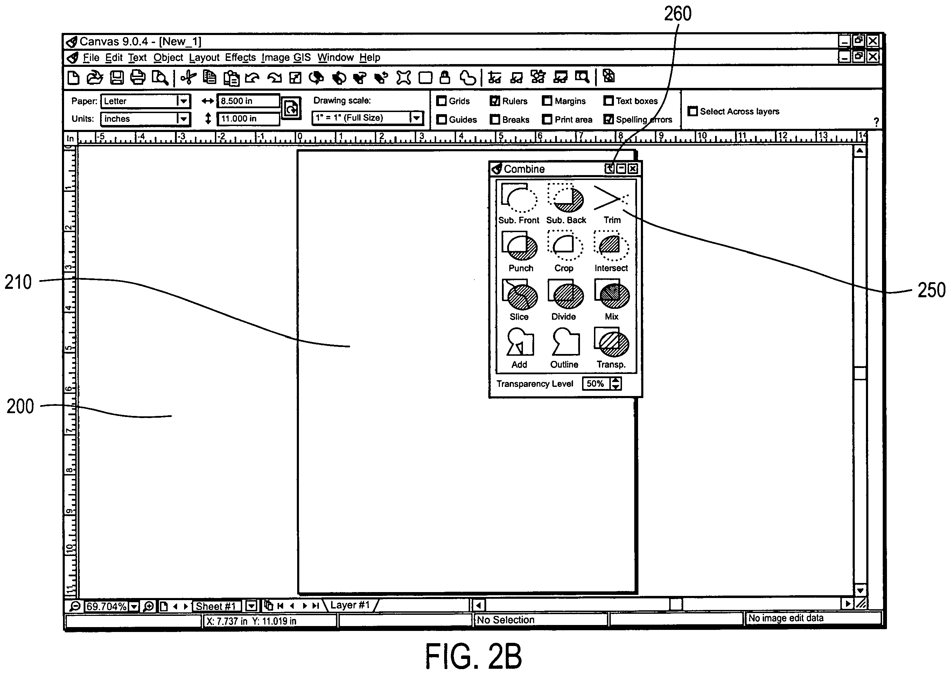

Shown in FIG. 2B is a window panel 250 that includes icons for the combine palette. Each icon represents a different combine operation, for combining two objects. Near the top right corner of window panel 250 is a button 260 for docking the panel.

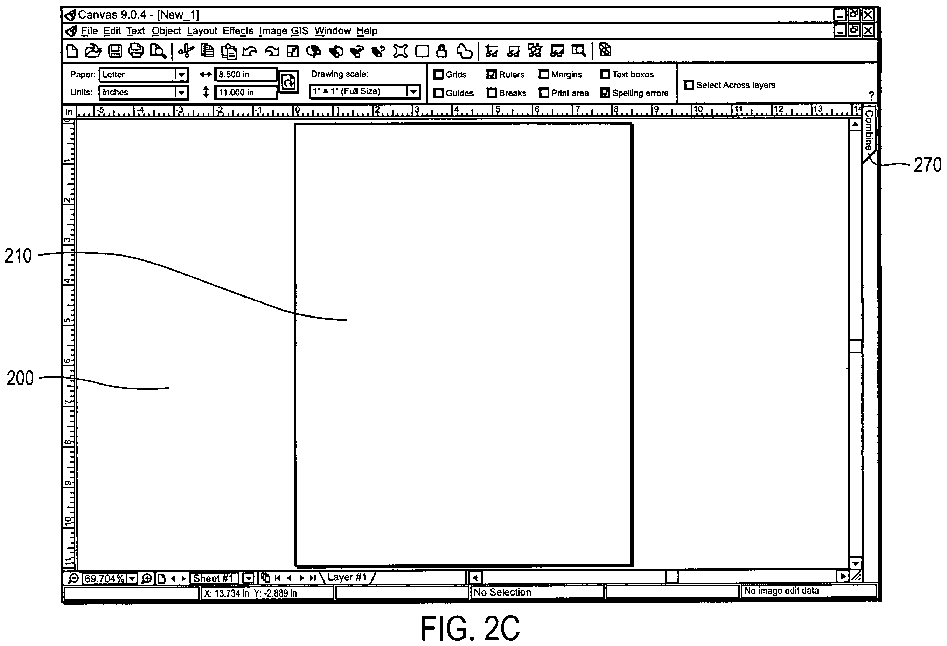

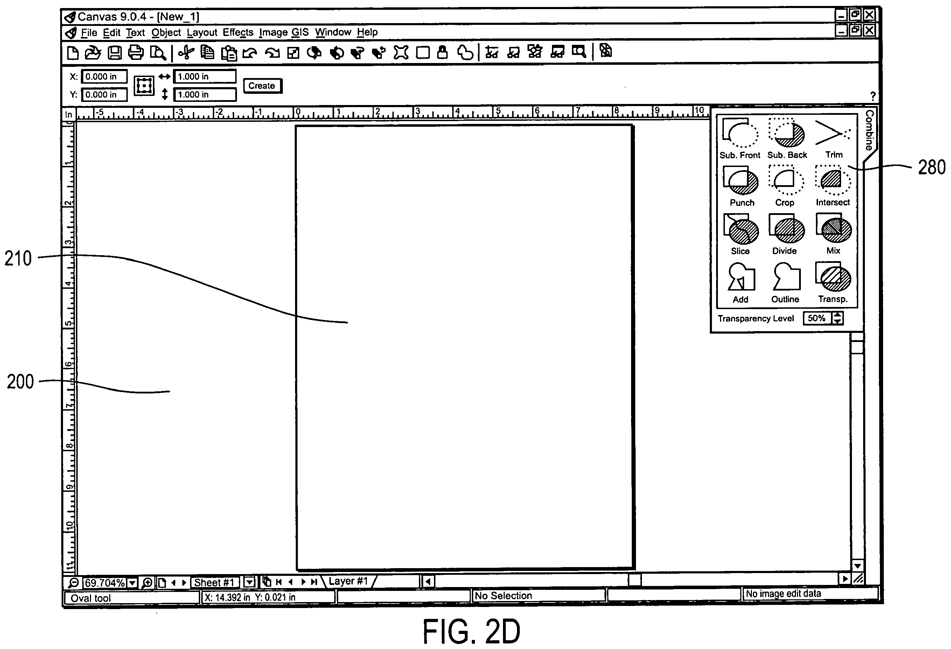

Shown in FIG. 2C is a tab 270 indicating that window panel 250 has been docked. Window panel 250 no longer appears in the Canvas application window, but it can be re-displayed by clicking on tab 270. In an example, when a user clicks on tab 270, the combine palette is displayed in an area 280 adjacent and to the left of tab 270, as shown in FIG. 2D. If the user subsequently clicks on tab 270 again, or clicks anywhere outside of the combine palette, the palette is re-docked. If the user clicks on tab 270 and, while a mouse button is depressed, moves the mouse pointer, then window panel 250 is opened at the location where the mouse button is released, as in FIG. 2B.

It often occurs with professional graphics applications that a user opens many palettes while working on graphics and, unless managed properly, the palettes can clutter the application window, making it difficult for the user to work. Docking of palettes is a convenient way to keep the palettes in a ready state, while not cluttering the application window.

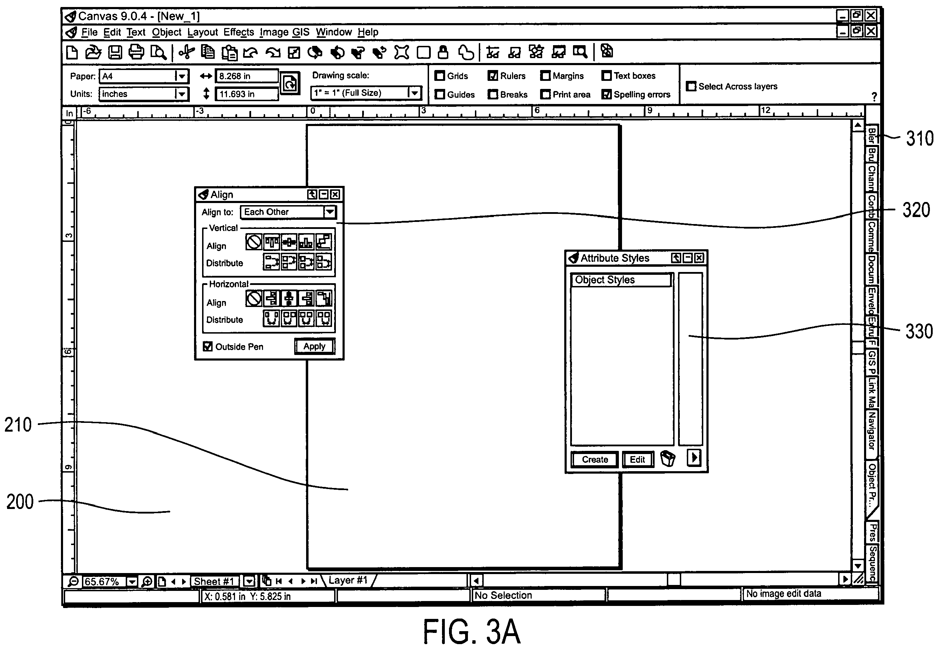

Reference is now made to FIGS. 3A - 3J, which are illustrations of fastening window panels together. Shown in FIG. 3A are docked palettes, indicated by display tabs such as tab 310 for a "Blend" palette. As shown in FIG. 3A, a user has opened two palettes; namely, an "Align" palette displayed in window panel 320, for aligning graphic objects, and an "Attribute Styles" palette displayed in window panel 330, for setting and changing object attribute styles. Each of the window panels 320 and 330 can be moved independently by pressing on a mouse button while the mouse pointer is positioned over a window panel, and moving the mouse pointer while the mouse button remains depressed, as is conventional with windows.

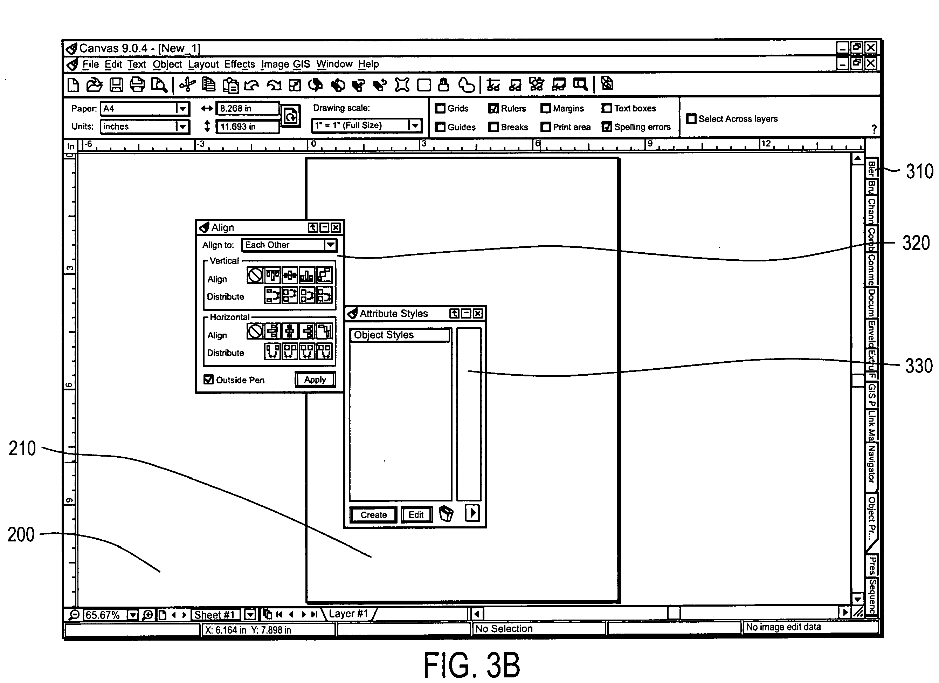

FIG. 3B shows that the user has moved window panel 330 in close proximity to window panel 320. In accordance with an example, when window panels 320 and 330 are in close proximity of one another, they snap together as a union and behave as a single area, where a "union" denotes a combination of one or more window panels that are fastened together and move together rigidly.

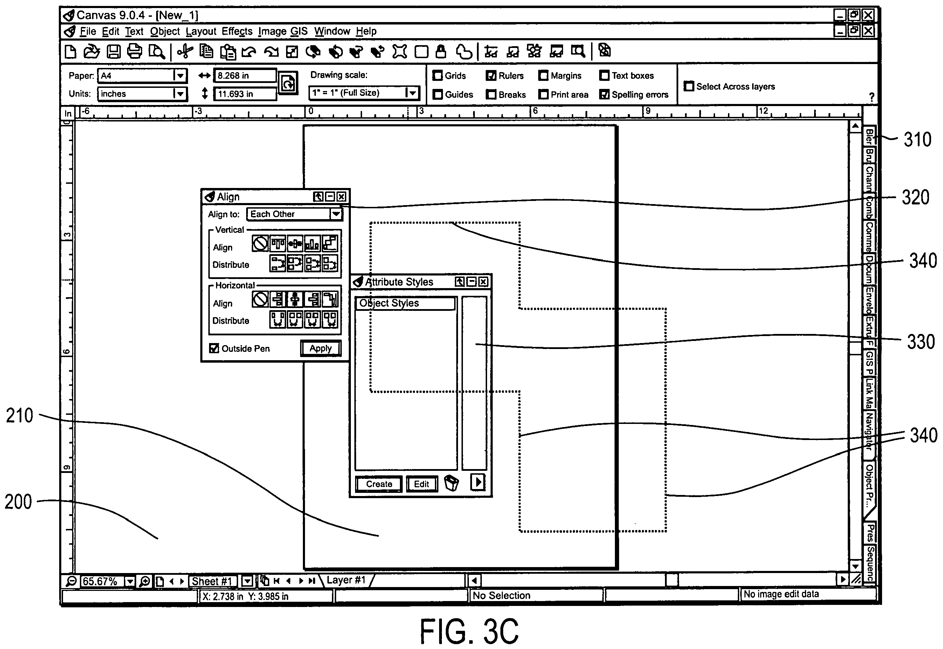

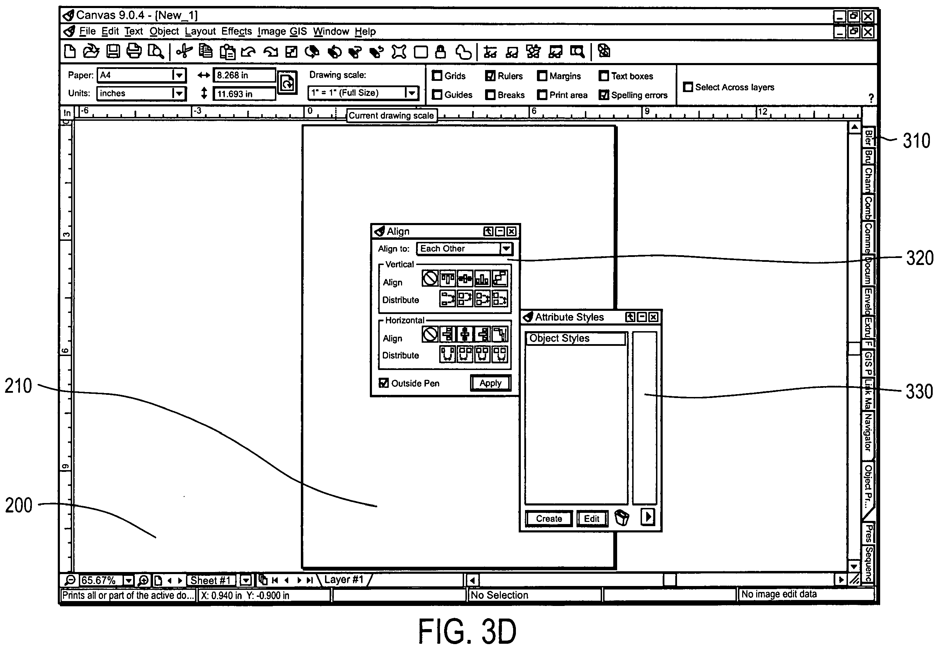

Specifically, as shown in FIG. 3C, when either window panel 320 and 330 is moved, both panels move together in unison. While the mouse button is depressed, an outline 340 is displayed as the mouse pointer is moved, indicating an area into which window panels 320 and 330 would be moved if the mouse button were released. As shown in FIG. 3D, when the mouse button is subsequently released, window panels 320 and 330 move together rigidly into the area that corresponds to outline 340.

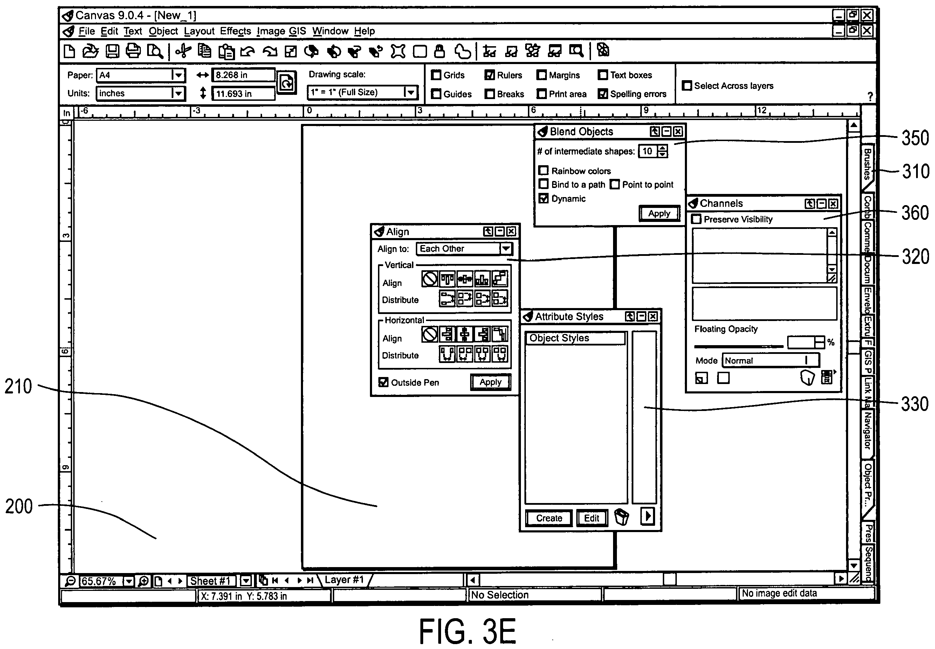

Shown in FIG. 3E are two additional window panels that are fastened together as a union. Window panel 350 includes a "Blend" palette, for blending objects, and window panel 360 includes a "Channels" palette for color channels. Window panels 350 and 360 were also in close proximity to one another, and snapped together similar to window panels 320 and 330. Each of the two-panel unions, panels 320/330 and panels 350/360, moves as a single area, and can be moved independently of the other union.

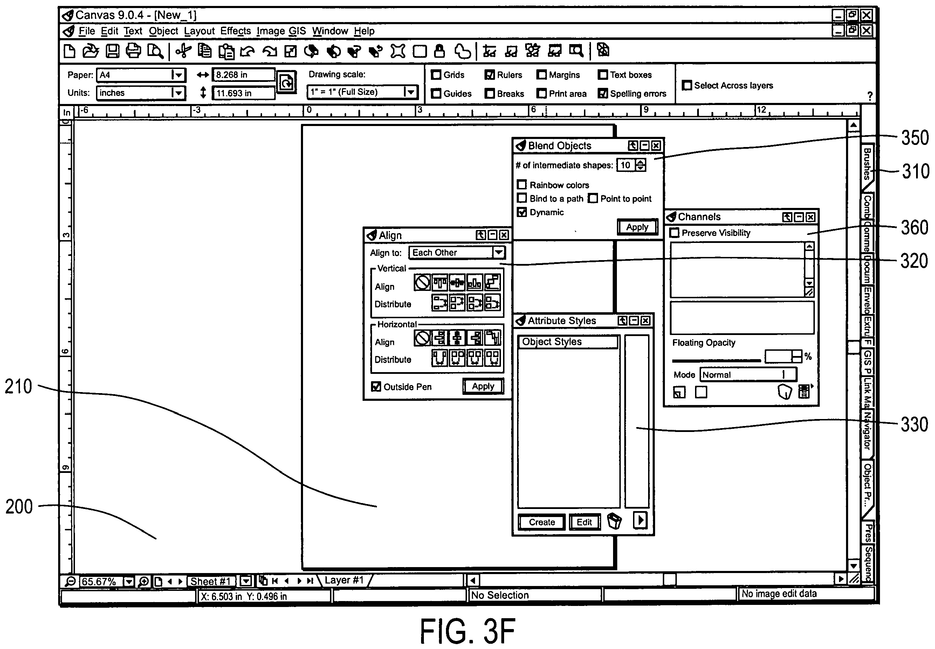

As shown in FIG. 3F, the user has moved the union 350/360 in close proximity to the union 320/330, and the two two-panel unions have fastened together to form a single four-panel union including panels 320, 330, 350 and 360. Specifically, panel 350 was moved to close proximity of panel 320, which triggered the fastening together of the two unions. The four-panel union behaves rigidly as a single area, and moving any one of the four panels causes the other three panels to move in unison.

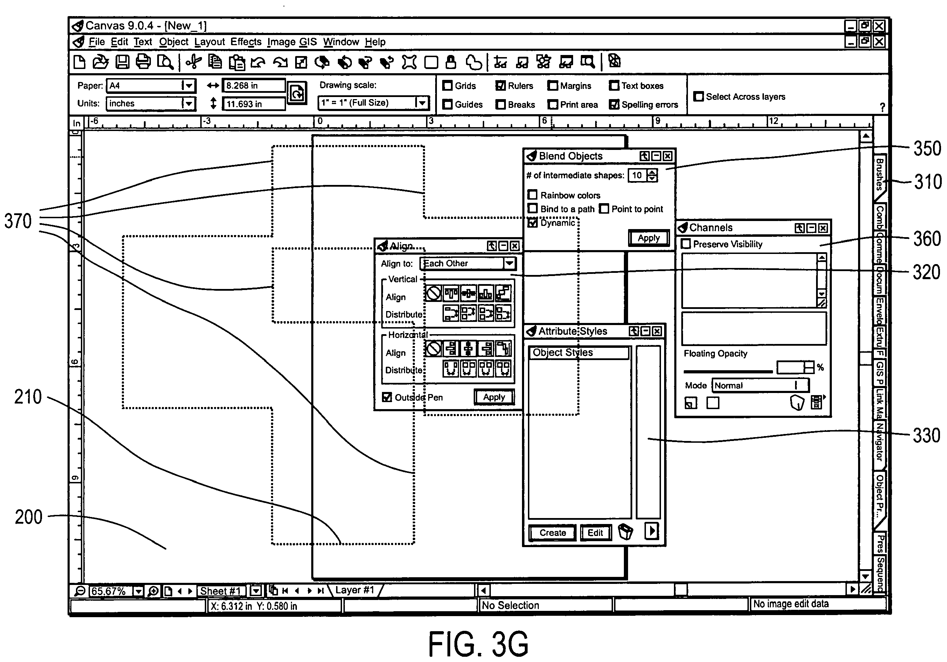

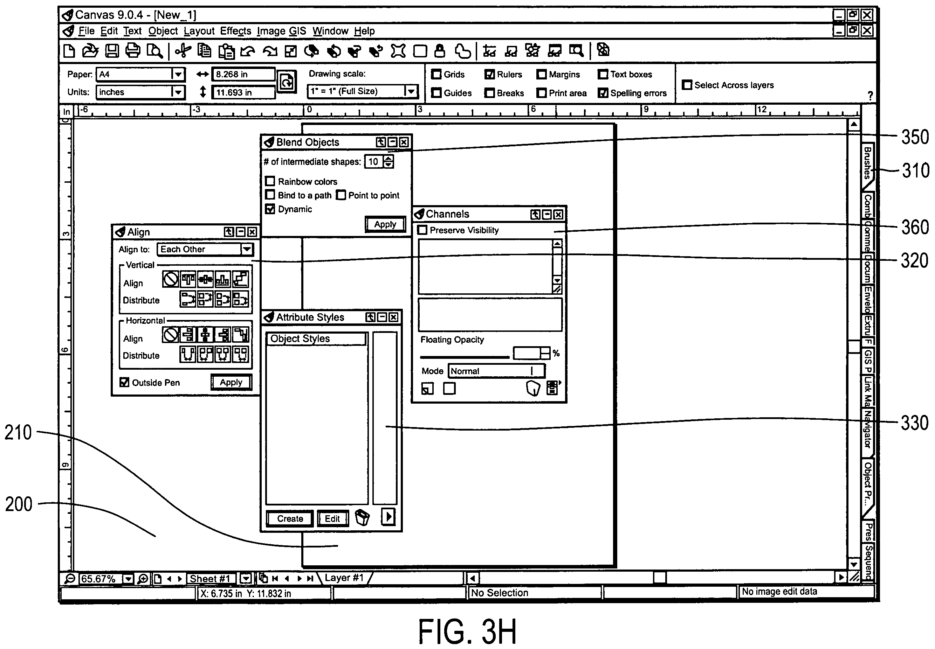

FIG. 3G shows what happens when a user presses the mouse button while the mouse pointer is positioned over one of the four panels 320, 330, 350 and 360, and moves the mouse pointer while the mouse button remains depressed. An outline 370 of the area covered by the four panels moves along with the mouse pointer, indicating where the union will be moved if the mouse button is released. FIG. 3H shows how the union has been moved into the position of outline 370.

In an example, the user is able to break apart a union of window panels into two smaller unions. Specifically, two actions are enabled:
Use of the shift key: If the user moves a window panel that is part of a union of panels while pressing and holding down the "shift" key of a keyboard, then that window panel alone is moved and separated from the union, and the other panels remain fixed.

Use of the control key: If the user moves a window panel that is part of a union of panels while pressing and holding down the "control" key of the keyboard, then that window panel and all other window panels of the union that are positioned below and to the right of it are moved and separated from the original union as a smaller union, while the other panels remain fixed.

Positioning of a window panel is preferably determined by the coordinates of the top left corner of the panel, although other conventions may be used, such as a different corner of the panel or the center of the panel. Coordinates are generally measured within the display screen relative to the top left corner of the screen. A first panel positioned at (*x*, *y*) within the display screen, is positioned below and to the right of a second panel positioned at (*u,* v) within the screen, if *u* ≤ *x* and *v* ≤ *y.*

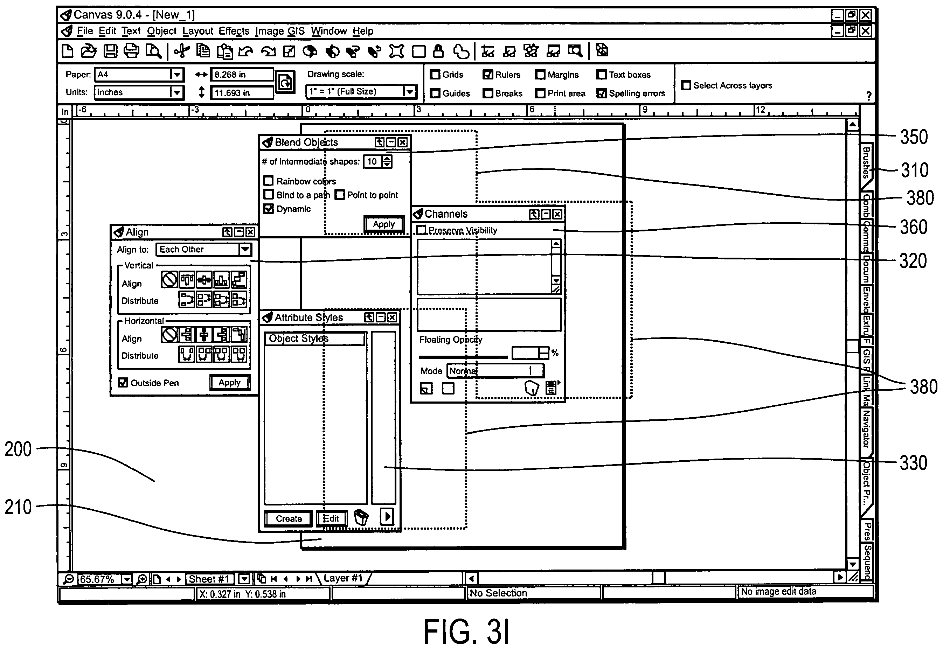

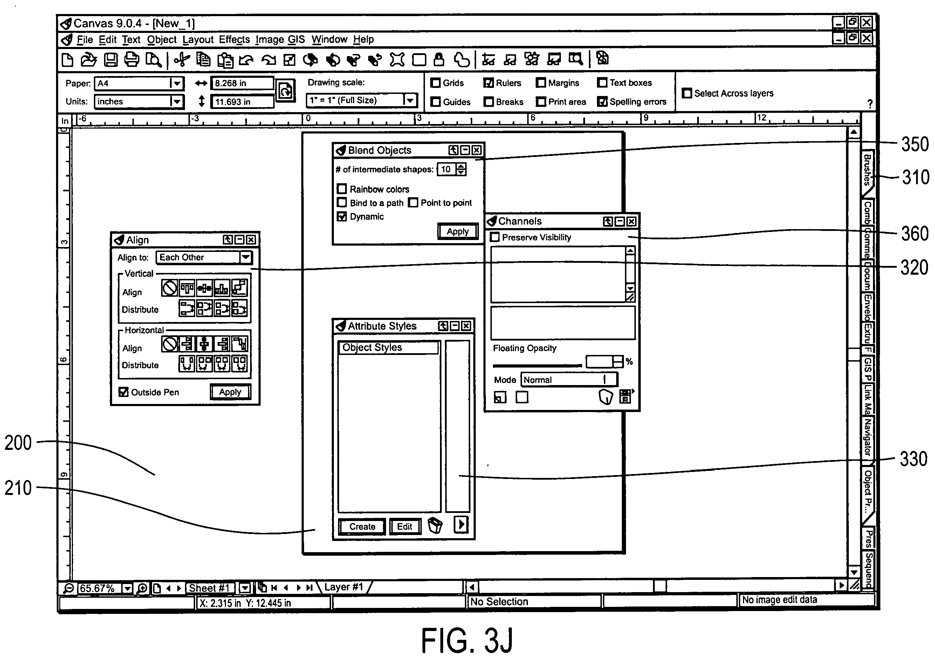

Referring to FIG. 3I, window panels 330 and 360 are each positioned below and to the right of window panel 350. As such, if panel 350 is moved while the control key is depressed, panels 330 and 360 are moved together with it, but panel 320 remains fixed. This action breaks apart the four-panel union 320/330/350/360 into a three-panel union 330/350/360 and a single-panel union 320. An outline 380 in the shape of the three-panel union indicates the place where this union will be positioned if the mouse button is released. FIG. 3J shows the three-panel union 330/350/360 having been moved to the position of outline 380, and the single-panel union 320 having remained fixed. The original four-panel union 320/330/350/360 shown in FIG. 3I has thus been decomposed into the three-panel union and the one panel union shown in FIG. 3J.

The two actions described hereinabove; namely, moving a single panel by use of the shift key, and moving a panel with other panels positioned below and to the right of it by use of the control key, provide the user with flexibility in pulling apart a general union of panels into two or more smaller unions.

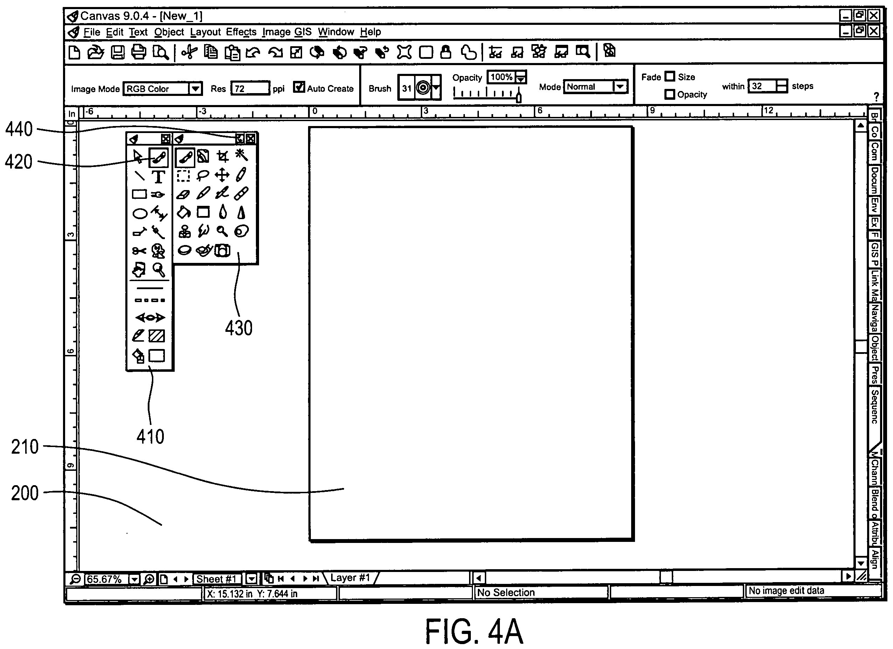

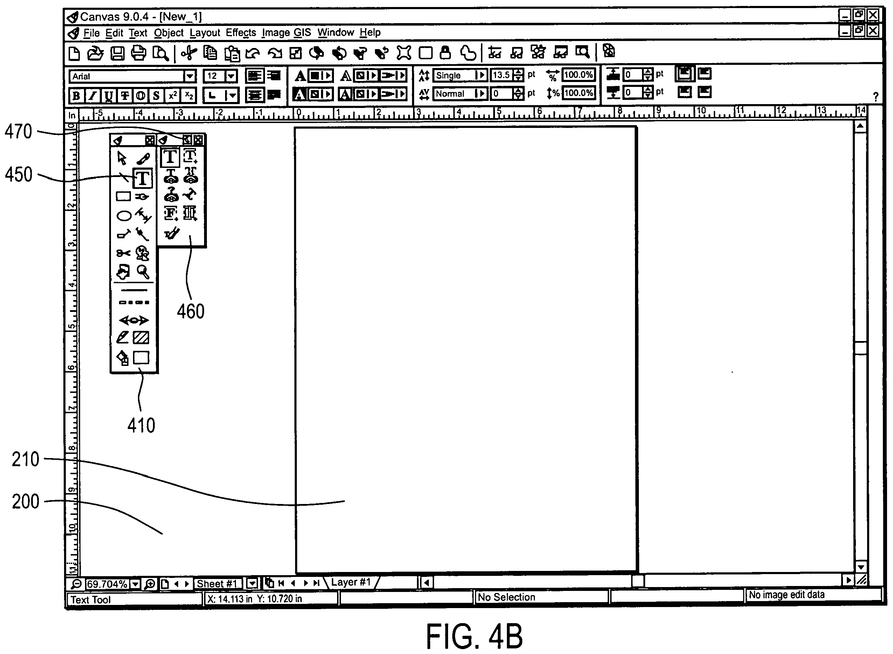

Reference is now made to FIGS. 4A and 4B, which are illustrations of fastening parent and child window panels together and locking the child window panels, in accordance with an example. Shown in FIG. 4A is a window panel 410 for a toolbox, containing a variety of graphics tools represented as icons. Pressing a mouse button while the mouse is pointed over an icon, such as brush icon 420, triggers opening of a child window panel 430 for a toolbox of brush strokes. Referring back to FIG. 2A, the parent window panel 410 for the toolbox is accessible as the second item in pop up list 230.

When child panel 430 is opened, it is positioned adjacent to its parent panel 410, and the two panels are fastened together to form a union, as described hereinabove with reference to FIG. 3B. Thus if a user moves either panel 410 or 430, the other panel automatically moves with it in coordination. If the user wishes to decompose the union of panels 410 and 430 and move one of the panels without moving the other, he can press the shift key or the control key while moving one of the panels, as described above with reference to FIG. 3I.

In accordance with an example, when a second child panel is opened, the first child panel is closed in its stead, unless the first child,panel has been locked. Specifically, referring to FIG. 4B, the user has pressed on icon 450 for a text tool, and accordingly child panel 460 with a variety of text tools is opened and positioned alongside parent panel 410, instead of child panel 430 with the brush stroke tools, which has now been closed. However, it is possible for both child panels 430 and 460 to simultaneously be open, by use of a locking mechanism. Referring back to FIG. 4A, child panel 430 includes a lock 440 which, if pressed by the user, ensures that child panel 430 remains open when another child panel is subsequently opened. When lock 440 is pressed, child panel 430 is said to be "locked", otherwise it is said to be "unlocked".

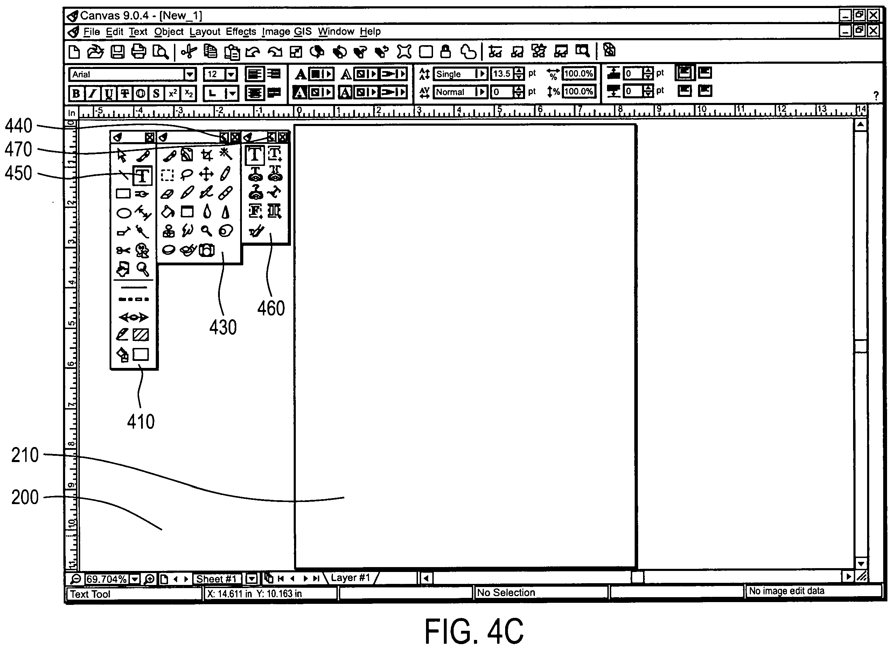

In distinction from FIG. 4B in which child panel 430 was unlocked and therefore closed, FIG. 4C shows what happens if child panel 430 was locked prior to opening the second child panel 460. Lock 440 is shown in FIG. 4C depressed. When the user clicks on icon 450, child panel 430 is maintained and the new child panel 460 for text is opened and displayed alongside child panel 430.

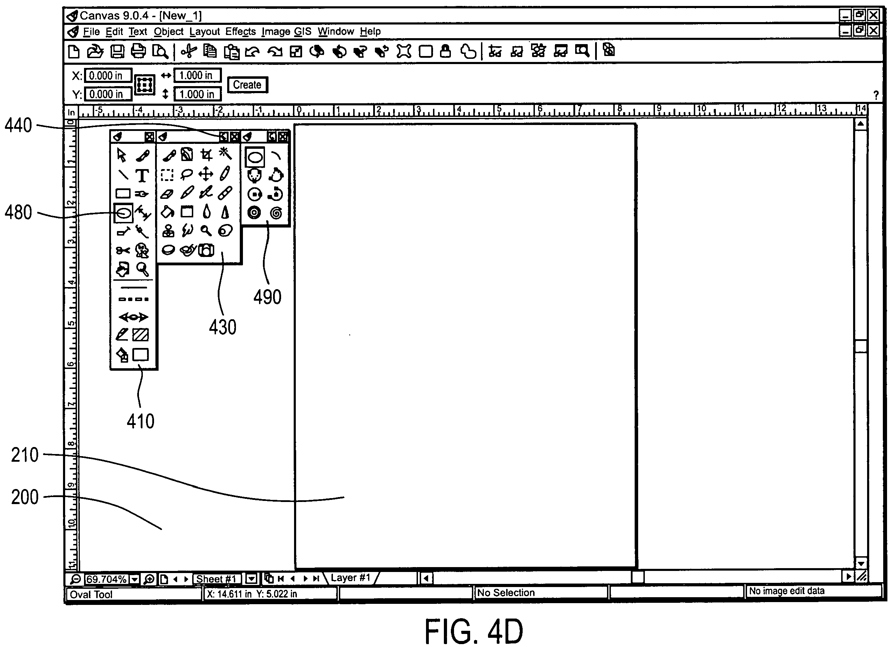

The process of opening successive child panels can be repeated, and preferably whenever a new child panel is opened, those previous child panels that were locked remain open, and those that were unlocked are closed. Thus, referring to FIG. 4D, after opening child panel 430 for brush strokes and child panel 460 for text tools, a user opens yet a third child panel by clicking in an icon 480 for ellipse tools. Prior to this, child panel 430 was locked, as shown in FIG. 4C with lock 440 depressed. However, child panel 460 was not locked, as shown in FIG. 4C with lock 470 released. As a result, when a new child panel 490 for ellipse tools is opened in FIG. 4D, child panel 430 remains open and child panel 460 is closed. Thus only child panels 430 and 490 appear in FIG. 4D, and not child panel 460, which was closed.

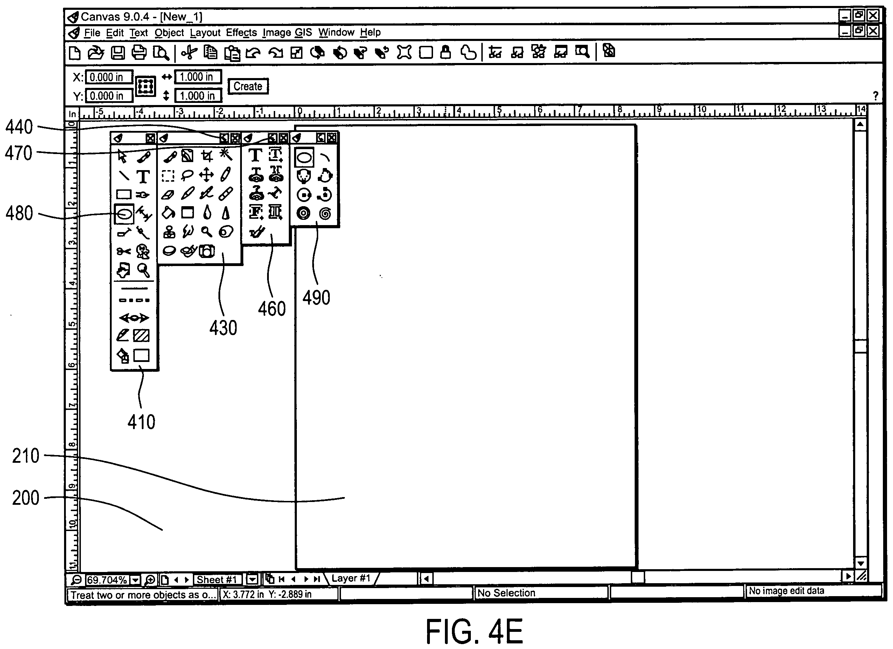

Alternatively, if lock 470 for child panel 460 had been pressed, then child panel 460 would also remain open, as illustrated in FIG. 4E. As shown in FIG. 4E, lock 440 for child panel 430 and lock 470 for child panel 460 are both depressed, and the new child panel 490 is opened alongside of child panel 460.

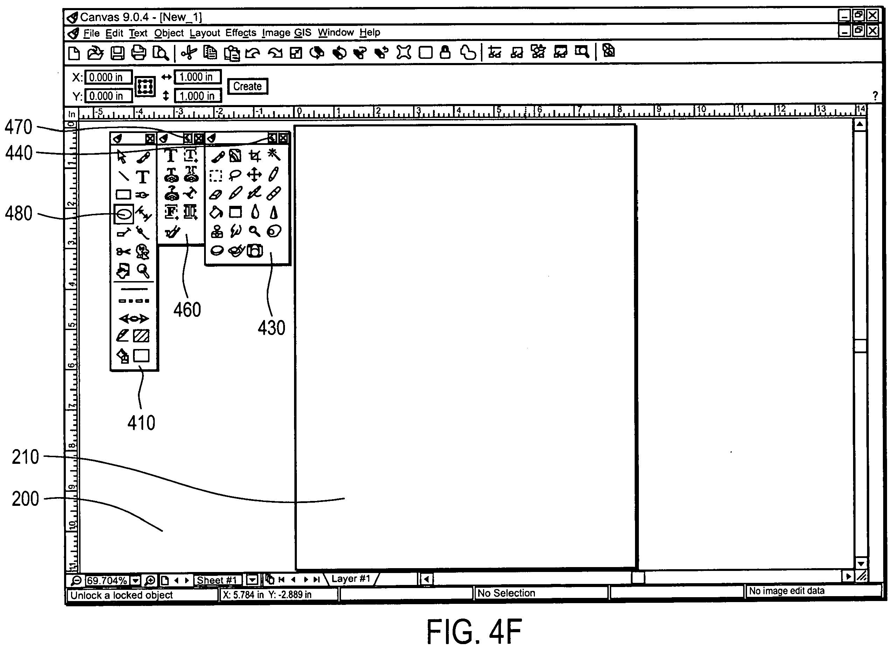

In accordance with an example, child panels are positioned so that the unlocked panels are to the right of the locked panels. Thus, in FIG. 4C child panel 430 is locked and child panel 460 is unlocked, and the latter is positioned to the right of the former. If the locks are switched, by releasing lock 440 and pressing lock 470, then the positioning of the child panels is also switched, as shown in FIG. 4F. That is, in FIG. 4F, lock 440 is released and lock 470 is pressed, and accordingly child panel 430 is now positioned to the right of child panel 460.

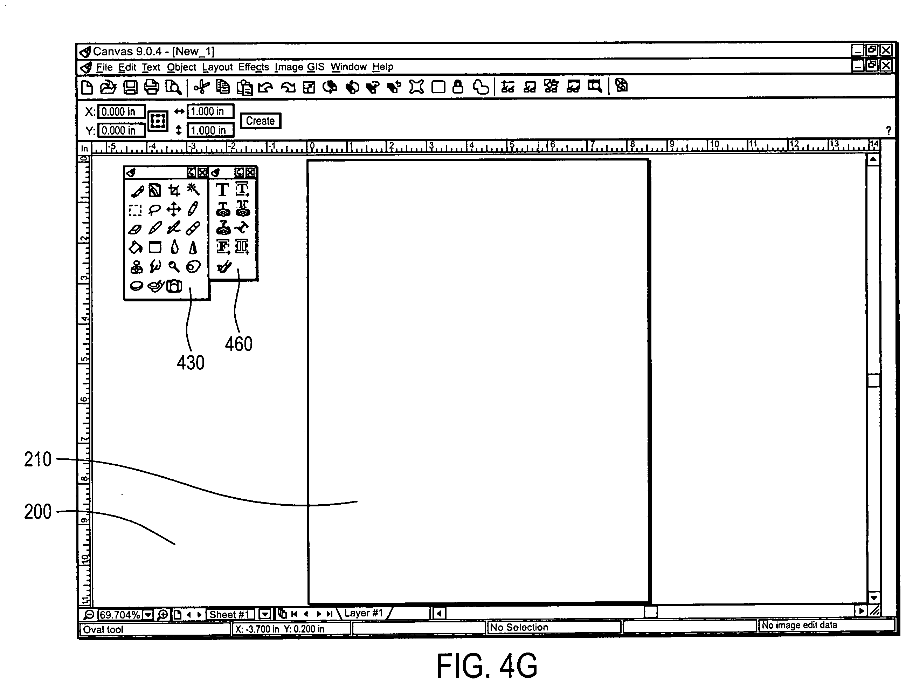

In accordance with an example, when a parent window panel is closed, the unlocked child window panels automatically close as well, but the locked child panels remain open. Referring back to FIG. 4E, child panels 430 and 460 are locked, and child panel 490 is unlocked. Referring to FIG. 4G, if the parent panel 410 is closed, then child panels 430 and 460 remain open, and child panel 490 is automatically closed.

The present invention provides a method and system for managing a context-dependent display bar, also referred to herein as a "property bar," that includes controls relevant for a current context in which a user is working; and for generating the display bar as a multi-page bar for drawing the relevant controls.

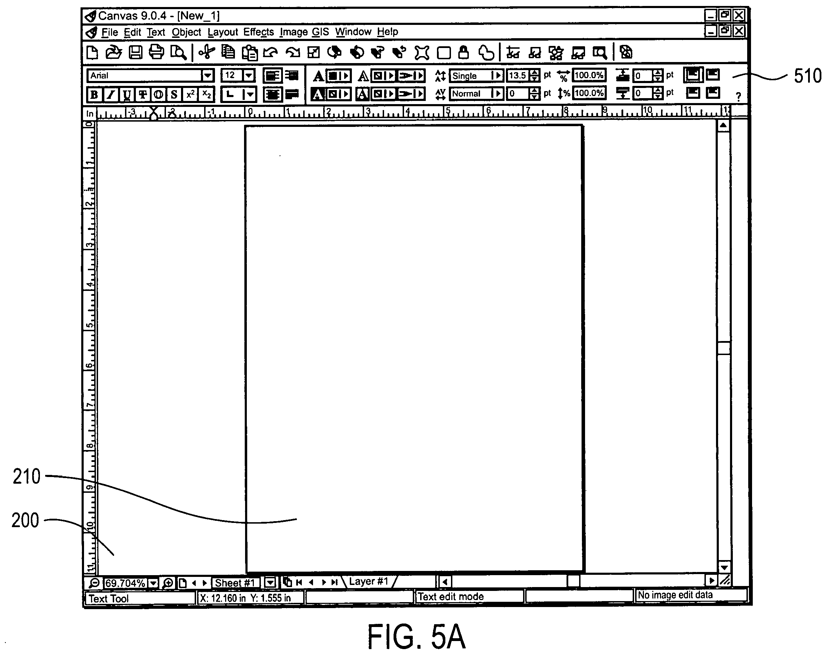

Reference is now made to FIGS. 5A - 5D, which are illustrations of a multi-page display bar, in accordance with an example. Shown in FIG. 5A is a property bar 510 with controls for text and artistic properties. The Canvas application window 200 is large enough for all of the necessary controls to fit within property bar 510.

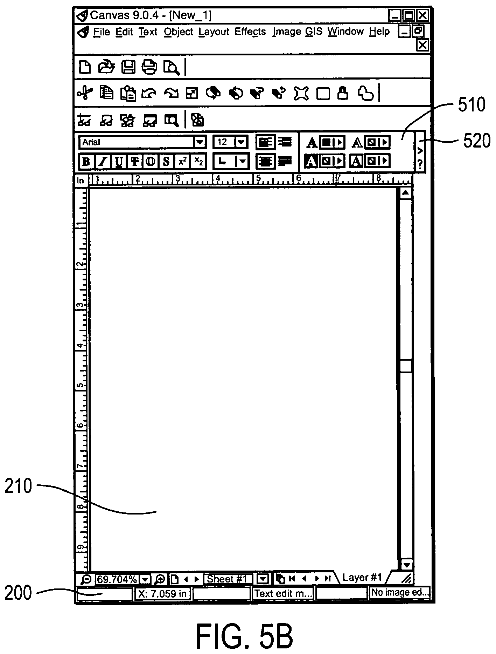

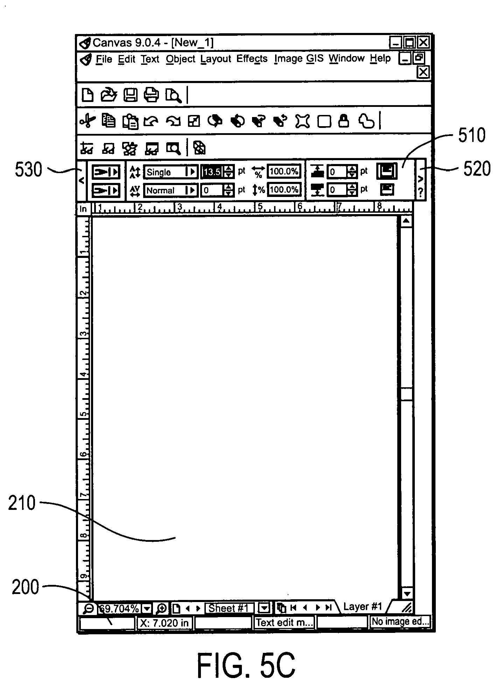

As shown in FIG. 5B, a user has resized application window 200 to reduce its width, and property bar 510 is no longer wide enough to display all of the necessary controls. Only a subset of the controls is visible in property bar 510, and the rest of the controls are hidden. In accordance with an example, in order to enable a user to access the hidden controls, a paging button 520 is provided. Button 520 enables the user to page through the controls, one page at a time. When the user presses on button 520, the next page of controls is displayed in property bar 510, as illustrated in FIG. 5B. A portion of the controls that were hidden in FIG. 5B, are now displayed in property bar 510 in FIG. 5C, and the controls that were visible in FIG. 5B are now hidden in FIG. 5C.

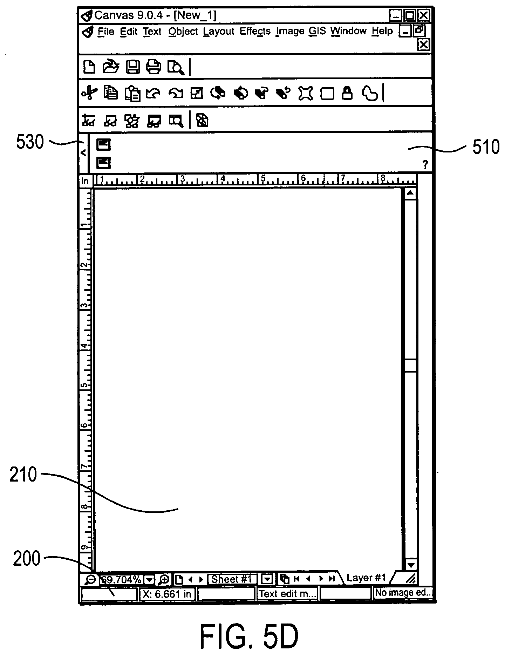

FIG. 5C includes button 520 for advancing to the next page of icons, and also button 530 for going back to the previous page of icons. Since three pages are necessary to display all of the controls, both buttons 520 and 530 appear in FIG. 5C, which displays the second page of controls in property bar 510. If the user clicks on button 530 to go back one page, then the first page of controls is displayed in property bar 510, as in FIG. 5B. If the user clicks on button 520 to go forward one page, then the third page of controls are displayed in property bar 510, as illustrated in FIG. 5D. FIG. 5D does not include button 520, since the last page of controls is being displayed in property bar 510, and there is no fourth page to advance to. However, FIG. 5D does include button 530 for going back to the second page of controls, as in FIG. 5C.

If application window 200 is further reduced in width, then additional pages may be required to accommodate all of the necessary controls, and if application window 200 is enlarged in width, then fewer pages may be required.

Thus it may be appreciated that the present invention provides a paging mechanism to enable a user to access controls that are not visible within a property bar.

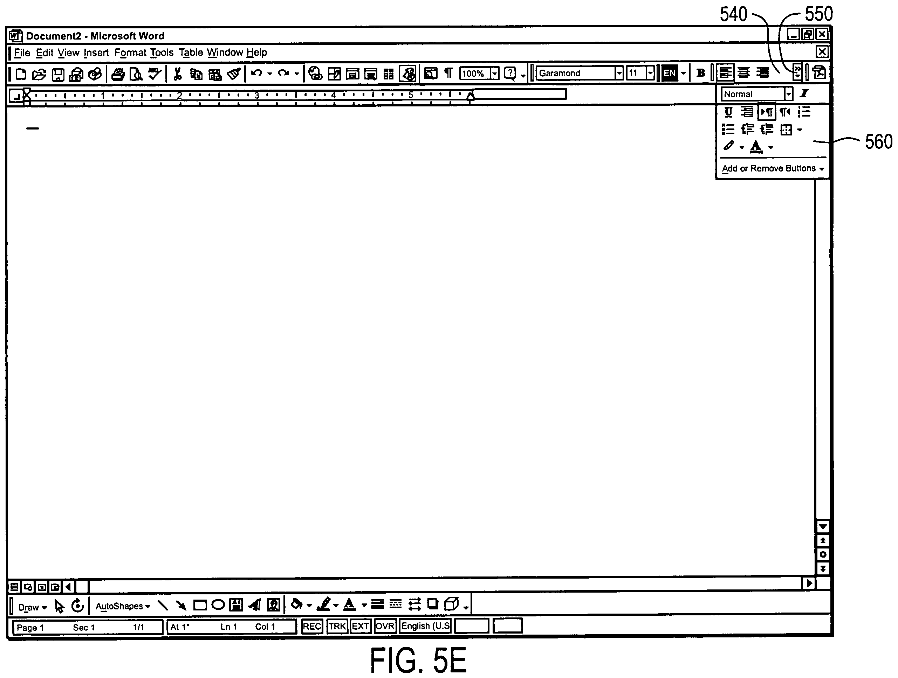

In distinction to the present invention, prior art methods and systems provide a different approach to enable a user to access hidden controls. Referring to FIG. 5E, a property bar 540 is not wide enough to accommodate all of the necessary controls. Some of the controls are visible within property bar 540, and others are hidden. To access the hidden controls, a button 550 is provided. When a user presses on button 550, the hidden controls are displayed within an area 560 adjacent to button 550. Area 560 is removed if the user clicks anywhere outside of area 560, or presses on an Alt or Esc key of a keyboard connected to his computer.

The present invention has several advantages over prior art approaches, when there are many hidden controls, and when a user requires frequent access to hidden icons.

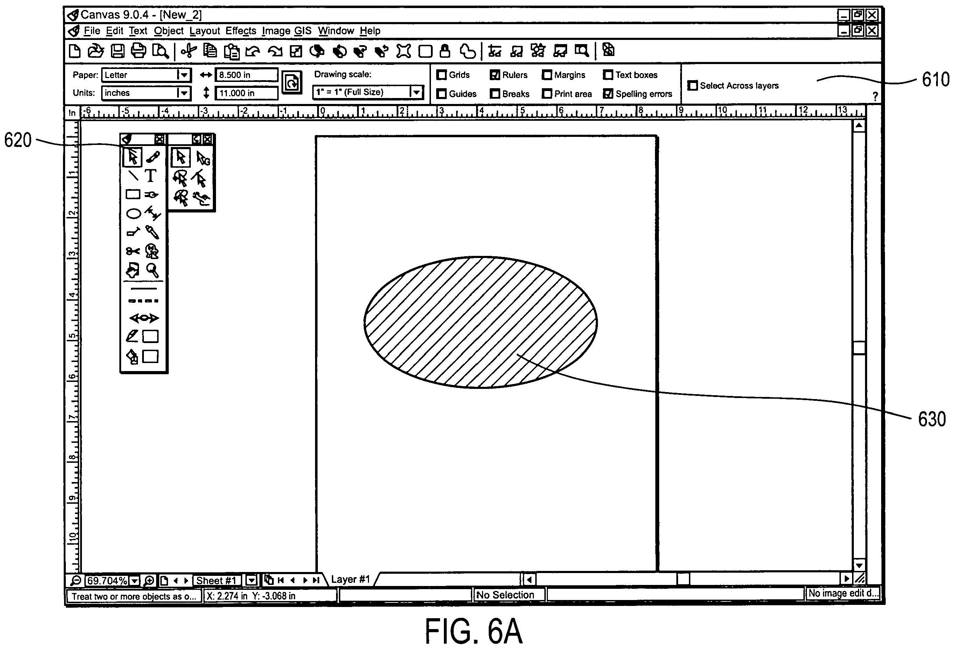

In accordance with a preferred embodiment of the present invention, the property bar shown in FIGS. 5A - 5D, which contains the various controls, is itself context-dependent. I.e., the set of controls included within property bar 510 can change, and depends on the context in which a user is working. Reference is now made to FIGS. 6A - 6F, which are illustrations of a context-dependent property bar, in accordance with a preferred embodiment of the present invention. Property bar 610 in FIG. 6A corresponds to a context where a selection tool 620 is activated. FIG. 6A also shows an elliptical vector object 630, which is not currently selected. Thus, the context of FIG. 6A is one where a user is not currently editing his document. Accordingly, property bar 610 includes controls for document properties such as page size, units and drawing scale.

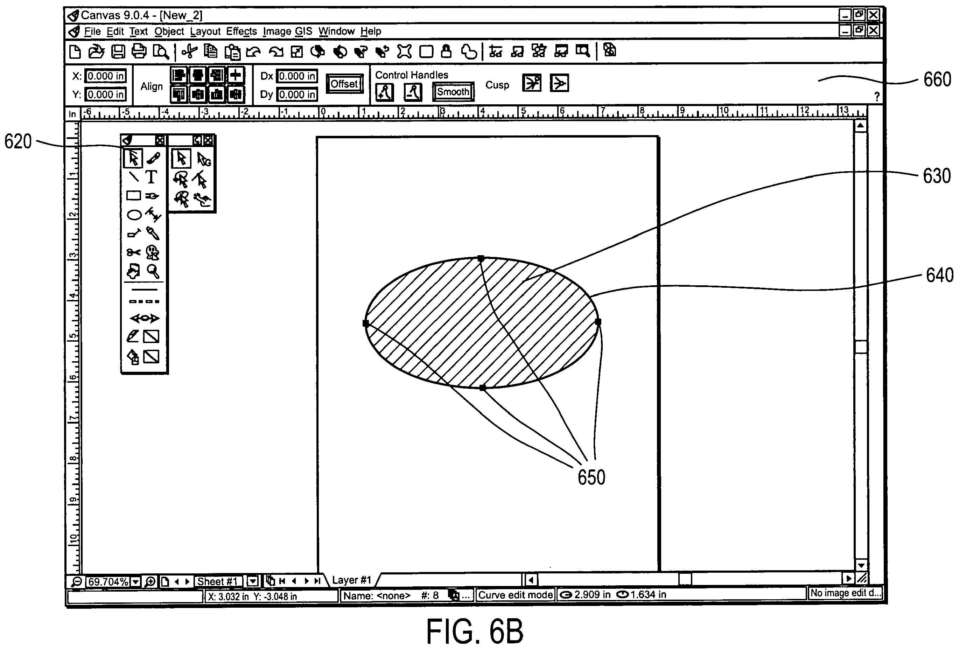

In FIG. 6B, the user has selected object 630 for editing, by double clicking on the object while the selection tool is active. Selection of vector object 630 is indicated by a frame 640 surrounding it, frame 640 having handles 650. In this current context, the user wishes to geometrically change object 630 and, accordingly, property bar 610 changes to property bar 660, which includes controls for changing the shape of object 630, such as handles and cusps.

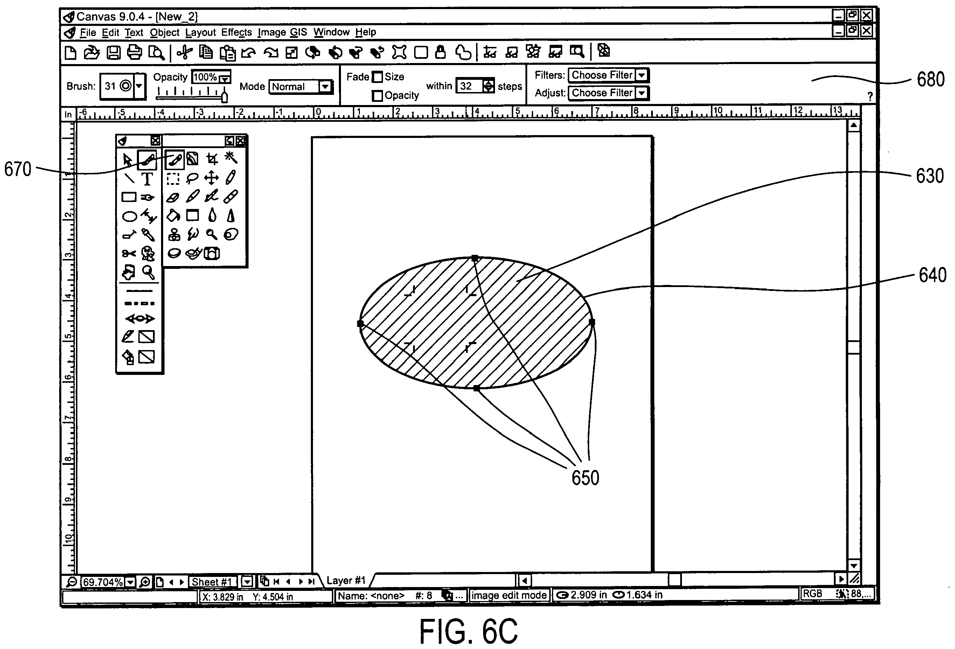

In FIG. 6C, the user has activated brush tool 670 for editing the selected object 630. Object 630 is still selected for editing, as evidenced by frame 640 surrounding it. In this context, the user wishes to edit object 630 by use of a paint brush and, accordingly, property bar 660 changes to property bar 680, which includes paint brush tools such as brush shape, brush thickness, brush mode and opacity.

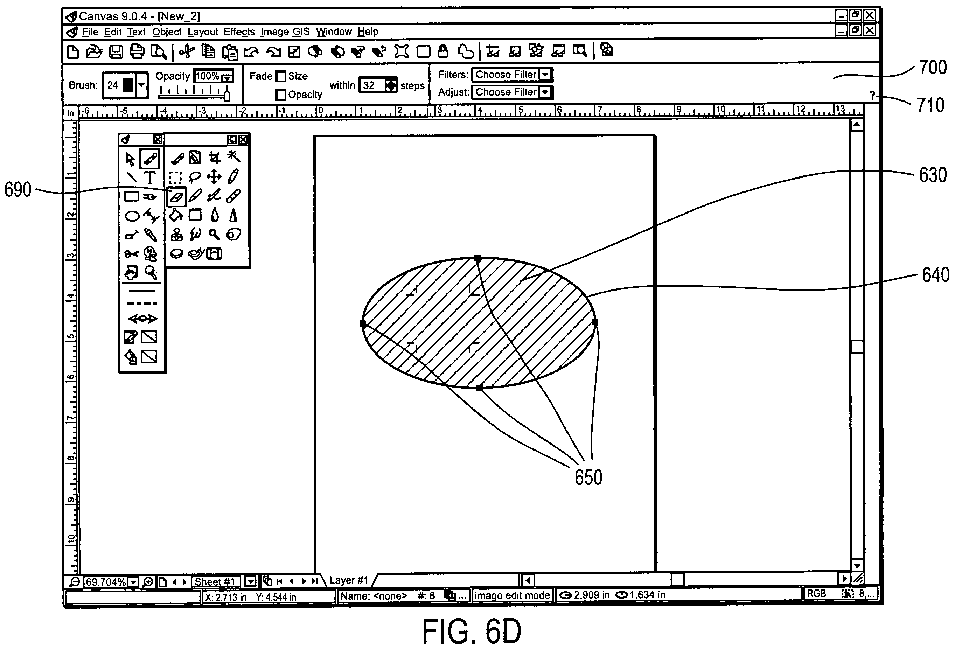

In FIG. 6D, the user has activated an eraser tool 690 for editing the selected object 630, instead of the previously selected brush tool 670. In this context, the user wishes to apply erasure strokes and, accordingly, property bar 680 further changes to property bar 700 which includes eraser tools such as eraser shape, eraser thickness and opacity. Observe that property bar 700 is different than property bar 680, since the brush mode control is not included in property bar 700.

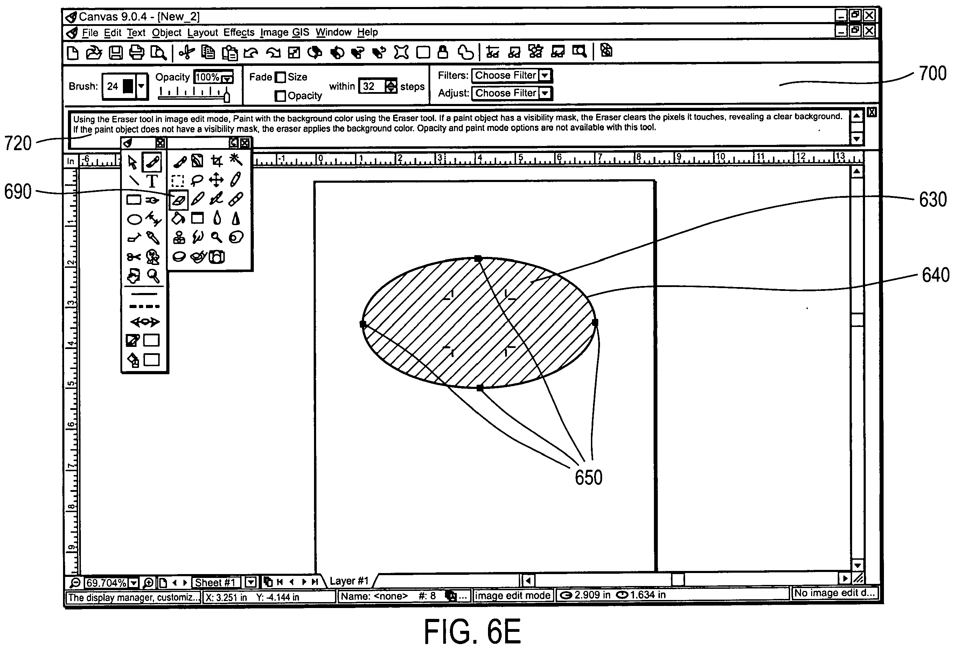

In accordance with a preferred embodiment of the present invention, property bars include a button 710 for context-sensitive help. When this button is pressed, instructions 720 specific to the current property bar are displayed, as shown in FIG. 6E.

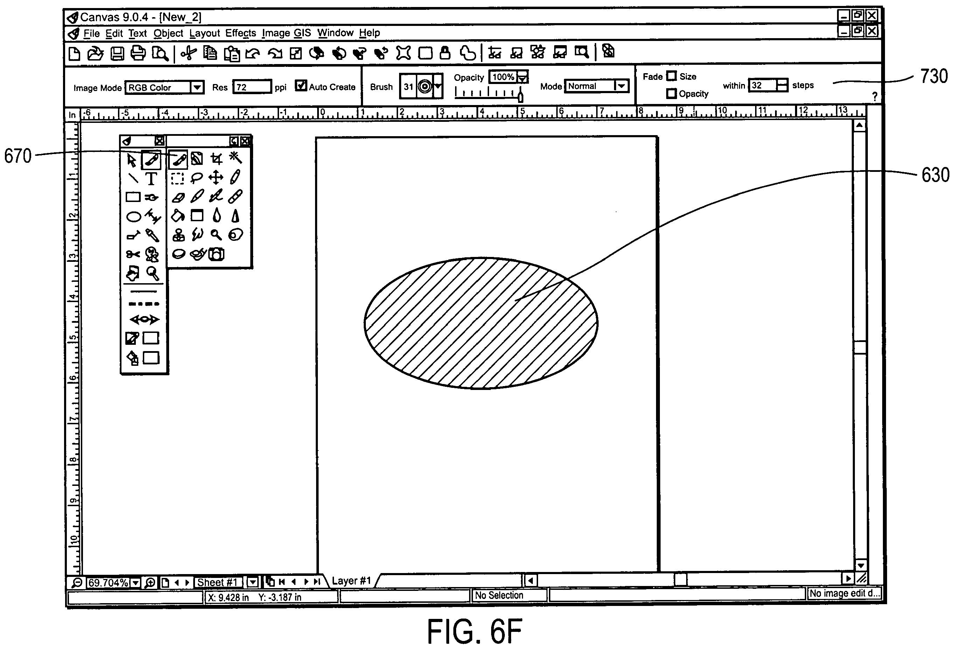

FIG. 6F shows property bar 730 corresponding to paint brush tool 670 being activated when object 630 is not selected. Although the same paint brush tool is activated in FIG. 6C and FIG. 6F, their contexts are different. Whereas FIG. 6C has an object selected in edit mode, FIG. 6F does not. It can be seen that property bar 730 is different than property bar 680, and includes an image mode control and does not include a filters control.

The following TABLE I summarizes the contexts of FIGS. 6A - 6F and the contents of the corresponding property bars.

| **TABLE I: Context-Dependent Property Bars** | | |
|---|---|---|
| **FIG.** | **Context** | **Contents of Property Bar** |
| | | |
| 6A | Selection tool activated | Page size, units and drawing scale |
| | Non-edit mode | Grids, guides and rulers |
| | | Layer selector |
| 6B | Selection tool activated | Linear position |
| | Edit mode | Alignment |
| | | Offset |
| | | Handles and cusps |
| 6C | Paint brush tool activated | Brush shape, opacity and mode |
| | Edit mode | Fade |
| | | Filters |
| 6D, 6E | Erase tool activated | Brush shape, opacity |
| | Edit mode | Fade |
| | | Filters |
| 6F | Paint brush tool activated | Image mode and resolution |
| | Non-edit mode | Brush shape, opacity and mode |
| | | Fade |

It may thus be appreciated that in accordance with a preferred embodiment of the present invention, a context is determined by an object, an edit mode and an activated tool. With each context is associated zero, one or more controls and, for each identified context, the property bar displays such associated controls.

### Implementation Details

The present invention is preferably implemented through a data structure that keeps track of which window panels are fastened together as a union. As window panels become fastened together into unions, or separated from unions, the data structure is updated accordingly so as to reflect the current composition of unions of window panels.

Preferably, when a positioning operation is applied to a window panel, the same operation is applied simultaneously to all other window panels fastened together therewith. Thus, for example, if a window panel is moved 50 pixels to the right and 40 pixels downwards, then all other window panels fastened together with it are also simultaneously moved 50 pixels to the right and 40 pixels downwards. The effect of The two actions described hereinabove; namely, moving a single panel by use of the shift key, and moving a panel with other panels positioned below and to the right of it by use of the control key, provide the user with flexibility in pulling apart a general union of panels into two or more smaller unions.

Reference is now made to FIGS. 4A and 4B, which are illustrations of fastening parent and child window panels together and locking the child window panels, in accordance with a preferred embodiment of the present invention. Shown in FIG. 4A is a window panel 410 for a toolbox, containing a variety of graphics tools represented as icons. Pressing a mouse button while the mouse is pointed over an icon, such as brush icon 420, triggers opening of a child window panel 430 for a toolbox of brush strokes. Referring back to FIG. 2A, the parent window panel 410 for the toolbox is accessible as the second item in pop up list 230.

When child panel 430 is opened, it is positioned adjacent to its parent panel 410, and the two panels are fastened together to form a union, as described hereinabove with reference to FIG. 3B. Thus if a user moves either panel 410 or 430, the other panel automatically moves with it in coordination. If the user wishes to decompose the union of panels 410 and 430 and move one of the panels without moving the other, he can press the shift key or the control key while moving one of the panels, as described above with reference to FIG. 3I.

In accordance with a preferred embodiment of the present invention, when a second child panel is opened, the first child panel is closed in its stead, unless the first child panel has been locked. Specifically, referring to FIG. 4B, the user has pressed on icon 450 for a text tool, and accordingly child panel 460 with a variety of text tools is opened and positioned alongside parent panel 410, instead of child panel 430 with the brush stroke tools, which has now been closed. However, it is possible for both child panels 430 and 460 to simultaneously be open, by use of a locking mechanism. Referring back to FIG. 4A, child panel 430 includes a lock 440 which, if pressed by the user, ensures that child panel 430 remains open when another child panel is subsequently opened. When lock 440 is pressed, child panel 430 is said to be "locked", otherwise it is said to be "unlocked".

In distinction from FIG. 4B in which child panel 430 was unlocked and therefore closed, FIG. 4C shows what happens if child panel 430 was locked prior to opening the second child panel 460. Lock 440 is shown in FIG. 4C depressed. When the user clicks on icon 450, child panel 430 is maintained and the new child panel 460 for text is opened and displayed alongside child panel 430.

The process of opening successive child panels can be repeated, and preferably whenever a new child panel is opened, those previous child panels that were locked remain open, and those that were unlocked are closed. Thus, referring to FIG. 4D, after opening child panel 430 for brush strokes and child panel 460 for text tools, a user opens yet a third child panel by clicking in an icon 480 for ellipse tools. Prior to this, child panel 430 was locked, as shown in FIG. 4C with lock 440 depressed. However, child panel 460 was not locked, as shown in FIG. 4C with lock 470 released. As a result, when a new child panel 490 for ellipse tools is opened in FIG. 4D, child panel 430 remains open and child panel 460 is closed. Thus only child panels 430 and 490 appear in FIG. 4D, and not child panel 460, which was closed.

Alternatively, if lock 470 for child panel 460 had been pressed, then child panel 460 would also remain open, as illustrated in FIG. 4E. As shown in FIG. 4E, lock 440 for child panel 430 and lock 470 for child panel 460 are both depressed, and the new child panel 490 is opened alongside of child panel 460.

In accordance with a preferred embodiment of the present invention, child panels are positioned so that the unlocked panels are to the right of the locked panels. Thus, in FIG. 4C child panel 430 is locked and child panel 460 is unlocked, and the latter is positioned to the right of the former. If the locks are switched, by releasing lock 440 and pressing lock 470, then the positioning of the child panels is also switched, as shown in FIG. 4F. That is, in FIG. 4F, lock 440 is released and lock 470 is pressed, and accordingly child panel 430 is now positioned to the right of child panel 460.

In accordance with a preferred embodiment of the present invention, when a parent window panel is closed, the unlocked child window panels automatically close as well, but the locked child panels remain open. Referring back to FIG. 4E, child panels 430 and 460 are locked, and child panel 490 is unlocked. Referring to FIG. 4G, if the parent panel 410 is closed, then child panels 430 and 460 remain open, and child panel 490 is automatically closed.

The present invention provides a method and system for managing a context-dependent display bar, also referred to herein as a "property bar," that includes controls relevant for a current context in which a user is working; and for generating the display bar as a multi-page bar for drawing the relevant controls.

Reference is now made to FIGS. 5A - 5D, which are illustrations of a multi-page display bar, in accordance with a preferred embodiment of the present invention. Shown in FIG. 5A is a property bar 510 with controls for text and artistic properties. The Canvas application window 200 is large enough for all of the necessary controls to fit within property bar 510.

As shown in FIG. 5B, a user has resized application window 200 to reduce its width, and property bar 510 is no longer wide enough to display all of the necessary controls. Only a subset of the controls is visible in property bar 510, and the rest of the controls are hidden. In accordance with a preferred embodiment of the present invention, in order to enable a user to access the hidden controls, a paging button 520 is provided. Button 520 enables the user to page through the controls, one page at a time. When the user presses on button 520, the next page of controls is displayed in property bar 510, as illustrated in FIG. 5B. A portion of the controls that were hidden in FIG. 5A, are now displayed in property bar 510 in FIG. 5B, and the controls that were visible in FIG. 5A are now hidden in FIG. 5B.

FIG. 5B includes button 520 for advancing to the next page of icons, and also button 530 for going back to the previous page of icons. Since three pages are necessary to display all of the controls, both buttons 520 and 530 appear in FIG. 5B, which displays the second page of controls in property bar 510. If the user clicks on button 530 to go back one page, then the first page of controls is displayed in property bar 510, as in FIG. 5A. If the user clicks on button 520 to go forward one page, then the third page of controls are displayed in property bar 510, as illustrated in FIG. 5D. FIG. 5D does not include button 520, since the last page of controls is being displayed in property bar 510, and there is no fourth page to advance to. However, FIG. 5D does include button 530 for going back to the second page of controls, as in FIG. 5C.

If application window 200 is further reduced in width, then additional pages may be required to accommodate all of the necessary controls, and if application window 200 is enlarged in width, the fewer pages may be required.

Thus it may be appreciated that the present invention provides a paging mechanism to enable a user to access controls that are not visible within a property bar.

In distinction to the present invention, prior art methods and systems provide a different approach to enable a user to access hidden controls. Referring to FIG. 5E, a property bar 540 is not wide enough to accommodate all of the necessary controls. Some of the controls are visible within property bar 540, and others are hidden. To access the hidden controls, a button 550 is provided. When a user presses on button 550, the hidden controls are displayed within an area 560 adjacent to button 550. Area 560 is removed if the user clicks anywhere outside of area 560, or presses on an Alt or Esc key of a keyboard connected to his computer.

The present invention has several advantages over prior art approaches, when there are many hidden controls, and when a user requires frequent access to hidden icons.

In accordance with a preferred embodiment of the present invention, the property bar shown in FIGS. 5A - 5D, which contains the various controls, is itself context-dependent. I.e., the set of controls included within property bar 510 can change, and depends on the context in which a user is working. Reference is now made to FIGS. 6A - 6E, which are illustrations of a context-dependent property bar, in accordance with a preferred embodiment of the present invention. Property bar 610 in FIG. 6A corresponds to a context where a selection tool 620 is activated. FIG. 6A also shows an elliptical vector object 630, which is not currently selected. Thus, the context of FIG. 6A is one where a user is not currently editing his document. Accordingly, property bar 610 includes controls for document properties such as page size, units and drawing scale.

In FIG. 6B, the user has selected object 630 for editing, by double clicking on the object while the selection tool is active. Selection of vector object 630 is indicated by a frame 640 surrounding it, frame 640 having handles 650. In this current context, the user wishes to geometrically change object 630 and, accordingly, property bar 610 changes to property bar 660, which includes controls for changing the shape of object 630, such as handles and cusps.

In FIG. 6C, the user has activated brush tool 670 for editing the selected object 630. Object 630 is still selected for editing, as evidenced by frame 640 surrounding it. In this context, the user wishes to edit object 630 by use of a paint brush and, accordingly, property bar 660 changes to property bar 680, which includes paint brush tools such as brush shape, brush thickness, brush mode and opacity.

In FIG. 6D, the user has activated an eraser tool 690 for editing the selected object 630, instead of the previously selected brush tool 670. In this context, the user wishes to apply erasure strokes and, accordingly, property bar 680 further changes to property bar 700 which includes eraser tools such as eraser shape, eraser thickness and opacity. Observe that property bar 700 is different than property bar 680, since the brush mode control is not included in property bar 700.

In accordance with a preferred embodiment of the present invention, property bars include a button 710 for context-sensitive help. When this button is pressed, instructions 720 specific to the current property bar are displayed, as shown in FIG. 6E.

FIG. 6F shows property bar 730 corresponding to paint brush tool 670 being activated when object 630 is not selected. Although the same paint brush tool is activated in FIG. 6C and FIG. 6F, their contexts are different. Whereas FIG. 6C has an object selected in edit mode, FIG. 6F does not. It can be seen that property bar 730 is different than property bar 670, and includes an image mode control and does not include a filters control.

The following TABLE I summarizes the contexts of FIGS. 6A - 6F and the contents of the corresponding property bars.

| **TABLE I: Context-Dependent Property Bars** | | |
|---|---|---|
| **FIG.** | **Context** | **Contents of Property Bar** |
| | | |
| 6A | Selection tool activated | Page size, units and drawing scale |
| | Non-edit mode | Grids, guides and rulers |
| | | Layer selector |
| 6B | Selection tool activated | Linear position |
| | Edit mode | Alignment |
| | | Offset |
| | | Handles and cusps |
| 6C | Paint brush tool activated | Brush shape, opacity and mode |
| | Edit mode | Fade |
| | | Filters |
| 6D, 6E | Erase tool activated | Brush shape, opacity |
| | Edit more | Fade |
| | | Filters |
| 6F | Paint brush tool activated | Image mode and resolution |
| | Non-edit mode | Brush shape, opacity and mode |
| | | Fade |

It may thus be appreciated that in accordance with a preferred embodiment of the present invention, a context is determined by an object, an edit mode and an activated tool. With each context is associated zero, one or more controls and, for each identified context, the property bar displays such associated controls.

### Implementation Details

The present invention is preferably implemented through a data structure that keeps track of which window panels are fastened together as a union. As window panels become fastened together into unions, or separated from unions, the data structure is updated accordingly so as to reflect the current composition of unions of window panels.

Preferably, when a positioning operation is applied to a window panel, the same operation is applied simultaneously to all other window panels fastened together therewith. Thus, for example, if a window panel is moved 50 pixels to the right and 40 pixels downwards, then all other window panels fastened together with it are also simultaneously moved 50 pixels to the right and 40 pixels downwards. The effect of the simultaneous movement is to give an appearance that all of these window panels move cohesively together as a single area.

Reference is now made to Appendix A, which includes a detailed listing of computer source code written in the C++ programming language for managing window panels that can be fastened together in unions, in accordance with the present invention, and in conjunction with a Microsoft Windows operating system. As seen in Appendix A, a window panel is represented by a structure, WindowItemInfo, which includes a handle for the window panel and a Boolean flag indicating whether or not the window panel is snapped to another panel. A union of window panels is represented by a list, fwListPtr, of a number, fwCount, of WindowItemInfo structures.

A list of all floating window panels is generated in a method CreateFloatWindowList (), which steps through the panels using window handles provided by methods GetFirstFloatWindow() and GetNextFloatWindow (). A list of window panels is sorted to arrange the window panels in the list from top-left of the display screen to bottom-right, using a method FWCompareProc () to compare two WindowItemInfo structures, and a method SortFloatWindowList () to apply a quicksort to the list relative to the order induced by FWCompareProc ().

A method AreWindowRectsGlued () determines whether two window panels are fastened together adjacently. A recursive method TagAllWindowsForGluedWindowResize () steps through window panels using GetFirstFloatWindow () and GetNextFloatWindow () to identify window panels that are part of a union.

A method MoveFloatWindowAndGluedWindows () moves window panels that are part of a union by looping through a list fwListPtr[i] and moving all window panels that have a flag fwListPrt [i]. flag set, indicating that such window panels are to be offset. The setting of the flags occurs in a method TagAllWindowsThatNeedOffset().

A method SnapFloatWindowRect () generates a union of areas by successive unions of rectangles, testRect.

It may be appreciated by those skilled in the art that the specific implementation described in Appendix A is but one of many alternative ways of programming the present invention.

Identification of child window panels and their locked or unlocked states is preferably implemented using a stack. The stack is popped when unlocked child panels are closed, and the stack is pushed when new child panels are opened.

Reference is now made to Appendix B, which includes a detailed listing of computer source code written in the C++ programming language for implementing a preferred embodiment for managing window panels that can have parent-child relationships, in accordance with the present invention, and in conjunction with a Microsoft Windows operating system. As seen in Appendix B, a toolbox palette is represented by a structure, PalData, and a stack of such palettes is represented by a linked list traversed by methods GetPrevWnd () and GetNextWnd (). The locked or unlocked status of a child window panel is represented by the Boolean member isLocked of PalData.

It may be appreciated by those skilled in the art that the specific implementation described in Appendix B is but one of many alternative ways of programming the present invention.

Implementation of multi-page property bars, as shown in FIGS. 5A - 5D, is preferably performed by determining a total screen width required to display all of the necessary controls, and allocating the controls to portions of the property bar, the width of each portion being determined by the width of the application window. For example, if 20 identically sized controls are to be displayed in a property bar, and if the width of the application window can only accommodate 6 such controls, then the property bar is rendered in 4 portions; namely, portion #1 with controls 1 - 6, portion #2 with controls 7 - 12, portion #3 with controls 13 - 18, and portion #4 with controls 19 and 20. Page forward and page backward buttons are preferably used to move from one portion of the property bar to the portion following or preceding it, respectively.

Implementation of context-dependent display bars is preferably performed by a modular software architecture, in which a master module is responsible for displaying a user interface including controls, and receiving events triggered when a user activates one of the displayed controls using a mouse or keyboard or combination of both. The master module's functionality includes:
- identifying a current context based upon a tool activated by a user, an edit mode and an object;
- identifying controls associated with the current context;
- displaying a property bar including the associated controls, using page forward and page backwards buttons as necessary, if the associated controls cannot all fit together within the width of the application screen;
- displaying an image being worked on, the image being a raster image or a vector image or a combined raster + vector image;
- receiving messages from the operating system concerning user events, including inter alia mouse and keyboard events; and
- sending notification of the events to appropriate handlers for the controls.
Preferably, each of the available controls has an associated handler, which processes image data in response to user activation of a control.

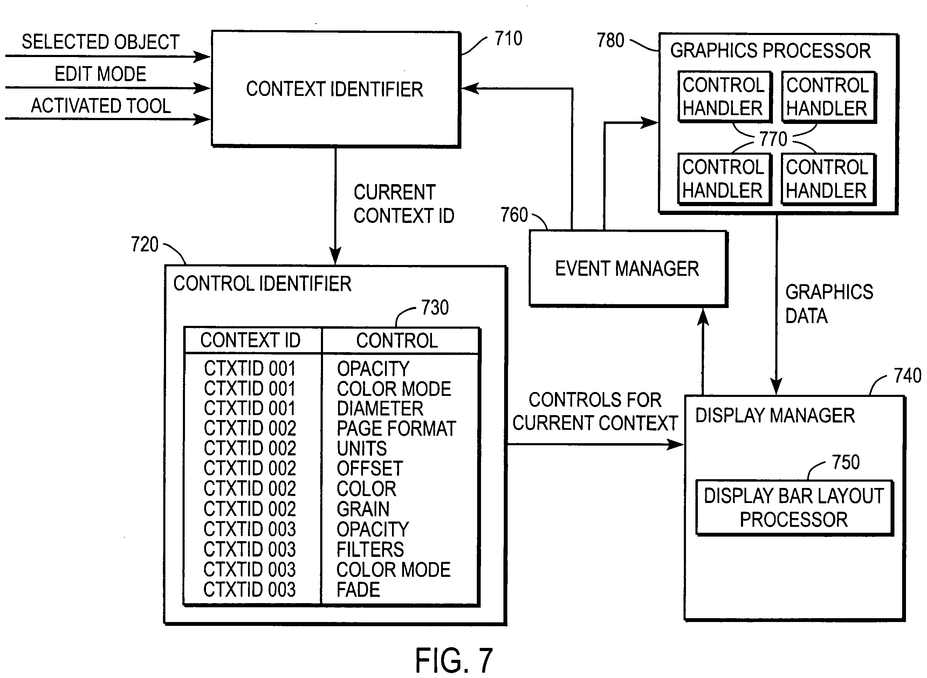

Reference is now made to FIG. 7, which is a simplified block diagram of a system for managing context-dependent property bars in conjunction with a graphics software application, and in accordance with a preferred embodiment of the present invention. As shown in FIG. 7, a context indentifier 710 receives a current state in which a user is working on a graphics object, the state including a currently selected object, a current edit mode and a currently activated tool, and determines a current context therefrom. Preferably, a unique ID is associated with each context.

A control identifier 720 receives the context ID from context identifier 710 and, preferably by accessing a look-up table 730 keyed on context IDs, determines a set of controls that are associated with the current context. The set of controls may be empty, or contain one or more controls. For example, look-up table 730 shows that a context ID CTXTID 001 is associated with three controls; namely, an opacity control, a color mode control and a diameter control.

A display manager 740 receives the set of controls associated with the current context and displays them within a dynamically changing display bar, or property bar, as part of a graphical use interface. Display manager 740 includes a display bar layout processor 750, which preferably determines how the associated controls are to be displayed within the display bar. In particular, layout processor 750 may split the associated controls among portions of the display bar, in accordance with a preferred embodiment of the present invention as described above with reference to FIGS. 5A - 5D. As a user pages back and forth through the portions of the display bar, different subsets of the associated controls become visible.

An event manager 760 listens for events intercepted by the operating system, such as user activation of a mouse or keyboard and combination thereof, while interacting with the graphical user interface. Specifically, event manager 760 detects when a control within the display bar is activated by a user.

Preferably, controls have handlers 770 associated therewith, which operate within an overall graphics processor 780. A handler generally processes a graphics object in a specific way, such as, for example, by modifying an edit path for a Bezier curve, or by adding paint brush strokes, or by modifying an opacity mask, or by filtering a raster image. When event manager 760 detects that a control is activated, it sends a notification to the control's handler 770, which then processes the graphics being worked on by the user accordingly. Preferably, event manager 760 also notifies context identifier 710 if the user changes the currently selected object, edit mode or tool, so that context identifier can change the current context accordingly.

Reference is now made to Appendix C, which includes a detailed listing of computer source code written in the C++ programming language for implementing a preferred embodiment for managing context-sensitive property bars and multi-page property bars, in accordance with the present invention, and in conjunction with a Microsoft Windows operating system. As seen in Appendix C, a context is modeled by a structure ContexMode that includes three private members, pvDrawToolID, pvEditSessionType and pvObjType, respectively representing (i) a current draw tool activated by a user, (ii) a current edit session if the user is working in an edit mode, and (iii) a current object type if an object is currently selected. Contexts are associated with values of these three members. Thus, for example, a context may be associated with (i) a draw tool for circles, (ii) a Bezier edit session and (iii) a selected object type. These three members are accessed by public methods GetContextDrawTool (), SetContextToDrawTool (), GetContextEditSession(), SetContextToEditSession(), GetContextObj ectType () and SetContextToObj ectType (). Contexts register themselves with control handlers by methods CXRegisterStandardContextItem () for standard handlers, and CXRegisterContextItem () for custom handlers.

It may be appreciated by those skilled in the art that the specific implementation described in Appendix C is but one of many alternative ways of programming the present invention.

In reading the above description, persons skilled in the art will realize that there are many apparent variations that can be applied to the methods and systems described. Thus, inter alia:
- although FIG. 3I illustrates window panels below and to the right of panel 350 being pulled away from a union, together with panel 350, other subsets of panels can be pulled away with panel 350 instead, such as panels above panel 350, or panels to the left of panel 350, or panels above and to the left of panel 350;
- child window panels can be fastened underneath or to the left of their parent window panels, instead of to the right of their window panels as illustrated in FIG. 4C; and
- buttons can be used to advance from one portion of a display bar directly to the last portion, or to go back directly to the first position, in addition to buttons 520 and 530 illustrated in FIG. 5C that move one portion at a time.

In the foregoing specification, the invention has been described with reference to specific exemplary embodiments thereof. It will, however, be evident that various modifications and changes may be made to the specific exemplary embodiments without departing from the broader scope of the invention as set forth in the appended claims. Accordingly, the specification and drawings are to be regarded in an illustrative rather than a restrictive sense.

There now follows a number of appendices, as listed above, which form part of the description.

### APPENDIX A

```
 struct WindowItemInfo
 {
 HWND wnd;
 RECT origRect;
 RECT newRect;
 Boolean needOffset;
 Boolean snapped;
 long tempFlag;
 };
 WindowItemInfo *CreateFloatWindowList(long *rCount, short
 toolBoxFilter=0);
 long AreWindowRectsGlued(RECT *srcRect, RECT *testRect, short
 *rSideAdj=0, short *adjEdgeStart=0, short *adjEdgeEnd=0);
 void TagAllWindowsForGluedWindowResize(HWND moveWnd, RECT *origRect,
 RECT *newRect, WindowItemInfo *fwListPtr, long fwCount);
 void MoveFloatWindowAndGluedWindows(HWND floatWnd, RECT *newRect,
 Boolean onlyDrawFocusRect, Boolean onlyBottomRight, Boolean repaint,
 Boolean onlyMoveGluedWindows=false, WindowItemInfo *fwListPtr=0, long
 fwCount=0) ;
 void SnapFloatWindowRect(HWND floatWnd, RECT *newfr,Boolean
 ignoreGluedWindows, WindowItemInfo *fwListPtr=0, long fwCount=0, RECT
 *origRect=0);
 void SortFloatWindowList(WindowItemInfo *fwListPtr, long count);
 static HWND GetNextFloatWindowLow(HWND curWnd)
 {
 do {
 curWnd = (HWND)GetWindowLong(curWnd, FL_NEXTFWND);
 } while(curWnd && IsXFloatModal(curWnd));
 return curWnd;
 }
 static HWND GetFirstFloatWindow(short toolBoxFilter=0)
 {
 HWND curWnd;
 curWnd=FloatWndList;
 while(curWnd && IsXFloatModal(curWnd))
 {
 curWnd = (HWND)GetWindowLong(curWnd, FL_NEXTFWND);
 }
 if (toolBoxFilter)
 {
 if (toolBoxFilter==1)
     {
    while(curWnd && !IsToolWindow(GetWRefCon(curWnd)))
        curWnd=GetNextFloatWindowLow(curWnd);
     )
 else
     {
    while(curWnd && IsToolWindow(GetWRefCon(curWnd)))
        curWnd=GetNextFloatWindowLow(curWnd);
     }
 )
 return curWnd;
 }
 static HWND GetNextFloatWindow(HWND curWnd, short toolBoxFilter=0)
 {
 curWnd=GetNextFloatWindowLow(curWnd);
 if (toolBoxFilter)
 {
 if (toolBoxFilter==1)
     {
    while(curWnd && !IsToolWindow(GetWRefCon(curWnd)))
        curWnd=GetNextFloatWindowLow(curWnd);
     }
 else
     {
    while(curWnd && IsToolWindow(GetWRefCon(curWnd)))
        curWnd=GetNextFloatWindowLow(curWnd);
     }
 }
 return curWnd;
 }
 long AreWindowRectsGlued(RECT *srcRect, RECT *testRect, short
 *rSideAdj, short *adjEdgeStart, short *adjEdgeEnd)
 {
 Boolean glued=false, inRange=false;
 long slen, p=0, start, end;
 short overlap=0;
 overlap=1;
 if (srcRect->left==testRect->right-overlap | | srcRect->right-
 overlap==testRect->left)
 {
 if (rSideAdj)
     {
     *rSideAdj = (srcRect->left==testRect->right-overlap) ? 1: 3;
     )
 slen = srcRect->bottom-srcRect->top;
 if (testRect->top >= srcRect->top && testRect->top <= srcRect-
 >bottom)
     {
     start = testRect->top;
     inRange = true;
     }
 else
     {
     start = srcRect->top;
     )
 if (testRect->bottom >= srcRect->top && testRect->bottom <=
 srcRect->bottom)
     {
     end = testRect->bottom;
     inRange = true;
     }
 else
     {
     end = srcRect->bottom;
    }
 if (!inRange && testRect->top<=srcRect->top && testRect->bottom
 >= srcRect->bottom)
    inRange=true;
 }
 else if (srcRect->top==testRect->bottom-overlap | | srcRect->bottom-
 overlap==testRect->top)
 {
 if (rSideAdj)
    {
    *rSideAdj = (srcRect->top==testRect->bottom-overlap) ? 2: 4;
    }
 slen = srcRect->right-srcRect->left;
 if (testRect->left >= srcRect->left && testRect->left <=
 srcRect->right)
    {
    start = testRect->left;
    inRange = true;
    }
 else
    {
    start = srcRect->left;
    }
 if (testRect->right >= srcRect->left && testRect->right <=
 srcRect->right)
    {
    end = testRect->right;
    inRange = true;
    }
 else
    {
    end = srcRect->right;
    }
 if (!inRange && testRect->left<=srcRect->left && testRect->right
 >= srcRect->right)
    inRange=true;
 }
 if (inRange && slen)
 {
 glued=true;
 p = ((end-start)*100) / slen;
 assert(p>=0 && p<=100);
 if (adjEdgeStart)
    *adjEdgeStart=start;
 if (adjEdgeEnd)
    *adjEdgeEnd=end;
 }
 return p;
 }
 WindowItemInfo *CreateFloatWindowList(long *rCount, short
 toolBoxFilter)
 {
 HWND hFWnd;
 WindowItemInfo *fwListPtr=0;
 long fwCount=0, i;
 if (hFWnd = GetFirstFloatWindow(toolBoxFilter))
 {
 do { fwCount++; }while (hFWnd = GetNextFloatWindow(hFWnd,
 toolBoxFilter));
 fwListPtr = (WindowItemInfo
 *)malloc(fwCount*sizeof(WindowItemInfo));
 if (fwListPtr)
     {
     for (hFWnd = GetFirstFloatWindow(toolBoxFilter),
     i=0; i<fwCount;i++)
         {
        fwListPtr[i].wnd = hFWnd;
        fwListPtr[i].needOffset = false;
        fwListPtr[i].tempFlag=0;
        fwListPtr[i].snapped=false;
        GetWindowRect(fwListPtr[i].wnd, &fwListPtr[i].origRect);
        hFWnd = GetNextFloatWindow(hFWnd, toolBoxFilter);
        }
     }
 }
 *rCount = fwCount;
 return fwListPtr;
 }
 static int FWCompareProc(const void *a, const void *b)
 {
 int r;
 WindowItemInfo *a1, *b1;
 a1 = (WindowItemInfo *)a;
 b1 = (WindowItemInfo *)b;
 r = a1->origRect.top - b1->origRect.top;
 if (!r)
 {
 r = a1->origRect.left - b1->origRect.left;
 }
 return r;
 }
 void SortFloatWindowList(WindowItemInfo *fwListPtr, long count)
 {
 qsort(fwListPtr, count, sizeof(WindowItemInfo), FWCompareProc);
 }
 void TagAllWindowsForGluedWindowResize(HWND moveWnd, RECT *origRect,
 RECT *newRect, WindowIemInfo *fwListPtr, long fwCount)
 {
 long i;
 RECT testRect;
 long dw, dh, dx, dy;
 dx = newRect->left - origRect->left;
 dy = newRect->top - origRect->top;
 dw = (newRect->right-newRect->left);
 if (dw==0) dw=1;
 dw -= (origRect->right-origRect->left);
 dh = (newRect->bottom-newRect->top);
 if (dh==0) dh=1;
 dh -= (origRect->bottom-origRect->top);
 for (i=0;i<fwCount;i++)
 {
 if (fwListPtr[i].needOffset)
     continue;
 if (moveWnd == fwListPtr[i].wnd)
     {
     fwListPtr[i].newRect = *newRect;
     fwListPtr[i].needOffset = true;
     fwListPtr[i].snapped = true;
     }
 else
     {
     long gluePercent, cdx, cdy;
     short side;
     gluePercent = AreWindowRectsGlued(origRect,
     &fwListPtr[i].origRect, &side);
     fwListPtr[i].newRect = fwListPtr[i].origRect;
     if (gluePercent)
         {
        fwListPtr[i].snapped = true;
        fwListPtr[i].tempFlag=1;
        fwListPtr[i].needOffset = true;
        if (!dx && dw && side==3)
            {
            fwListPtr[i].newRect.left+=dw;
            fwListPtr[i].newRect.right+=dw;
            }
        if (dx)
            {
            if (side==3)
                {
                fwListPtr[i].newRect.left+=dx+dw;
                fwListPtr[i].newRect.right+=dx+dw;
                }
            else
                {
                fwListPtr[i].newRect.left+=dx;
                fwListPtr[i].newRect.right+=dx;
                }
            }
        if (!dy && dh && side==4)
            {
            fwListPtr[i].newRect.top+=dh;
            fwListPtr[i].newRect.bottom+=dh;
            }
        if (dy)
            {
            if (side==4)
                {
                fwListPtr[i].newRect.top+=dy+dh;
                fwListPtr[i].newRect.bottom+=dy+dh;
                }
            else
                {
                fwListPtr[i].newRect.top+=dy;
                fwListPtr[i].newRect.bottom+=dy;
                }
             }
         }
     }
  }
  for (i=0;i<fwCount;i++)
  {
 if (fwListPtr[i].tempFlag)
     {
     fwListPtr[i].tempFlag=0;
     TagAllWindowsForGluedWindowResize(fwListPtr[i] .wnd,
     &fwListPtr[i].origRect, &fwListPtr[i].newRect, fwListPtr, fwCount);
     }
  }
  }
  void MoveFloatWindowAndGluedWindows(HWND floatWnd, RECT *newRect,
  Boolean onlyDrawFocusRect, Boolean onlyBottomRight, Boolean repaint,
  Boolean onlyMoveGluedWindows, WindowItemInfo *fwListPtr, long fwCount)
  {
  if (gQuitting)
  return;
  if (GetFloatGlueMode(GetWRefCon(floatWnd)) &&
  !IsXFloatModal(floatWnd))
  {
 long i;
 RECT origRect;
 bool needDispose = false;
 HCOMP floatWndComp=GetWRefCon(floatWnd);
 if (!fwListPtr)
     {
     short toolBoxFilter=0;
     if (GetFloatGlueMode(floatWndComp)==2)
         {
         toolBoxFilter=(IsToolWindow(floatWndComp)) ? 1:2;
         }
     fwListPtr = CreateFloatWindowList(&fwCount, toolBoxFilter);
     needDispose = true;
     }
 else
     {
     ResetWindowItemInfo (fwListPtr, fwCount);
     }
 if (fwListPtr)
     {
     GetOriginalWindowRect(fwListPtr, fwCount, floatWnd,
     &origRect);
     TagAllWindowsForGluedWindowResize(floatWnd, &origRect,
     newRect, fwListPtr, fwCount);
     for (i=0;i<fwCount;i++)
         {
         if (fwListPtr[i].needOffset)
             {
            if (onlyBottomRight)
                {
                if (fwListPtr[i].origRect.left < origRect.left | |
                fwListPtr[i].origRect.top < origRect.top)
                    continue;
                }
             if (onlyDrawFocusRect)
                {
                DrawFocusRect(&fwListPtr[i] .newRect);
                }
             else
                {
                if (!onlyMoveGluedWindows | |
                fwListPtr[i].wnd!=floatWnd)
                    {
                    MoveWindow ( fwListPtr[i].wnd,
                                  fwListPtr[i].newRect.left,
                                  fwListPtr[i].newRect.top,
                                  fwListPtr[i].newRect.right-
                                  fwListPtr[i].newRect.left,
                                  fwListPtr[i].newRect.bottom-
                                  fwListPtr[i].newRect.top,
                                  fwListPtr[i].wnd==floatWnd ?
                                  repaint:TRUE);
                    }
                }
             }
         }
     if (!onlyDrawFocusRect)
         {
         for (i=0;i<fwCount;i++)
             {
             if (fwListPtr[i].snapped)
                {
                DrawFloatWindowFrame(0, fwListPtr[i].wnd);
                }
             }
         }
     if (needDispose)
         free(fwListPtr);
      }
  }
  else
  {
  if (onlyDrawFocusRect)
      {
     DrawFocusRect(newRect);
      }
  else
      {
     if (!onlyMoveGluedWindows)
         {
         MoveWindow ( floatWnd,
                        newRect->left,
                        newRect->top,
                        newRect->right-newRect->left,
                        newRect->bottom-newRect->top,
                        repaint);
        }
    }
 }
 }
 #define minabs(a, b) ((abs(a)<abs(b)) ? a:b)
 #define maxabs(a, b) ((abs(a)>abs(b)) ? a:b)
 static void SnapRectToRect(RECT &testRect, RECT *snapRect)
 {
 RECT testRect1, snapRect1;
 long deltal, delta2, delta;
 testRect.right--;
 testRect. bottom--;
 snapRect->right--;
 snapRect->bottom--;
 testRect1 = testRect;
 InsetRect(&testRect1, -SNAPDIST, -SNAPDIST);
 snapRect1 = *snapRect;
 InsetRect(&snapRect1, -SNAPDIST, -SNAPDIST);
 if (IsSectRect(testRect1, snapRect1))
 {
 delta1=delta2=0;
 delta = snapRect->bottom - testRect.bottom;
 if ( abs(delta) < SNAPDIST)
    (
    delta1=delta;
    }
 delta = snapRect->top - testRect.top;
 if ( abs(delta) < SNAPDIST)
    {
    delta2=delta;
    }
 delta = (deltal && delta2) ? minabs(deltal,delta2) :
 maxabs(deltal, delta2);
 OffsetRect(snapRect, 0, -delta);
 delta1=delta2=0;
 delta = snapRect->right - testRect.right;
 if ( abs(delta) < SNAPDIST)
    {
    delta1=delta;
    }
 delta = snapRect->left - testRect.left;
 if (abs(delta) < SNAPDIST)
    {
    delta2=delta;
    }
 delta = (deltal && delta2) ? minabs(deltal,delta2) :
 maxabs(deltal, delta2);
 OffsetRect(snapRect, -delta, 0);
 delta1=delta2=0;
 delta = snapRect->left - testRect.right;
 if ( abs(delta) < SNAPDIST)
    {
    delta1=delta;
    }
 delta = snapRect->right - testRect.left;
 if (abs(delta) < SNAPDIST)
     {
    delta2=delta;
     }
 delta = (deltal && delta2) ? minabs(deltal,delta2) :
 maxabs(deltal, delta2);
 OffsetRect(snapRect, -delta, 0);
 delta1=delta2=0;
 delta = snapRect->top - testRect.bottom;
 if (abs(delta) < SNAPDIST)
     {
    delta1=delta;
     }
 delta = snapRect->bottom - testRect.top;
 if (abs(delta) < SNAPDIST)
     {
    delta2=delta;
     }
 delta = (deltal && delta2) ? minabs(deltal,delta2) :
 maxabs(deltal, delta2);
 OffsetRect(snapRect, 0, -delta);
 }
 testRect.right++;
 testRect.bottom++;
 snapRect->right++;
 snapRect->bottom++;
 }
 static Boolean SnapFloatWindowExplicit(HWND floatWnd, RECT *fr,
 WindowItemInfo *fwListPtr, long fwCount)
 {
 RECT testRect, origRect;
 Boolean snapped=false;
 long i;
 origRect = *fr;
 for (i=0;i<fwCount;i++)
 {
 if (!fwListPtr[i].snapped && floatWnd!=fwListPtr[i].wnd)
     {
    GetWindowRect(fwListPtr[i].wnd, &testRect);
    SnapRectToRect(testRect, fr);
     }
 }
 if (origRect.left!=fr->left | | origRect.top!=fr->top | |
 origRect.right!=fr->right | | origRect.bottom!=fr->bottom)
 snapped=true;
 return snapped;
 }
 void SnapFloatWindowRect(HWND floatWnd, RECT *newfr,Boolean
 ignoreGluedWindows, WindowItemInfo *fwListPtr, long fwCount, RECT
 *origRect)
 {
 HWND hFWnd;
 RECT testRect, curfr;
 Boolean snapped=false;
 long i, dx, dy;
 bool needDispose=false;
 RECT unionRect={0,0,0,0};
 bool firstTime=true;
 if (!origRect)
 GetWindowRect(floatWnd, &curfr);
 else
 curfr=*origRect;
 if (!fwListPtr)
 {
 fwListPtr = CreateFloatWindowList(&fwCount);
 needDispose = true;
 }
 else
 {
 ResetWindowItemInfo(fwListPtr, fwCount);
 }
 if (fwListPtr)
 {
 if (ignoreGluedWindows)
   {
   TagAllWindowsForGluedWindowResize(floatWnd, &curfr, &curfr,
   fwListPtr, fwCount);
   }
   snapped = SnapFloatWindowExplicit(floatWnd, newfr, fwListPtr,
   fwCount);
   if (GetFloatGlueMode() && !snapped)
   {
   for (i=0;i<fwCount;i++)
       {
       if (fwListPtr[i].snapped && fwListPtr[i].wnd!=floatWnd)
          {
          RECT origTestRect;
          testRect = fwListPtr[i].origRect;
          testRect.left+=(newfr->left-curfr.left);
          testRect.right+=(newfr->left-curfr.left);
          testRect.top+=(newfr->top-curfr.top);
          testRect.bottom+=(newfr->top-curfr.top);
          origTestRect = testRect;
          snapped = SnapFloatWindowExplicit(fwListPtr[i].wnd,
          &testRect, fwListPtr, fwCount);
          if (snapped)
              {
              dx = testRect.left - origTestRect.left;
              dy = testRect.top - origTestRect.top;
              newfr->top+=dy;
              newfr->bottom+=dy;
              newfr->left+=dx;
              newfr->right+=dx;
              break;
              }
          if (firstTime)
              {
              firstTime=false;
              unionRect=testRect;
               }
           else
               {
              UnionRect(unionRect, testRect, &unionRect);
               }
           }
       }
    }
    if (needDispose)
    free(fwListPtr);
 }
 GetDesktopRect(&testRect);
 HMONITOR hmon = MonitorFromRect(newfr, 0);
 if (hmon)
 {
 MONITORINFO monInfo;
 if (GetMonitorInfo(hmon, &monInfo))
    {
    testRect.left = monInfo.rcMonitor.left;
    testRect.top = monInfo.rcMonitor.top;
    testRect.right = monInfo.rcMonitor.right;
    testRect.bottom = monInfo.rcMonitor.bottom;
    }
 }
 if (!firstTime)
 {
 dx=dy=0;
 UnionRect(unionRect, *newfr, &unionRect);
 }
 else
 {
 dx=dy=0;
 unionRect= *newfr;
 unionRect.bottom = unionRect.top+25;
 .unionRect.left = (unionRect.right+unionRect.left)/2;
 unionRect.right = unionRect.left+1;
 }
 if (unionRect.left < testRect.left)
 dx=testRect. left-unionRect.left;
 else if (unionRect.right > testRect.right)
 dx=testRect.right-unionRect.right;
 if (unionRect.top < testRect.top)
 dy=testRect.top-unionRect.top;
 else if (unionRect.bottom > testRect.bottom)
 dy=testRect.bottom-unionRect.bottom;
 newfr->left +=dx;
 newfr->right +=dx;
 newfr->top +=dy;
 newfr->bottom +=dy;
 SnapRectToRect(testRect, newfr);
 }
```

### APPENDIX B

```
 Err InstallDrawTool(TCmpRef theDrawTool);
 Err CreateAndInstallDrawTool(Boolean canPop, Boolean
 canConfigure, short resID, short mode, TToolRef theTool, TCmpID
 theDrawToolID,long helpID, TCmpProcPtr theProcPtr);
 Err InstallDrawToolExt(char *itemTag, TCmpRef theDrawTool);
 Err CreateAndInstallDrawToolExt(char *itemTag, Boolean canPop,
 Boolean canConfigure, short resID, short mode, TToolRef theTool,
 TCmpID theDrawToolID, long helpID, TCmpProcPtr theProcPtr);
 DTCategoryType GetDrawToolCategorys(TCmpID drawToolID);
 void MapDrawToolIDToTag(TCmpID drawToolID, char *tag);
 TCmpID MapTagToDrawToolID(const char *tag);
 long CountDrawTools();
 void GetNthDrawTooInfo(long n, char *tag, long *drawToolID,
 DTCategoryType *category);
 void GetToolName(TCmpID theDrawToolID, char *buff, long len);
 Err CreateHiddenDrawTool(TToolRef theTool, TCmpID
 theDrawToolID, TCmpProcPtr theProcPtr);
 long GetNthHiddenDrawToolData(TCmpID drawToolID, long n);
 Err SetNthHiddenDrawToolData(TCmpID drawToolID, long n, long
 val) ;
 struct PalData
 {
 long tid;
 TCmpRef grpRef;
 Boolean isLocked;
 Boolean saved;
 Boolean popRight;
 void SetPrevWnd(HCOMP prevWnd);
 HCOMP GetPrevWnd();
 void SetNextWnd(HCOMP nextWnd);
 HCOMP GetNextWnd();
 private:
 HCOMP prevFWnd;
 HCOMP nextFWnd;
 };
 inline HCOMP PalData::GetPrevWnd()
 {
 return prevFWnd;
 }
 inline HCOMP PalData::GetNextWnd()
 {
 return nextFWnd;
 }
 extern HWND GetFloatWndFromChild (HWND childWnd);
 inline void PalData::SetPrevWnd(HCOMP prevWnd)
 {
 prevFWnd=GetFloatWndFromChild(prevWnd) ;
 }
 inline void PalData::SetNextWnd(HCOMP nextWnd)
 {
 nextFWnd=GetFloatWndFromChild(nextWnd);
 }
 Boolean IsToolWindow(HCOMP fPalWnd);
 Err SetData(HCOMP fPalWnd, TBOXPalData *data);
 PalData* GetDataPtr(HCOMP fPalWnd);
 void LockStack(HCOMP fPalWnd);
 void PopStack(HCOMP fPalWnd, Boolean ignoreLockedFlag);
 void PushStack(HCOMP fPalWnd, HCOMP newWnd);
 void OrphanFromStack(HCOMP fPalWnd, Boolean repositionPals);
 HCOMP FindStackHead(HCOMP fPalWnd);
 HCOMP FindStackTail(HCOMP fPalWnd);
 HCOMP CreateAndPushGroupOnStack(HCOMP fPalWnd, TCmpID groupID,
 Boolean shouldLock);
 HCOMP ShowRelatedTools(HCOMP parentWnd, TCmpRef drawToolRef);
 void ArrangeStackPalPositions (HCOMP fPalWnd);
 Boolean ShouldPopRight(HCOMP fPalWnd);
 Boolean UseAutoPopMode();
 void SetAutoPopMode(Boolean autoPop);
 void Update();
 HCOMP GetMainToolBox();
 HCOMP GetNextWindow(HCOMP curWnd);
 HCOMP GetPrevWindow(HCOMP curWnd);
 Err CreatePaletteMap();
 Err BuildMenu(TCmpID menuGrpID);
 extern void WalkDrawToolTree(TCmpRef grpRef);
 Err {SetData(HCOMP fPalWnd, PalData *data)
 Err err=0;
 {
 HWND pal;
 Handle h;
 char str[50];
 GetClassName(fPalWnd, str, kStrSize50);
 if (lstrcmp(str, PaletteClass)==0)
    pal = fPalWnd;
 else
    pal = GetDlgItem(GetFloatWndFromChild(fPalWnd),FW_VIEW);
 h = (Handle)GetWindowLong(pal, PL_EXTDATAHDL);
 if (!h)
     {
    err=NewHandErr(&h, sizeof(PalData));
    if (!err)
        {
        SetWindowLong(pal, PL_EXTDATAHDL, (long)h);
        }
     }
 if (!err && h)
     {
    data->tid = 'TBOX';
    BlockMove(data, DerefHand(h), sizeof(PalData));
     }
 }
 return err;
 }
 PalData *GetDataPtr(HCOMP fPalWnd)
 {
 PalData *data=NULL;
 {
 HWND pal;
 Handle h;
 char str[50];
 GetClassName(fPalWnd, str, kStrSize50);
 if (lstrcmp(str, PaletteClass)==0)
    pal = fPalWnd;
 else
    pal = GetDlgItem(GetFloatWndFromChild(fPalWnd),FW_VIEW);
 h = (Handle)GetWindowLong(pal, PL_EXTDATAHDL);
 if (h)
    {
    data = (PalData *)DerefHand(h);
    assert(GetHandSize(h) == sizeof(PalData));
    }
 }
 assert(data);
 return data;
 }
 Boolean IsToolWindow(HCOMP fPalWnd)
 {
 Boolean isTool=false;
 {
 if (GetFloatType(GetFloatWndFromChild(fPalWnd))==FW)
    {
    PalData *data;
    data = GetDataPtr(fPalWnd);
    if (data && data->tid == 'TBOX')
        {
        isTool=true;
        }
    }
 }
 return isTool;
 }
 Boolean ShouldPopRight(HCOMP fPalWnd)
 {
 HCOMP head=FindStackHead(fPalWnd);
 Boolean popRight=true;
 if (head)
 {
 popRight=GetDataPtr(head)->popRight;
 }
 return popRight;
 }
 static void CloseExplicit(HCOMP fPalWnd)
 {
 OrphanFromStack(fPalWnd, false);
 {
 DestroyWindow(GetFloatWndFromChild(fPalWnd));
 }
 }
 static void GetWindowRect(HCOMP fPalWnd, Rect *r)
 { {
 RECT wr;
 fPalWnd = GetFloatWndFromChild(fPalWnd);
 GetWindowRect(fPalWnd, &wr);
 r->left=wr.left;
 r->right=wr.right;
 r->top=wr.top;
 r->bottom=wr.bottom;
 }
 }
 static void MoveWindow(HCOMP fPalWnd, long dx, long dy)
 {
 {
 RECT r;
 fPalWnd = GetFloatWndFromChild(fPalWnd);
 GetWindowRect(fPalWnd, &r);
 MoveWindow(fPalWnd, r.left+dx, r.top+dy, r.right-r.left,
 r.bottom-r.top, true);
 InvalidateRect(fPalWnd, NULL, false);
 }
 }
 static void UpdateCaptionWindows(HCOMP fPalWnd)
 {
 HCOMP curWnd;
 curWnd = FindStackHead(fPalWnd);
 while(curWnd)
 {
   HCOMP captionWnd = GetDlgItem(curWnd, FW_CAPTION);
   if (captionWnd)
       InvalidateRect(captionWnd, NULL, false);
       curWnd = GetDataPtr(curWnd)->GetNextWnd();
 }
 }
 void LockStack(HCOMP fPalWnd)
 {
 while(fPalWnd)
 {
 GetDataPtr(fPalWnd)->isLocked=true;
 fPalWnd = GetDataPtr(fPalWnd)->GetPrevWnd();
 }
 )
 HCOMP FindStackHead(HCOMP fPalWnd)
 {
 HCOMP curWnd, resultWnd=0;
 long maxLoop=20;
 if (GetDataPtr(fPalWnd))
 {
 curWnd=fPalWnd;
 while(curWnd)
   {
   resultWnd=curWnd;
   curWnd=GetDataPtr(curWnd)->GetPrevWnd();
   if (!(maxLoop--))
       {
      assert (0);
      break;
       }
   }
   }
   else
   {
   assert(0);
   resultWnd=fPalWnd;
   }
   return resultWnd;
   }
   HCOMP FindStackTail(HCOMP fPalWnd)
   {
   HCOMP curWnd, resultWnd=0;
   long maxLoop=20;
   if (GetDataPtr(fPalWnd))
   {
   curWnd=fPalWnd;
   while(curWnd)
   {
   resultWnd=curWnd;
   curWnd=GetDataPtr(curWnd)->GetNextWnd();
   if (!(maxLoop--))
       {
      assert(0);
      break;
       }
   }
   }
   else
   {
   assert(0);
   resultWnd=fPalWnd;
   }
   return resultWnd;
   }
   void OrphanFromStack(HCOMP fPalWnd, Boolean repositionPals)
   {
   HCOMP prevWnd, nextWnd;
   PalData *data;
   HCOMP adjWnd=0;
   if (GetDataPtr(fPalWnd))
   {
   prevWnd = GetDataPtr(fPalWnd)->GetPrevWnd();
   if(prevWnd)
   {
   data = GetDataPtr(prevWnd);
   if (data)
       data->SetNextWnd(GetDataPtr(fPalWnd)->GetNextWnd());
   }
   nextWnd = GetDataPtr(fPalWnd)->GetNextWnd();
   if(nextWnd)
   {
   data = GetDataPtr(nextWnd);
   if (data)
       data->SetPrevWnd(GetDataPtr(fPalWnd)->GetPrevWnd());
   }
   GetDataPtr(fPalWnd)->SetPrevWnd(0) ;
   GetDataPtr(fPalWnd)->SetNextWnd(0);
   GetDataPtr(fPalWnd)->isLocked=false;
   }
   if (prevWnd)
   adjWnd=prevWnd;
   else if (nextWnd)
   adjWnd=nextWnd;
   if (adjWnd)
   {
   if (repositionPals)
   {
   ArrangeStackPalPositions(adjWnd);
   }
   UpdateCaptionWindows(adjWnd);
   }
   UpdateCaptionWindows(fPalWnd);
   }
   void ArrangeStackPalPositions(HCOMP fPalWnd)
   {
   HCOMP prevWnd, curWnd;
   Rect prevRect, curRect;
   long dx, dy;
   Boolean popRight;
   popRight=ShouldPopRight(fPalWnd);
   curWnd = FindStackHead(fPalWnd);
   prevWnd = curWnd;
   curWnd = GetDataPtr(curWnd)->GetNextWnd();
   while(curWnd)
   {
   GetWindowRect(prevWnd, &prevRect);
   GetWindowRect(curWnd, &curRect);
   if (popRight)
   {
   dx = prevRect.right - curRect.left - 1;
   }
   else
   {
   dx = prevRect.left - curRect.right + 1;
     }
  dy = prevRect.top - curRect.top;
  if (dx | | dy)
     MoveWindow(curWnd, dx, dy);
  prevWnd = curWnd;
  curWnd = GetDataPtr(curWnd)->GetNextWnd();
  }
  }
  void PopStack(HCOMP fPalWnd, Boolean ignoreLockedFlag)
  {
  HCOMP curWnd, nextWnd;
  curWnd = GetDataPtr(fPalWnd)->GetNextWnd();
  while(curWnd)
  {
  nextWnd = GetDataPtr(curWnd)->GetNextWnd();
  if (ignoreLockedFlag | | !GetDataPtr(curWnd)->isLocked)
      {
     CloseExplicit(curWnd);
      }
  curWnd = nextWnd;
  }
  }
  void PushStack(HCOMP fPalWnd, HCOMP newWnd)
  {
  HCOMP lastWnd;
  lastWnd = FindStackTail(fPalWnd);
  GetDataPtr(lastWnd)->SetNextWnd(newWnd);
  GetDataPtr(newWnd)->SetPrevWnd(lastWnd);
  UpdateCaptionWindows(fPalWnd);
  }
  static HCOMP CreateGroupToolsWindow(HCOMP curWnd, HCOMP fPalWnd,
  TDrawToolGroupData *newGroupData)
  {
  HCOMP newFPalWnd=0;
  long i;
  TCmpRef newGrpRef;
  long maxNumCellVert;
  newGrpRef=FindDrawToolGroup(newGroupData->grpID);
  assert(newGrpRef);
  if (newGrpRef)
  {
  if (GetDataPtr(curWnd)->grpRef == newGrpRef)
      {
      )
  else
      {
         newFPalWnd =
         CreateGroupFloatPalette(GenericGroupPaletteProc, -2000, -2000,
         newGrpRef);
     if (newFPalWnd)
         {
         assert(GetDataPtr(newFPalWnd)->grpRef == newGrpRef);
         GetDataPtr(newFPalWnd)->isLocked= false;
       PushStack(fPalWnd, newFPalWnd);
       TDrawToolGroupData *mainGroupData;
       mainGroupData = GetDrawToolGroupData(
       FindDrawToolGroup(kDTMainGroupID));
       assert(mainGroupData);
       maxNumCellVert = (mainGroupData->itemCount+1)/2;
           {
           POINT fwSize;
           RECT lr;
           GetWindowRect(GetFloatWndFromChild(fPalWnd), &lr);
           if (((newGroupData->itemCount+1)/2) > maxNumCellVert)
               {
               fwSize.y=(maxNumCellVert*kToolCellHeight)+FW_SYSMENUSIZE+(CalcFWFra
               meHeight(0)*2);
               fwSize.x=(((newGroupData->itemCount+maxNumCellVert-
               1)/maxNumCellVert)*kToolCellWidth)+(CalcFWFrameWidth(0)*2);
               }
           else
               {
               if (0)
                   {
                   fwSize.x=(kToolCellHeight) + (CalcFWFrameWidth (0) *2) ;
                  fwSize.y=(((newGroupData-
                  >itemCount+1))*kToolCellHeight)+FW_SYSMENUSIZE+(CalcFWFrameHeight(0)*2
                  ) ;
                   }
               else
                   {
                   fwSize.x=(2*kToolCellHeight) + (CalcFWFrameWidth (0) *2) ;
                  fwSize.y=(((newGroupData-
                  >itemCount+1)/2)*kToolCellHeight)+FW_SYSMENUSIZE+(CalcFWFrameHeight(0)
                  *2) ;
                   }
               }
           AdjustFloatWindowSize(GetFloatWndFromChild(newFPalWnd),
           &fwSize) ;
           if (ShouldPopRight(newFPalWnd))
               {
              MoveFloatWindow(GetFloatWndFromChild(newFPalWnd),
              lr.right-1, lr.top, fwSize.x, fwSize.y);
               }
           else
               {
              MoveFloatWindow(GetFloatWndFromChild(newFPalWnd),
              lr.left-fwSize.x+1, lr.top, fwSize.x, fwSize.y);
               }
           }
       UpdateCaptionWindows(fPalWnd) ;
        }
    }
 }
 return newFPalWnd;
 }
 HCOMP CreateAndPushGroupOnStack(HCOMP fPalWnd, TCmpID groupID, Boolean
 shouldLock)
 {
 HCOMP newWnd=0;
 TDrawToolGroupData groupData;
 TCmpRef grpRef;
 grpRef = FindDrawToolGroup(groupID);
 if (grpRef)
 {
 groupData = *GetDrawToolGroupData(grpRef);
 if (groupData.itemCount>1 && groupData.grpID!=kDTMainGroupID)
   {
   HCOMP head, curWnd, lastWnd;
   head=FindStackHead(fPalWnd);
   if (head==FindStackTail(fPalWnd))
       {
       Rect headRect, monitorRect;
       GetWindowRect(head, &headRect);
       GetBestMonitorRectFromRect(&headRect, &monitorRect);
       if (headRect.left<
       ((monitorRect.left+monitorRect.right)/2))
           {
          GetDataPtr(head)->popRight=true;
           }
       else
           {
          GetDataPtr(head)->popRight=false;
           }
       }
   PopStack(fPalWnd, false);
   lastWnd = FindStackTail(fPalWnd);
   newWnd=CreateGroupToolsWindow(fPalWnd, lastWnd, &groupData);
   if (newWnd)
       {
       GetDataPtr(newWnd)->popRight=GetDataPtr(head)->popRight;
       }
    }
    }
    if (newWnd && shouldLock)
 {
 GetDataPtr(newWnd)->isLocked=true;
 }
 return newWnd;
 }
 HCOMP ShowRelatedTools(HCOMP fPalWnd, TCmpRef drawToolRef)
 {
 HCOMP result=0;
 TDrawToolGroupData groupData;
 TBaseDrawToolData *toolData;
 if (drawToolRef)
 {
 toolData = GetBaseDrawToolData(drawToolRef);
 groupData = *GetDrawToolGroupData(toolData->pvParentGroup);
 if (groupData.itemCount==1)
      {
      groupData = *GetDrawToolGroupData(groupData.parentGroup);
      }
  if (groupData.itemCount>1 && groupData.grpID!=kDTMainGroupID)
      {
      if (UseAutoPopMode())
          {
          Boolean found=false;
          HCOMP head, curWnd, lastWnd;
          head=FindStackHead(fPalWnd) ;
          if (head==FindStackTail(fPalWnd))
              {
             Rect headRect, monitorRect;
             GetWindowRect(head, &headRect);
             GetBestMonitorRectFromRect(&headRect, &monitorRect);
             if (headRect.left<
             ((monitorRect.left+monitorRect.right)/2))
                 {
                 GetDataPtr(head)->popRight=true;
                 }
             else
                 {
                 GetDataPtr(head)->popRight=false;
                 }
              )
          curWnd = FindStackHead(fPalWnd);
          while(curWnd)
              {
             assert(GetDataPtr(curWnd));
             if (GetDataPtr(curWnd))
                 {
                 if (GetDrawToolGroupData(GetDataPtr(curWnd)->grpRef
                 )->grpID==groupData.grpID)
                     {
                     found=true;
                     result=curWnd;
                     break;
                     }
                 }
             curWnd = GetDataPtr(curWnd)->GetNextWnd();
              }
          if (! found)
              {
             PopStack(fPalWnd, false);
             lastWnd = FindStackTail(fPalWnd);
             result = CreateGroupToolsWindow(fPalWnd, lastWnd,
             &groupData) ;
             if (result)
                 {
                 GetDataPtr(result)->popRight=GetDataPtr(head)-
                 >popRight;
                 }
              }
          }
      else
          {
         TCmpRef newGrpRef;
         FloatStateInfo floatState;
         newGrpRef=FindDrawToolGroup (groupData. grpID) ;
         assert(newGrpRef);
         if (newGrpRef)
             {
             GetFloatWindowState(LC('D', 'T', 'G', 'P'),
             groupData.grpID, &floatState);
                 result =
                 CreateGroupFloatPalette(GenericGroupPaletteProc, floatState.posx,
                 floatState.posy, newGrpRef);
             }
          }
      }
  }
  return result;
  }
  void Update()
  {
  UpdateAllGroupPalettes(FindMainDrawToolGroup()) ;
  }
  HCOMP GetMainToolBox()
  {
  return ToolboxWnd;
  }
  HCOMP GetNextWindow(HCOMP curWnd)
  {
  return GetDataPtr(curWnd)->GetNextWnd();
  }
  HCOMP GetPrevWindow(HCOMP curWnd)
  {
  return GetDataPtr(curWnd)->GetPrevWnd();
  }
```

### APPENDIX C

```
 typedef long CVEditSessionType;
 enum ContextType
 {
 ContextType_Undefined=0,
 ContextType_DrawTool=1,
 ContextType_EditSession=2,
 ContextType_ObjectType=3,
 ContextType_Default_NoSelection=4,
 ContextType_Default_MultipleSelection=5
 } ;
 typedef double ContextID;
 class ContextMode
 {
 public:
 ContextMode()
 : pvContextType (ContextType_Undefined)
 , pvDrawToolID (0)
 , pvEditSessionType (0)
 , pvObjType (0)
 , pvObjCreatorToolID (0)
 { }
 void SetContextToDrawTool(TCmpID drawToolID)
 { pvContextType=ContextType_DrawTool; pvDrawToolID=drawToolID; }
 void SetContextToEditSession(CVEditSessionType editSessionType,
 TCmpID drawToolID) {pvContextType=ContextType_EditSession;
 pvEditSessionType=editSessionType; pvDrawToolID=drawToolID; }
 void SetContextToObjectType(ObjectType objType)
     { pvContextType=ContextType_ObjectType; pvObjType=objType;
     pvObjCreatorToolID=0;}
 void SetContextToExtObjectType(ToolID objCreatorToolID)
         { pvContextType=ContextType_ObjectType;
         pvObjType=ObjectCreator; pvObjCreatorToolID=objCreatorToolID; }
 void SetContextToDefault(ContextType type)
 { pvContextType=type;}
 ContextType GetContextType() const {
 return pvContextType; }
 TCmpID GetContextDrawTool() const {
 return (pvContextType==ContextType_DrawTool | |
 pvContextType==ContextType_EditSession) ? pvDrawToolID:-1; }
 CVEditSessionType GetContextEditSession() const {
 return (pvContextType==ContextType_EditSession) ? pvEditSessionType: -
 1; )
 ObjectType GetContextObjectType() const {
 return (pvContextType==ContextType_ObjectType) ? pvObjType: -1; }
 ToolID GetContextExtObjectType() const {
 return (pvContextType==ContextType_ObjectType) ? pvObjCreatorToolID: -
 1; )
 CVBoolean TestContext(ContextMode &testContext);
 ContextID GetContextID();
 private:
 ContextType pvContextType;
   TCmpID pvDrawToolID;
   CVEditSessionType pvEditSessionType;
   ObjectType pvObjType;
   ToolID pvObjCreatorToolID;
   };
   inline ContextID ContextMode::GetContextID()
   {
   ContextID id=(pvContextType-1)*0x8FFFFFF*2;
   switch(pvContextType)
   {
   case ContextType_DrawTool: id+=pvDrawToolID;
   break;
   case ContextType_EditSession:
   id+=pvEditSessionType+pvDrawToolID; break;
   case ContextType_ObjectType:
   id+=pvObjType+pvObjCreatorToolID; break;
   default: id+=pvContextType;
   break;
   }
   return id;
   }
   inline CVBoolean ContextMode::TestContext(ContextMode &testContext)
   {
   CVBoolean valid=false;
   if (testContext.GetContextType() == GetContextType())
   {
   switch(pvContextType)
       {
       case ContextType_DrawTool:
          valid =
          (testContext.GetContextDrawTool()==GetContextDrawTool()) ;
          break;
       case ContextType_EditSession:
          valid =
          (testContext.GetContextEditSession()==GetContextEditSession() &&
          testContext.GetContextDrawTool()==GetContextDrawTool()) ;
          break;
       case ContextType_ObjectType :
          valid =
          (testContext.GetContextObjectType()==GetContextObjectType() &&
          testContext.GetContextExtObjectType()==GetContextExtObjectType()) ;
          break;
      default:
          valid=true;
          break;
       }
   }
   return valid;
   }
   struct ContextMappingData
   {
   ContextMode refContext;
   TCmpRef mapperCmp;
   };
   static ContextMode gLastContextSet;
   static CFixedSortedArray *gUIContextItemList=0;
   static CFixedArray *gUIContextItemCacheList=0;
   static CFixedArray *gUIContextMapper=0;
   extern UIDlg gContextStripUIDlg;
   #define STATIC _CVAPI CVAPI
   static void CXRecordContextStripOperation();
   extern void RegisterDefaultContextItems();
   void InitCoreContextStripItems()
   {
   RegisterDefaultContextItems() ;
   }
   static short UIContextItemCompareProc(const TPtr elementData, TIndex
   index, long theList)
   {
   short result;
   UIContextItemExt *indexItem, *cmpItem;
   assert(index <= ((CFixedSortedArray*)theList)->Count());
   cmpItem = (UIContextItemExt *) elementData;
   indexItem = (UIContextItemExt *)((CFixedSortedArray*)theList)-
   >GetPtr(index);
   if (indexItem->contextID == cmpItem->contextID)
 {
 if (cmpItem->order == indexItem->order)
    {
    result=0;
    }
    else if (cmpItem->order < indexItem->order)
    {
    result = -1;
    }
    else
    {
    result = 1;
    }
 }
 else if (cmpItem->contextID < indexItem->contextID)
 {
 result = -1;
 }
 else
 {
 result = 1;
 }
 return result;
 }
 CVErr CXInitContextEngine()
 {
 CVErr err=0;
 if (!gUIContextItemList)
 {
 gUIContextItemList = new CFixedSortedArray;
 if (gUIContextItemList)
    {
    err=gUIContextItemList-
    >IFixedSortedArray(sizeof(UIContextItemExt),
    (sizeof(UIContextItemExt)*25), UIContextItemCompareProc, FALSE);
    }
 else
    {
    err=-1;
    }
 if (!err)
    {
    gUIContextItemCacheList=new CFixedArray;
    if(gUIContextItemCacheList)
        {
       err=gUIContextItemCacheList-
       >IFixedArray(sizeof(UIContextItemCache),
       (sizeof(UIContextItemCache)*25), FALSE);
        }
    else
        {
        err=-1;
        }
    }
 }
 if (!err && !gUIContextMapper)
 {
 gUIContextMapper = new CFixedArray;
 if (gUIContextMapper)
    {
    err=gUIContextMapper->IFixedArray(sizeof(ContextMappingData),
    1, FALSE);
    }
 else
    {
    err=-1;
    }
 }
 if (!err)
 InitCoreContextStripItems();
 assert(! err);
 return err;
 }
 void CXDisposeContextEngine()
 {
 if (gUIContextItemList)
 {
 delete(gUIContextItemList) ;
 gUIContextItemList=0;
 }
 if (gUIContextItemCacheList)
 {
 delete(gUIContextItemCacheList);
 gUIContextItemCacheList=0;
 }
 if (gUIContextMapper)
 {
 delete(gUIContextMapper);
 gUIContextMapper=0;
 }
 }
 void CXGetCurrentContextExt(ContextMode *curContext, CVBoolean
 forDynaHelp)
 {
 ContextMode cm;
 TCmpID curDrawToolID;
 CVBoolean done=false;
 TCmpRef dt;
 dt = DTGetCurrentDrawTool();
 curDrawToolID=(dt) ? DTGetDrawToolID(dt):0;
 if (curDrawToolID)
 {
 if (EditingSessionPresent())
   {
   CVEditStackItem edItem;
   GetIndEditStackItem(gTopOfStack, &edItem);
   if (edItem.editType)
       {
       cm.SetContextToEditSession(edItem.editType,
       curDrawToolID);
       done=true;
       }
   }
   if (!done && !forDynaHelp)
   {
   if(curDrawToolID==kDTHand | | curDrawToolID==kDTMag)
       {
       curDrawToolID=kDTArrow;
       }
   }
   if (!done && curDrawToolID!=kDTArrow &&
   curDrawToolID!=kDTDirectArrow && curDrawToolID!=kDTVectorLasso)
   {
   cm.SetContextToDrawTool(curDrawToolID);
   done=true;
   }
   }
   else
   {
   done=true;
   }
   if (!done)
   {
   long numSel = sCVSelection->CountSelection();
   if (numSel==1)
   {
   ObjectType objType;
   CVSelectionItem sItem;
   sCVSelection->GetNthSelectionItem(1, &sItem);
   objType=GetObjType(sItem.theObj);
   if (objType==ObjectCreator)
         {
        cm.SetContextToExtObjectType(GetObjTool(sItem.theObj)) ;
         }
     else
         {
        cm.SetContextToObjectType(objType);
         }
     }
 else if (numSel>1)
     {
     cm.SetContextToDefault(ContextType_Default_MultipleSelection);
     }
 else
     {
     cm.SetContextToDefault(ContextType_Default_NoSelection);
     }
 }
 long i, mapperCount = gUIContextMapper->Count();
 for (i=1;i<=mapperCount;i++)
 {
 ContextMappingData *data =(ContextMappingData
 *)gUIContextMapper->GetPtr(i);
 if (cm.TestContext(data->refContext))
     {
     CXMapContextMsg msgData;
     msgData.contextToMap = cm;
     if (SendCmpMsg(data->mapperCmp, 0, CXMapContextMsgID,
     &msgData))
         {
        cm = msgData.contextToMap;
        break;
         }
     }
 }
 *curContext = cm;
 }
 static CVAPI void CXGetCurrentContext(ContextMode *curContext)
 {
 if (CVHaveDocument())
 CXGetCurrentContextExt(curContext, false);
 else
 curContext->SetContextToDefault(ContextType_Undefined);
 }
 CVErr CXCreateUICacheItem(long *uiCacheItem)
 {
 CVErr err=0;
 *uiCacheItem=0;
 err=gUIContextItemCacheList->Add(*uiCacheItem) ;
 if (!err)
 {
 CXGetUIContextCacheltem(*uiCacheItem)->dlgCountID=0;
 CXGetUIContextCacheltem(*uiCacheItem)->labelID=0;
 CXGetUIContextCacheltern(*uiCacheItern)->itemID=0;
 CXGetUIContextCacheltem(*uiCacheItem)->unitLabelID=0;
 CXGetUIContextCacheItem(*uiCacheItem)->lastAccessTime=0;
 }
 return err;
 }
 CVAPI CVErr CXRegisterContextItemExt(ContextMode *context, CXItemID
 cxitem, TCmpRef cmp, const char *label,
                      long uiCacheItem, const CXItemLabelInfo
                      *advLabelInfo,
                      CXAlignment itemAlignment, CXBehaviorFlags
                      behavior, CXItemID cxGroupItem)
                      {
                      CVErr err=0;
                      UIContextItemExt item;
                      long i;
                      CVBoolean shouldAdd=true;
                      if (context->GetContextType()==ContextType_Undefined)
 {
 assert(0) ;
 err=-1;
 }
 else
 {
 assert(gUIContextItemList);
 item.contextID = context->GetContextID();
 item.context = *context;
 item.cxitem = cxitem;
 item.cmpHandler = cmp;
 item.itemAlignment = itemAlignment;
 item.behavior = behavior;
 item.cxGroupItem = cxGroupItem;
 item.order=gUIContextItemList->Count() ;
 if (advLabelInfo)
    {
    item.advLabelInfo = *advLabelInfo;
    }
 else
    {
    memset(&item.advLabelInfo, 0, sizeof(CXItemLabelInfo));
    }
 if (label)
    strcpy(item.label, label);
 else
    item.label[0]=0;
 item.uiCacheItem=uiCacheItem;
 i=CXFindFirstUIContextItem(context);
 while(i)
   {
    if (CXGetNthUIContextItem(i)->cxitem==cxitem)
        {
        char buff[255];
        sprintf(buff, "RegisterContextItem Error: Duplicate cxitem
        for ContextMode not allowed. Skipping item. (CXITEM=%d, LABEL1=%s,
        LABEL2=%s)", cxitem, CXGetNthUIContextItem(i)->label, label);
        CVCustMessageBox(buff, "OK", "", "");
        shouldAdd=false;
         break;
         }
     i=CXFindNextUIContextItem(context, i);
     }
 if (shouldAdd)
     {
     i=gUIContextItemList->AddData(&item) ;
     if (!i)
         err=-108;
     }
  }
  return err;
  }
  CVAPI CVErr CXRegisterContextItem(ContextMode *context, CXItemID
  cxitem, TCmpRef cmp, const char *label, const CXItemLabelInfo
  *advLabelInfo, CXAlignment itemAlignment, CXBehaviorFlags behavior)
  {
  CVErr err=0;
  long uiCacheItem;
  err=CXCreateUICacheItem(&uiCacheItem) ;
  if (!err)
  {
 err=CXRegisterContextItemExt(context, cxitem, cmp, label,
 uiCacheItem, advLabelInfo, itemAlignment, behavior, 0);
  }
  return err;
  }
  static CVAPI CVErr CXRegisterContextItemList(ContextMode *context,
  long numContexts, CXItemID cxitem, TCmpRef cmp, const char *label,
  const CXItemLabelInfo *advLabelInfo, CXAlignment itemAlignment,
  CXBehaviorFlags behavior)
  {
  CVErr err=0;
  long i;
  long uiCacheItem;
  err=CXCreateUICacheItem(&uiCacheItem);
  if (!err)
  {
  for (i=0;i<numContexts && !err;i++)
     {
     err=CXRegisterContextItemExt(&context[i], cxitem, cmp, label,
     uiCacheItem, advLabelInfo, itemAlignment, behavior, 0);
     }
  }
  return err;
  }
  static CVAPI CVErr CXRegisterContextItemGroup(ContextMode
  *contextList, long numContexts, CXItemID cxGroupItem, const
  UIContextItem *itemList, long numItems)
  {
  CVErr err=0;
  long i, j;
  for (i=0;i<numItems && !err;i++)
  {
  long uiCacheItem;
  err=CXCreateUICacheItem(&uiCacheItem) ;
  if (!err)
   {
   for (j=0;j<numContexts && !err;j++)
       {
      err=CXRegisterContextItemExt (&contextList[j],
                                   itemList[i].cxitem,
                                   itemList[i].cmpHandler,
                                   itemList[i] .label,
                                   uiCacheItem,
                                   &itemList[i] .advLabelInfo,
                                   itemList[i].itemAlignment,
                                   itemList[i].behavior,
                                   cxGroupItem) ;
       }
   }
   }
   return err;
   }
   static CVBoolean gDidContextChange=false;
   static CVBoolean gContextChangeLocked=false;
   void CXHandleContextChange(CVBoolean forceChange)
   {
   if (CVHaveDocument())
   {
   if ((gDidContextChange | | forceChange) && !UIHaveModal() &&
   !IsMenuKeyDown())
   {
   ContextMode curContext;
   CXGetCurrentContext(&curContext);
   if (!curContext.TestContext(gLastContextSet) | | forceChange)
       {
      CXSetContextStrip(&curContext) ;
       }
   else
       {
      CXAdjustContextStrip() ;
       }
   gDidContextChange=false;
   }
   }
   else
   {
   CXDeactivateContextStrip();
   gLastContextSet.SetContextToDefault(ContextType_Undefined);
   }
   }
   static CVAPI void CXSetAndAdjustContextStrip(ContextMode *context,
   CXBehaviorFlags adjustBehavior, void *behaviorData)
   {
   if (!context)
 {
 CXAdjustContextStrip(adjustBehavior, behaviorData);
 }
 else
 {
 ContextMode cm = *context;
 long i, mapperCount = gUIContextMapper->Count();
 for (i=1;i<=mapperCount;i++)
    {
    ContextMappingData *data = (ContextMappingData
    *)gUIContextMapper->GetPtr(i);
    if (cm.TestContext(data->refContext))
        {
       CXMapContextMsg msgData;
       msgData.contextToMap = cm;
       if (SendCmpMsg(data->mapperCmp, 0, CXMapContextMsgID,
       &msgData))
           {
           cm = msgData.contextToMap;
           break;
           }
        }
    }
 if (!gLastContextSet.TestContext(cm))
    {
    CXSetContextStrip(&cm);
    }
 if (adjustBehavior)
    CXAdjustContextStrip(adjustBehavior, behaviorData);
 }
 }
 static CVAPI void CXContextChange()
 {
 if (!gContextChangeLocked)
 gDidContextChange=true;
 )
 static CVAPI void CXLockContextChangeState()
 {
 gContextChangeLocked=true;
 }
 static CVAPI void CXUnlockContextChangeState()
 {
 gContextChangeLocked=false;
 }
 void CXSetContextStrip(ContextMode *context)
 {
 if (gContextStripUIDlg)
 {
 CXItemBeginBatchShow() ;
 CXDeactivateContextStrip();
 CXActivateContextStrip(context);
 CXItemEndBatchShow() ;
 PurgeCachedItems();
 gLastContextSet=*context;
 }
 }
 long CXFindFirstUIContextItem(ContextMode *context)
 {
 CVBoolean found;
 long n;
 UIContextItemExt item, *list;
 ContextID curContextID = context->GetContextID();
 item.contextID=context->GetContextID() ;
 item.order=-1;
 n=gUIContextItemList->FindData(&item, &found);
 if (n>0 && n<=gUIContextItemList->Count())
 {
 list = (UIContextItemExt *)gUIContextItemList->GetPtr(n);
 if (list->contextID == curContextID)
    {
    for (;n>1;n--)
       {
       list--;
       if (list->contextID!=curContextID)
           break;
       }
    }
    else
    {
   n=0;
    }
 }
 else
 {
 n=0;
 }
 return n;
 }
 long CXFindNextUIContextItem(ContextMode *context, long lastItem)
 {
 long n;
 UIContextItemExt *list;
 ContextID curContextID = context->GetContextID();
 n = lastItem;
 list = (UIContextItemExt *)gUIContextItemList->GetPtr(n);
 if ((n+1)<=gUIContextItemList->Count())
 {
 list++;
 if (list->contextID==curContextID)
    {
   n++;
    }
    else
    {
   n=0;
   }
   }
   else
   {
   n=0;
   }
   return n;
   }
   UIContextItemExt *CXGetNthUIContextItem(long n)
   {
   return (UIContextItemExt *)(gUIContextItemList->GetPtr(n));
   }
   UIContextItemCache *CXGetUIContextCacheItem(long n, CVBoolean
   updateLastAccessTime)
   {
   UIContextItemCache *cacheItem;
   cacheItem = (UIContextItemCache *)(gUIContextItemCacheList-
   >GetPtr(n)) ;
   if (updateLastAccessTime)
   cacheItem->lastAccessTime=UIGetSecs();
   return cacheItem;
   }
   long CXCountUICacheItems()
   {
   return gUIContextItemCacheList->Count();
   )
   static CVAPI CVErr
   CXCreateContextListForDrawToolCategory(DTCategoryType category, Handle
   *rList, long *numItems)
   {
   CVErr err=0;
   Handle h;
   long i, numDrawTools=TBOXCountDrawTools(), n;
   DTCategoryType curCat;
   ContextMode *contextList;
   long dtid;
   err = NewHandErr(&h, numDrawTools*sizeof(ContextMode));
   if (!err)
   {
   HLock(h);
   contextList=(ContextMode *)DerefHand(h);
   for (n=0, i=1;i<=numDrawTools;i++)
   {
   TBOXGetNthDrawTooInfo(i, NULL, &dtid, &curCat);
   if (curCat==category)
       {
      contextList[n].SetContextToDrawTool(dtid);
      n++;
       }
   }
   HUnlock(h) ;
   SetHandSize(&h, n*sizeof(ContextMode));
   *rList=h;
   numItems=n;
   }
   return err;
   }
   static CVAPI CVErr CXInstallContextMapper(ContextMode *contextToMap,
   TCmpRef mapperCmp)
   {
   CVErr err=0;
   TIndex entry;
   err = gUIContextMapper->Add(entry);
   if (!err)
   {
   ContextMappingData *data = (ContextMappingData
   *)gUIContextMapper->GetPtr(entry);
   data->refContext = *contextToMap;
   data->mapperCmp=mapperCmp;
   }
   return err;
   }
   static CVAPI CVBoolean CXShowContextStrip(CVBoolean show)
   {
   CVBoolean wasShown;
   wasShown = gContextStripUIDlg ? true:false;
   {
   }
   else
   {
   CXShowContextStripWindow(show ? 1:0);
   }
   return wasShown;
   }
   struct Globals
   {
   CVContextStripSuite contextSuite;
   } ;
   static Globals gHolder;
   static Globals *g=0;
   static SPBasicSuite *sSPBasic=0;
   STATIC_CVAPI CVErr CXRegisterStandardContextItem(ContextMode *context,
   CXStandardItemType itemType, long param);
   STATIC_CVAPI CVErr CXRegisterStandardContextItemList(ContextMode
   *contextList, long numContexts, CXStandardItemType itemType, long
   param);
   STATIC_CVAPI TCmpID CXFindContextItem(UIDlg parent, CXItemID cxitem);
   STATIC_CVAPI void CXAdjustContextItem(UIDlg parent, CXItemID cxitem);
   STATIC_CVAPI void CXItemEnable(CXItemID cxitem);
   STATIC_CVAPI void CXItemDisable(CXItemID cxitem);
   STATIC_CVAPI void CXChangeContextItemLabel(CXItemID cxitem, const char
   *label);
   STATIC_CVAPI void CXGetStandardContextItemValues(UIDlg parent,
   CXStandardItemType type, void *data, long dataSize);
   STATIC_CVAPI void CXSetStandardContextItemValues(UIDlg parent,
   CXStandardItemType type, void *data, long dataSize);
   static void GetSuiteProcs(CVContextStripSuite *p)
   {
   p->CXRegisterContextItem = CXRegisterContextItem;
   p->CXRegisterContextItemList =
   CXRegisterContextItemList;
   p->CXRegisterContextItemGroup =
   CXRegisterContextItemGroup;
   p->CXRegisterStandardContextItem =
   CXRegisterStandardContextItem;
   p->CXRegisterStandardContextItemList =
   CXRegisterStandardContextItemList;
   p->CXInstallContextMapper = CXInstallContextMapper;
   p->CXGetCurrentContext = CXGetCurrentContext;
   p->CXCreateContextListForDrawToolCategory =
   CXCreateContextListForDrawToolCategory;
   p->CXFindContextItem = CXFindContextItem;
   p->CXAdjustContextItem = CXAdjustContextItem;
   p->CXItemEnable = CXItemEnable;
   p->CXItemDisable = CXItemDisable;
   p->CXChangeContextItemLabel =
   CXChangeContextItemLabel;
   p->CXContextChange = CXContextChange;
   p->CXSetAndAdjustContextStrip =
   CXSetAndAdjustContextStrip;
   p->CXGetStandardContextItemValues =
   CXGetStandardContextItemValues;
   p->CXSetStandardContextItemValues =
   CXSetStandardContextItemValues;
   p->CXShowContextStrip = CXShowContextStrip;
   p->CXLockContextChangeState =
   CXLockContextChangeState;
   p->CXUnlockContextChangeState =
   CXUnlockContextChangeState;
   }
   static void LoadSuiteProcs(void)
   {
   GetSuiteProcs(&g->contextSuite);
   }
   static SPErr DoInitSuite()
   {
   SPErr err=kSPNoError;
   long suite;
   SPGetBasicSuite(&sSPBasic);
   g = &gHolder;
   if(!err)
   {
   LoadSuiteProcs();
   err=CVAddSuite {0,
   kContextStripSuite,
   kContextStripSuiteVersion,
   1,
   &g->contextSuite,
   sizeof(CVContextStripSuite),
   &suite
    );
    }
    return err;
    }
    static void InitContextStripTool(TToolRef theTool)
    {
    UINewMenuItemStruct info;
    TUIMenuRef theMenu;
    memset(&info, 0, sizeof(info));
    info.name = kCXStr_ShowContextStrip;
    info.toolID = kContextStripToolID;
    info.cmdID = 2;
    info.iconType = kMenuIconSuiteType;
    info.iconID = kShowIconBarSubIcon;
    theMenu = UINewMenuItemExt(&info);
    if (theMenu)
    {
    UIInsertToMenuGrp(kCVBarsGroupID, theMenu);
    }
    info.name = kCXStr_ShowDynamicHelp;
    info.toolID = kContextStripToolID;
    info.cmdID = 3;
    info.iconType = kMenuIconSuiteType;
    info.iconID = kShowIconBarSubIcon;
    theMenu = UINewMenuItemExt(&info);
    if (theMenu)
    {
    UIInsertToMenuGrp(kCVBarsGroupID, theMenu);
    }
    }
    static void DoAdjustMenu(UIMenuAdjustMsg *theMsg)
    {
    short height, pos, stripPartHeight;
    CXGetContextStripWindowInfo(&height, &pos, &stripPartHeight);
    switch(theMsg->cmdID)
    {
    case 2:
   {
   UIEnableMenu(theMsg->theItem, true);
   if (pos)
       {
       UISetMenuName(theMsg->theItem, kCXStr_HideContextStrip);
       }
   else
       {
       UISetMenuName(theMsg->theItem, kCXStr_ShowContextStrip);
       }
   break;
   }
 case 3:
     {
    if (height==stripPartHeight)
        {
        UISetMenuName(theMsg->theItem, kCXStr_ShowDynamicHelp) ;
        }
    else
        {
        UISetMenuName(theMsg->theItem, kCXStr_HideDynamicHelp);
        }
     if (pos)
        {
        UIEnableMenu(theMsg->theItem, true);
        }
     else
        {
        UIEnableMenu(theMsg->theItem, false);
    break;
     }
 }
 }
 static void DoMenuChosen(UIMenuChosenMsg *theMsg)
 {
 short height, pos, stripPartHeight;
 CXGetContextStripWindowInfo(&height, &pos, &stripPartHeight);
 switch(theMsg->cmdID)
 {
 case 2:
     {
     if (pos)
        {
        CXShowContextStripWindow(0);
        }
     else
        {
        CXShowContextStripWindow(1) ;
        }
    break;
     }
 case 3:
     {
     if (height==stripPartHeight)
        {
        CXShowContextStripWindow(-1, 1);
        }
     else
        {
        CXShowContextStripWindow(-1, 0);
        }
    break;
     }
 }
 }
 long ContextStripToolProc(ToolCallParameterBlock &gToolCall)
 {
 SPErr err=0;
 TToolRef theTool = gToolCall.thisTool;
 TCmpMsgID theMsgID = gToolCall.Message;
 TCmpMsgData theMsgData = gToolCall.ParameterData;
 switch(theMsgID)
  {
 case PreInitToolMsg:
     {
     err = DoInitSuite();
     break;
     }
 case InitToolMsg:
     {
     InitContextStripTool(theTool);
     break;
     }
 case PostInitMsg:
     {
     CXShowContextStripWindow(-1, -1);
     break;
     }
 case UIMenuChosenMsgID:
     {
     DoMenuChosen((UIMenuChosenMsg *)theMsgData);
     break;
     }
 case UIMenuAdjustMsgID:
     {
     DoAdjustMenu((UIMenuAdjustMsg *)theMsgData);
     break;
     }
 case PlayActionMsgID:
     {
     DoPlayAction((PlayActionMsg*) theMsgData);
     err = 1;
     break;
     }
  }
  return err;
  }
  inline long GetSecondsBetweenItemPurge()
  {
 if (CVIsWinNT())
     return kSecondsBetweenItemPurge;
 else
 } return kSecondsBetweenItemPurge_Win98ME;
 struct UIContextStripItem
 {
 CXItemID cxitem;
 TCmpID itemID;
 TCmpRef cmpHandler;
 CXItemID cxGroupItem;
 short cxPage;
 Rect origItemRect;
 CXBehaviorFlags behavior;
 char actionLabel[64];
 CVBoolean adjusted;
 CVBoolean canBreakAfter;
 CVBoolean forcePageBreakAfter;
 CVBoolean itemMovedToPage;
 };
 struct UIContextStripDlgData
 {
 long dlgCountID;
 long numItems;
 long nextID;
 short cxCurPage;
 short cxTotalPage;
 CVBoolean cxPagesCalced;
 long totalItemWidth;
 CVBoolean hasPageBreaks;
 long lastCachePurgeTime;
 UIContextStripItem items [kMaxContextStripItems];
 } ;
 UIDlg gContextStripUIDlg=0;
 static long gContextStripUIDlgCountID=0;
 static long gDynamicHelpWindowHeight=0;
 struct CXItemBatchShowData
 {
 CVBoolean batchShowStarted;
 long numItems;
 TCmpID itemList[kMaxContextStripItems*2];
 CVBoolean showItem[kMaxContextStripItems*2];
 HDWP winMoveData;
 CXItemBatchShowData()
  {
  batchShowStarted=false;
  }
  };
  static CXItemBatchShowData gCXBatchShowData;
  static void CXGetContextDlgBounds(Rect *r)
  {
  if (gContextStripUIDlg)
  {
  UIGetBounds(gContextStripUIDlg, 0, r);
  r->bottom-=gDynamicHelpWindowHeight;
  }
  else
  {
  r->left=0;
  r->top=0;
  r->right=0;
 r->bottom=0;
 }
 static void CXGetItemRect(UIDlg theDlg, TCmpID itemID, Rect *r)
 {
 Rect dlgRect, itemRect;
 UIGetScreenRect(theDlg, 0, &dlgRect);
 UIGetScreenRect(theDlg, itemID, r);
 r->left-=dlgRect.left;
 r->right-=dlgRect.left;
 r->top-=dlgRect.top;
 r->bottom-=dlgRect.top;,
 }
 void CXItemBeginBatchShow()
 {
 assert(!gCXBatchShowData.batchShowStarted);
 gCXBatchShowData.batchShowStarted=true;
 gCXBatchShowData.numItems=0;
 gCXBatchShowData.winMoveData = 0;
 }
 void CXItemEndBatchShow()
 {
 long i;
 TCmpID itemID;
 CVBoolean done=false;
 if (gCXBatchShowData.batchShowStarted)
 {
    if (gCXBatchShowData.winMoveData)
        {
        EndDeferWindowPos(gCXBatchShowData.winMoveData) ;
        gCXBatchShowData.winMoveData=0;
        }
    HDWP winShowData;
 if (!done)
     {
    for (i=0;i<gCXBatchShowData.numItems;i++)
        {
        itemID = gCXBatchShowData.itemList[i];
        if (itemID)
            {
            if (gCXBatchShowData.showItem[i])
                {
               UIShow(gContextStripUIDlg, itemID);
                }
            else
                {
               UIHide(gContextStripUIDlg, itemID);
                }
            }
        }
     }
 gCXBatchShowData.batchShowStarted=false;
 gCXBatchShowData.numItems=0;
 }
 UpdateWindow(gContextStripUIDlg);
 }
 static void CXItemHide(TCmpID itemID)
 {
 assert(itemID);
 if (gCXBatchShowData.batchShowStarted)
 {
 CVBoolean done=false;
 long i;
 for (i=0;i<gCXBatchShowData.numItems;i++)
     {
    if (gCXBatchShowData.itemList[i]==itemID)
        {
        gCXBatchShowData.showItem[i]=false;
        done=true;
        break;
        }
     }
 if (!done)
     {
    gCXBatchShowData.itemList[gCXBatchShowData.numItems]=itemID;
    gCXBatchShowData. showItem[gCXBatchShowData.numItems] =false;
    gCXBatchShowData.numItems++;
    assert(gCXBatchShowData.numItems<kMaxContextStripItems* 2);
     }
 }
 else
 {
 UIHide(gContextStripUIDlg, itemID);
 }
 }
 static void CXItemShow(TCmpID itemID)
 {
 if (gCXBatchShowData.batchShowStarted)
 {
 CVBoolean done=false;
 long i;
 for (i=0;i<gCXBatchShowData.numItems;i++)
     {
    if (gCXBatchShowData.itemList[i]==itemID)
        {
        gCXBatchShowData.showItem[i]=true;
        done=true;
        break;
        }
     }
 if (!done)
     {
    gCXBatchShowData. itemList[gCXBatchShowData.numlItems] =it emID;
    gCXBatchShowData.showItem[gCXBatchShowData.numItems]=true;
    gCXBatchShowData.numItems++;
    assert(gCXBatchShowData.numItems<kMaxContextStripItems*2);
     }
 }
 else
 {
 UIShow(gContextStripUIDlg, itemID);
 }
 }
 static void CXItemMove(TCmpID itemID, long x, long y)
 {
 Rect r;
 assert(itemID);
 CXGetItemRect(gContextStripUIDlg, itemID, &r);
 if (r.left!=x | | r.top!=y)
     {
    HWND itemWnd = UIFindItem(gContextStripUIDlg, itemID);
     if (gCXBatchShowData.winMoveData && IsWindowVisible(itemWnd))
        {
        RECT winRect;
        GetWindowRect(itemWnd, &winRect);
        gCXBatchShowData.winMoveData=DeferWindowPos(gCXBatchShowData.winMov
        eData,
                                                itemWnd,
                                                0,
                                                x, y,
                                                winRect.right-
                                                winRect.left,
                                                winRect.bottom-
                                                winRect.top,
                                                SWP_NOZORDER |
                                                SWP_NOREPOSITION | SWP_NOACTIVATE
                                                ) ;
        }
    else
        {
        UIHide(gContextStripUIDlg, itemID);
        UIMove(gContextStripUIDlg, itemID, x, y);
        }
     }
     }
     static void CXItemSetBounds(TCmpID itemID, Rect *r)
     {
     UIHide(gContextStripUIDlg, itemID);
     UISetBounds(gContextStripUIDlg, itemID, r);
     CXItemShow(itemID);
     }
     static inline UIContextStripDlgData *CXGetDlgData(UIDlg theDlg)
     {
     return (UIContextStripDlgData *)UIGetDlgData(theDlg);
     }
     static short CXGetNextItemID(UIDlg theDlg)
     {
     short itemID;
     itemID=(CXGetDlgData(theDlg)->nextID+1) %30000;
     if (itemID<kFirstContextItemID)
 itemID=kFirstContextItemID;
 CXGetDlgData(theDlg)->nextID=itemID;
 return itemID;
 }
 static void CXInitContextStripItem(UIContextStripItem *item)
 {
 item->cxitem=0;
 item->itemID=0;
 item->cmpHandler=0;
 item->cxGroupItem=0;
 item->cxPage=l;
 item->behavior=0;
 item->actionLabel[0]=0;
 item->adjusted=false;
 item->canBreakAfter=0;
 item->forcePageBreakAfter=false;
 item->itemMovedToPage=0;
 }
 static void CalcLabelSize(const UIContextItemExt *item, long *width,
 long *height)
 {
 if (item->advLabelInfo.useIcon)
 {
 *width = item->advLabelInfo.iconVisWidth;
 *height = item->advLabelInfo.iconVisHeight;
 }
 else
 {
 CalcStringSize(item->label, width, height);
 }
 }
 static long CXCalcYPosBasedOnAlginment(CXAlignment itemAlignment, Rect
 *dlgBounds, long itemHeight, CVBoolean isLabel)
 {
 long ypos=0;
 Rect r;
 r = *dlgBounds;
 r.top+=2;
 r.bottom-=2;
 switch(itemAlignment&kCXInternalVerticalAlignmentMask)
 {
 case kCXAlignItemTop:
 case kCXAlignItemTopLabelRight:
    r.bottom = ((dlgBounds->bottom+dlgBounds->top+1) / 2);
    break;
 case kCXAlignItemBottom:
 case kCXAlignItemBottomLabelRight:
    r.top = ((dlgBounds->bottom+dlgBounds->top+1) / 2);
   break;
   case kCXAlignLabelTopItemBottom:
    if (!isLabel)
       r.top = ((dlgBounds->bottom+dlgBounds->top+1) / 2);
    else
       r.bottom = ((dlgBounds->bottom+dlgBounds->top+1) / 2);
   break;
   case kCXAlignItemCenter:
   case kCXAlignItemCenterLabelRight:
   default:
   break;
 }
 ypos = (r.top+(((r.bottom-r.top+1) - itemHeight+1) / 2)) -
 dlgBounds->top;
 return ypos;
 }
 static long CXAddLabelToContextStrip(UIDlg theDlg, const
 UlContextItemExt *item, long xpos, long labelWidth)
 {
 CVErr err=0;
 TCmpID itemID=0;
 CXCreateMsg msg;
 CVBoolean handled;
 long width=0, height;
 Rect dlgBounds, itemRect;
 long ypos;
 UIContextItemCache *cacheltem;
 CXGetContextDlgBounds(&dlgBounds);
 if ((CXGetDlgData(theDlg)->numIterns+1)<kMaxContextStripItems)
 {
 UIDlg itemWnd;
 if (item->label[0] | | item->advLabelInfo.useIcon)
    {
   itemID=CXGetNextItemID(theDlg) ;
   CalcLabelSize(item, &width, &height);
   if (labelWidth)
       width=labelWidth;
   ypos = CXCalcYPosBasedOnAlginment(item->itemAlignment,
   &dlgBounds, height, true);
   cacheItem = CXGetUIContextCacheItem(item->uiCacheItem);
   if (!cacheItem->labelID | | cacheItem-
   >dlgCountID!=CXGetDlgData(theDlg)->dlgCountID)
       {
       itemRect.left=xpos;
       itemRect.right=xpos+width;
       itemRect.top=ypos;
       itemRect.bottom=ypos+height;
       if (item->advLabelInfo.useIcon)
           {
           UIStaticIconInIo iconlnfo;
           iconInfo.toolID=item->advLabelInfo.resTool;
           iconInfo.resInstance=item->advLabelInfo.resInstance;
           iconInfo.iconID = item->advLabelInfo.iconID;
           iconInfo.iconSize= item->advLabelInfo.iconSize;
           itemWnd=UICreateStaticIconItem(theDlg, &itemRect,
           itemID, &iconInfo);
           }
       else
           {
           itemWnd=UICreateStaticTextItem(theDlg, &itemRect,
           itemID, (char *)item->label);
           }
       if (!itemWnd)
           {
           assert(itemWnd);
           err=-1;
           }
        }
    else
        {
       itemID=cacheItem->labelID;
        }
    if (!err)
        {
       Rect itemBounds;
       CXGetItemRect(theDlg, itemID, &itemBounds);
       if (itemBounds.top!=ypos | | itemBounds.left!=xpos)
           CXItemMove(itemID, xpos, ypos);
       itemRect.left=xpos;
       itemRect.top=ypos;
       itemRect.right=xpos+(itemBounds.right-itemBounds.left);
       itemRect.bottom=ypos+(itemBounds.bottom-itemBounds.top);
        )
    if (!err)
        {
       long curItem=CXGatDlgData(thcDlg)->numItoms;
       CXInitContextStripItem(&CXGetDlgData(theDlg)-
       >items[curItem]) ;
       CXGetDlgData(theDlg)->items[curItem].itemID = itemID;
       CXGetDlgData(theDlg)->items[curItem].cxitem = -item-
       >cxitem;
       CXGetDlgData(theDlg)-
       >items[curItem] .origItemRect=itemRect;
       CXGetDlgData(theDlg)->numItems++;
        }
    CXGetUIContextCacheItem(item->uiCacheItem)->labelID=itemID;
    }
 }
 return width;
 }
 static long CXAddUnitLabelToContextStrip(UIDlg theDlg, const
 UIContextItemExt *item, long xpos)
 {
 CVErr err=0;
 TCmpID itemID=0;
 CXCreateMsg msg;
 CVBoolean handled;
 long width=O, height;
 Rect dlgBounds, itemRect;
 long ypos;
 UIContextItemCache *cachaItem;
 char label[10];
 CXGetContextDlgBounds(&dlgBounds);
 if ((CXGetDlgData(thaDlg)->numItems+1)<kMaxContextStripItems)
 {
 UIDlg itemWnd;
 if (item->advLabelInfo.displayUnits)
     {
     if (item->advLabelInfo.unitStr[0])
        {
        strcpy(label, item->advLabelInfo.unitStr);
        }
     else
        {
        Unit curUnit = sCVRuler->GetCurrentUnit();
        strncpy(label, sCVRuler->GetUnitAbbreviation(curUnit), 9);
        }
     itemID=CXGetNextItemID(theDlg);
     CalcStringSize(label, &width, &height);
     ypos = CXCalcYPosBasedOnAlginment (item->itemAlignment,
     &dlgBounds, height, false)-1;
     cacheItem = CXGetUIContextCacheItem(item->uiCacheItem);
     if (cacheItem->unitLabelID && cacheItem-
     >dlgCountID==CXGetDlgData(theDlg)->dlgCountID)
         {
        Rect itemBounds;
        itemID=cacheItem->unitLabelID;
        CXGetItemRect(theDlg, itemID, &itemBounds);
        if (itemBounds.top!=ypos | | itemBounds.left!=xpos)
            CXItemMove(itemID, xpos, ypos);
        itemRect.left=xpos;
        itemRect.top=ypos;
        itemRect.right=xpos+(itemBounds.right-itemBounds.left);
        itemRect.bottom=ypos+(itemBounds.bottom-itemBounds.top);
         }
     else
         {
        itemRect.left=xpos;
        itemRect.right=xpos+width;
        itemRect.top=ypos;
        itemRect.bottom=ypos+height;
        itemWnd=UICreateStaticTextItem(theDlg, &itemRect, itemID,
        label);
        if (!itemWnd)
            {
            err=-1;
            }
         }
     if (!err)
         {
        long curItem=CXGetDlgData(theDlg)->numItems;
        CXInitContextStripItem(&CXGetDlgData(theDlg)-
        >items[curItem]) ;
        CXGetDlgData(theDlg)->items[curItem].itemID = itemID;
      CXGetDlgData(theDlg)->items[curItem].cxitem = -item-
      >cxitem;
      CXGetDlgData(theDlg)-
      >items[curItem].origItemRect=itemRect;
      CXGetDlgData(theDlg)->numItems++;
      }
   }
   }
   CXGetUIContextCacheItem(item->uiCacheItem)->unitLabelID=itemID;
   return width;
   }
   static long CXAddItemToContextStrip(UIDlg theDlg, const
   UIContextItemExt *item, long xpos, long labelWidth)
   {
   CVErr err=0;
   TCmpID itemID=0;
   CXCreateMsg msg;
   CVBoolean handled;
   long width=0, height;
   Rect dlgBounds, itemRect;
   long ypos;
   UIContextItemCache *cacheItem;
   CVBoolean minTotalWidth=0;
   CXGetContextDlgBounds(&dlgBounds) ;
   if ((CXGetDlgData(theDlg)->numItems+1)<kMaxContextStripItems)
   {
   UIDlg itemWnd;
   if (!(item->itemAlignment&kCXInternalAlignLabelRightMask))
   {
  width=CXAddLabelToContextStrip(theDlg, item, xpos,
  labelWidth);
   if (!(item->itemAlignment&kCXAlignLabelTopItemBottom) &&
   width)
      {
      if (item->advLabelInfo.labelOffsetFromItem)
          width+=item->advLabelInfo.labelOffsetFromItem;
      else
          width+=kSpacingAfterLabel;
      xpos+=width;
      }
   else
      {
      minTotalWidth=width;
      width=0;
      }
   }
   if (item->cmpHandler)
   {
   itemID=CXGetNextItemID(theDlg);
   cacheItem = CXGetUIContextCacheItem(item->uiCacheItem);
   if (cacheItem->itemID && cacheItem-
   >dlgCountID==CXGetDlgData(theDlg)->dlgCountID)
      {
       itemID=cacheItem->itemID;
       UIGetBounds(theDlg, itemID, &itemRect);
       width+=itemRect.right-itemRect.left;
       ypos = CXCalcYPosBasedOnAlginment(item->itemAlignment,
       &dlgBounds, (itemRect.bottom-itemRect.top), false);
       if ((itemRect.top-dlgBounds.top)!=ypos | | (itemRect.left-
       dlgBounds.left) !=xpos)
           CXItemMove(itemID, xpos, ypos);
       itemRect.right=xpos+(itemRect.right-itemRect.left);
       itemRect.bottom=ypos+(itemRect.bottom-itemRect.top);
       itemRect.left=xpos;
       itemRect.top=ypos;
       }
    else
       {
       msg.cxitem = item->cxitem;
       msg.theItemID = itemID;
       msg.parent = theDlg;
       handled=SendCmpMsg(item->cmpHandler, 0, CXCreateMsgID,
       &msg);
       if (handled)
           {
           UIGetBounds(theDlg, itemID, &itemRect);
           width+=itemRect.right-itemRect.left;
           ypos = CXCalcYPosBasedOnAlginment(item->itemAlignment,
           &dlgBounds, (itemRect.bottom-itemRect.top), false);
           CXItemMove(itemID, xpos, ypos);
           itemRect.right=xpos+(itemRect.right-itemRect.left);
           itemRect.bottom=ypos+(itemRect.bottom-itemRect.top);
           itemRect.left=xpos;
           itemRect.top=ypos;
           }
       else
           {
           itemID=0;
           }
       }
    if (!err && itemID)
        {
       long curItem=CXGetDlgData(theDlg)->numItems;
       UIContextStripItem *itemData= &CXGetDlgData(theDlg)-
       >items[curItem];
       CXInitContextStripItem(itemData);
       itemData->cxitem = item->cxitem;
       itemData->itemID = itemID;
       itemData->cmpHandler = item->cmpHandler;
       itemData->cxGroupItem = item->cxGroupItem;
       itemData->behavior = item->behavior;
       itemData->origItemRect=itemRect;
       if (item->label[0])
           {
           strcpy(itemData->actionLabel, item->label);
           }
       CXGetDlgData(theDlg)->numItems++;
       }
    else
        {
        assertString(0, "Context Item creation failed!");
        }
    xpos+=itemRect.right-itemRect.left;
    }
 else if (item->cxitem==kCXItemID_PageBreak)
    {
    long curItem=CXGetDlgData(theDlg)->numItems;
    if (curItem>0)
        {
        CXGetDlgData(theDlg)->items[curItem-1].forcePageBreakAfter
        = true;
        CXGetDlgData(theDlg)->items[curItem-1].canBreakAfter =
        true;
        CXGetDlgData(theDlg)->hasPageBreaks=true;
        }
    }
 if (item->itemAlignment&kCXInternalAlignLabelRightMask)
    {
    if (item->advLabelInfo.labelOffsetFromItem)
        xpos+=item->advLabelInfo.labelOffsetFromItem;
    else
        xpos+=kSpacingAfterLabel;
    width+=CXAddLabelToContextStrip(theDlg, item, xpos,
    labelWidth) ;
    }
 else if (item->advLabelInfo.displayUnits)
    {
    xpos+=1;
    width+=CXAddUnitLabelToContextStrip(theDlg, item, xpos);
    }
 }
 if (width<minTotalWidth)
 width=minTotalWidth;
 CXGetUIContextCacheItem(item->uiCacheItem)->itemID=itemID;
 CXGetUIContextCacheItem(item->uiCacheItem)-
 >dlgCountID=CXGetDlgData(theDlg)->dlgCountID;
 return width;
 }
 static void CXShowPageView(short cxPage, CVBoolean hideCurrentItems,
 CVBoolean forceRecalc=false)
 {
 long n, i;
 Rect cxStripRect, itemRect;
 CXGetContextDlgBounds(&cxStripRect) ;
 if ((cxStripRect.right-
 cxStripRect.left)>=CXGetDlgData(gContextStripUIDlg)->totalItemWidth &&
 !CXGetDlgData(gContextStripUIDlg)->hasPageBreaks)
 cxPage=0;
 CXGetDlgData(gContextStripUIDlg)->cxCurPage=cxPage;
 n = CXGetDlgData(gContextStripUIDlg)->numItems;
 if (hideCurrentItems)
 {
 for (i=0;i<n;i++)
   {
   CXItemHide(CXGetDlgData(gContextStripUIDlg)-
   >items[i].itemID);
   }
   }
   if (cxPage==0)
   {
   CXItemHide(kPageLeftItemID);
   CXItemHide(kPageRightItemID);
   for (i=0;i<n;i++)
   {
   if (CXGetDlgData(gContextStripUIDlg)-
   >items[i].itemMovedToPage)
       {
      itemRect=CXGetDlgData(gContextStripUIDlg)-
      >items[i].origItemRect;
      CXItemMove(CXGetDlgData(gContextStripUIDlg)-
      >items[i].itemID, itemRect.left, itemRect.top);
      CXGetDlgData(gContextStripUIDlg)-
      >items[i].itemMovedToPage=false;
       }
   CXItemShow(CXGetDlgData(gContextStripUIDlg)-
   >items[i].itemID);
   }
   }
   else
   {
   short leftMargin = (kLeftMargin+(kSpaceBetweenItems/2));
   short rightMargin = (kSpaceBetweenItems/2)+kPageButtonWidth;
   long cxWidth, cxCurPage, cxCurPageRight, startN, xval;
   short lastValidBreakX=0, lastValidBreakItem;
   startN=0;
   if (forceRecalc | | !CXGetDlgData(gContextStripUIDlg)-
   >cxPagesCalced)
   {
   cxWidth = cxStripRect.right-cxStripRect.left-leftMargin-
   rightMargin;
   cxCurPage=1;
   cxCurPageRight = cxWidth+leftMargin;
   startN=0;
   lastValidBreakItem=1;
   for (i=0;i<n;i++)
       {
      itemRect = CXGetDlgData(gContextStripUIDlg)-
      >items[i].origItemRect;
      xval=itemRect.right;
      if (xval>cxCurPageRight)
          {
          if (cxCurPage==1)
              {
             leftMargin+=kPageButtonWidth;
             cxWidth-=kPageButtonWidth;
              }
           cxCurPage++;
           cxCurPageRight=lastValidBreakX+cxWidth;
           i = lastValidBreakItem;
           lastValidBreakItem=i+1;
           if (cxCurPage==cxPage)
               {
              startN=i;
               }
           }
       CXGetDlgData(gContextStripUIDlg)-
       >items[i].cxPage=cxCurPage;
       if (CXGetDlgData(gContextStripUIDlg)-
       >items[i].canBreakAfter)
           {
           lastValidBreakX=xval;
           lastValidBreakItem=i+1;
           }
       if (CXGetDlgData(gContextStripUIDlg)-
       >items[i].forcePageBreakAfter)
           {
           lastValidBreakX=xva1;
           lastValidBreakItem=i+1;
           cxCurPageRight=0;
           }
       CXGetDlgData(gContextStripUIDlg)-
       >items[i].itemMovedToPage=false;
       }
    CXGetDlgData(gContextStripUIDlg)->cxTotalPage=cxCurPage;
    CXGetDlgData(gContextStripUIDlg)->cxPagesCalced=true;
    }
    else
    {
    for (i=0;i<n;i++)
       {
       if (CXGetDlgData(gContextStripUIDlg)-
       >items[i].cxPage==cxPage)
           {
           startN=i;
           break;
           }
       }
    }
    short dx;
    itemRect=CXGetDlgData(gContextStripUIDlg)-
    >items[startN].origItemRect;
    if (cxPage==1)
   dx = 0;
   else
   dx = itemRect.left-leftMargin-kPageButtonWidth;
   if (cxPage==1)
    {
    CXItemHide(kPageLeftItemID);
    }
    if (cxPage==CXGetDlgData(gContextStripUIDlg)->cxTotalPage)
    {
    CXItemHide(kPageRightItemID);
    }
 if (CXIsItemDivider(CXGetDlgData(gContextStripUIDlg)-
 >items[0].cxitem))
    startN++;
 if (CXIsItemDivider(CXGetDlgData(gContextStripUIDlg)->items[n-
 1].cxitem))
    n--;
 for (i=startN;i<n;i++)
    {
    if (CXGetDlgData(gContextStripUIDlg)-
    >items[i].cxPage==cxPage)
        {
       if(!CXGetDlgData(gContextStripUIDlg)-
       >items[i].itemMovedToPage)
           {
           itemRect=CXGetDlgData(gContextStripUIDlg)-
           >items[i].origItemRect;
           if (cxPage==1)
               {
               CXItemMove(CXGetDlgData(gContextStripUIDlg)-
               >items[i].itemID, itemRect.left, itemRect.top);
               }
           else
               {
               CXItemMove(CXGetDlgData(gContextStripUIDlg)-
               >items[i].itemID, itemRect.left-dx, itemRect.top);
               }
           CXGetDlgData(gContextStripUIDlg)-
           >items[i].itemMovedToPage=true;
           }
       CXItemShow(CXGetDlgData(gContextStripUIDlg)-
       >items[i].itemID);
        }
    else
        {
       break;
        }
    }
 if (cxPage>1)
    {
    Rect itemRect;
    CXGetContextDlgBounds(&itemRect);
    itemRect.right=kPageButtonWidth;
    CXItemSetBounds(kPageLeftItemID, &itemRect);
    CXItemShow(kPageLeftItemID);
    }
 if (cxPage<CXGetDlgData(gContextStripUIDlg)->cxTotalPage)
    {
    Rect itemRect;
    CXGetContextDlgBounds(&itemRect);
    itemRect.left=itemRect.right-kPageButtonWidth;
    CXItemSetBounds(kPageRightItemID, &itemRect);
    CXItemShow(kPageRightItemID);
    }
   }
   if (!gDynamicHelpWindowHeight)
   {
   Rect itemRect;
   CXGetContextDlgBounds(&itemRect);
   itemRect.right-=2;
   itemRect.left=itemRect.right-kDynamicHelpOpenButtonSize;
   itemRect.bottom-=4;
   itemRect.top=itemRect.bottom-kDynamicHelpOpenButtonSize;
   CXItemSetBounds(kDynamicHelpOpenID, &itemRect);
   CXItemShow(kDynamicHelpOpenID);
   }
   else
   {
   CXItemHide(kDynamicHelpOpenID);
   }
   }
   static long CXBuildContextStripForContextExt(ContextMode *context)
   {
   long i, n, xpos, txpos, bxpos;
   UIContextItemExt item, nextItem;
   CVBoolean done, isFirstItem=true, isLastItem=false,
   lastItemTop=false;
   xpos=kLeftMargin;
   txpos = bxpos = xpos;
   n = CXFindFirstUIContextItem(context);
   while(n)
   {
   item = *CXGetNthUIContextItem(n);
   n = CXFindNextUIContextItem(context, n);
   if (!n) isLastItem=true;
   if ((isFirstItem | | isLastItem) && CXIsItemDivider(item.cxitem))
       continue;
   done=false;
   isFirstItem=false;
   if (!lastItemTop && item.itemAlignment&kCXAlignItemTop && n &&
   ! (item.itemAlignment&kCXHorizontalBreak))
       {
      nextItem = *CXGetNthUIContextItem(n);
      if (nextItem.itemAlignment&kCXAlignItemBottom)
          {
          long width1, width2, labelWidth, labelHeight;
          CalcLabelSize(&item, &width1, &labelHeight);
          CalcLabelSize(&nextItem, &width2, &labelHeight);
          if (width1 && width2)
              labelWidth = max(width1, width2);
          else
              labelWidth=0;
          if((item.itemAlignment&kCXAlignLeftTight) &&
          (nextItem.itemAlignment&kCXAlignLeftTight))
              xpos +=
              (((item.itemAlignment&kCXAlignLeftVeryTight)==kCXAlignLeftVeryTight)
              &&
              ((nextItem.itemAlignment&kCXAlignLeftVeryTight)==kCXAlignLeftVeryTight
              )) ? 0:1;
         else
             xpos += (kSpaceBetweenItems/2);
         txpos=bxpos=xpos;
         width1=CXAddItemToContextStrip(gContextStripUIDlg, &item,
         xpos, labelWidth);
         width2=CXAddItemToContextStrip(gContextStripUIDlg,
         &nextItem, xpos, labelWidth);
         txpos += width1;
         bxpos += width2;
         xpos += max(width1, width2);
         txpos += (item.itemAlignment&kCXAlignRightTight) ?
         (((item.itemAlignment&kCXAlignRightVeryTight)==kCXAlignRightVeryTight)
         ?0:1): (kSpaceBetweenItems/2);
         bxpos += (nextItem.itemAlignment&kCXAlignRightTight) ?
         (((nextItem.itemAlignment&kCXAlignRightVeryTight)==kCXAlignRightVeryTi
         ght)?0:1): (kSpaceBetweenItems/2);
         xpos = max(txpos, bxpos);
         n = CXFindNextUIContextItem(context, n);
         if (nextltem.itemAlignment&kCXHorizontalBreak)
             txpos=bxpos=xpos;
         done=true;
          }
      }
  if (!done)
      {
      if (item.itemAlignment&kCXAlignItemTop)
          {
         txpos += (item.itemAlignment&kCXAlignLeftTight) ?
         (((item.itemAlignment&kCXAlignLeftVeryTight)==kCXAlignLeftVeryTight)?0
         :1): (kSpaceBetweenItems/2);
         txpos += CXAddItemToContextStrip(gContextStripUIDlg,
         &item, txpos, 0);
         txpos += (item.itemAlignment&kCXAlignRightTight) ?
         (((item.itemAlignment&kCXAlignRightVeryTight)==kCXAlignRightVeryTight)
         ?0:1): (kSpaceBetweenItems/2);
         xpos = max(txpos, bxpos);
         lastItemTop=true;
         }
      else if (item.itemAlignment&kCXAlignItemBottom)
          {
         bxpos += (item.itemAlignment&kCXAlignLeftTight) ?
         (((item.itemAlignment&kCXAlignLeftVeryTight)==kCXAlignLeftVeryTight)?0
         :1): (kSpaceBetweenItems/2);
         bxpos += CXAddItemToContextStrip(gContextStripUIDlg,
         &item, bxpos, 0);
         bxpos += (item.itemAlignment&kCXAlignRightTight) ?
         (((item.itemAlignment&kCXAlignRightVeryTight)==kCXAlignRightVeryTight)
         ?0:1): (kSpaceBetweenItems/2);
         xpos = max(txpos, bxpos);
         lastItemTop=false;
         }
      else
          {
       xpos += (item.itemAlignment&kCXAlignLeftTight) ?
       (((item.itemAlignment&kCXAlignLeftVeryTight)==kCXAlignLeftVeryTight)?0
       :1): (kSpaceBetweenItems/2) ;
       xpos += CXAddItemToContextStrip(gContextStripUIDlg, &item,
       xpos, 0);
       xpos += (item.itemAlignment&kCXAlignRightTight) ?
       (((item.itemAlignment&kCXAlignRightVeryTight)==kCXAlignRightVeryTight)
       ?0:1): (kSpaceBetweenItems/2);
       txpos=bxpos=xpos;
       lastItemTop=false;
       }
   if (item.itemAlignment&kCXHorizontalBreak &&
   ! (item.itemAlignment&kCXAlignItemTop))
       txpos=bxpos=xpos;
   }
   CXGetDlgData(gContextStripUIDlg)-
   >items[CXGetDlgData(gContextStripUIDlg)->numltems-
   1].canBreakAfter=true;
   }
   CXGetDlgData(gContextStripUIDlg)->totalItemWidth=xpos;
   CXAdjustContextStrip(0,0,context);
   CXShowPageView(CXGetDlgData(gContextStripUIDlg)->cxCurrage, false);
   return xpos;
   }
   static void CXInitContextStripPal(UIDlg hDlg)
   {
   gContextStripUIDlg=hDlg;
   CXGetDlgData(hDlg)->dlgCountID=gContextStripUIDlgCountID++;
   CXGetDlgData(hDlg)->numItems=0;
   CXGetDlgData(hDlg)->nextID=kFirstContextItemID;
   CXGetDlgData(hDlg)->cxCurPage=1;
   CXGetDlgData(hDlg)->cxTotalPage=1;
   CXGetDlgData(hDlg)->cxPagesCalced=false;
   CXGetDlgData(hDlg)->totalItemWidth=0;
   CXGetDlgData(hDlg)->lastCachePurgeTime=UIGetSecs();
   CXGetDlgData(hDlg)->hasPageBreaks=false;
   sCXStrip->CXContextChange();
   }
   static void CXDisposeContextStripPal(UIDlg hDlg)
   {
   gContextStripUIDlg=0;
   }
   Boolean UIContextStripPalProc(UIDlg theDlg, UIItemID theItemID,
   UIMsgID theMsgID, UIMsgData theMsgData)
   {
   Boolean handled = TRUE;
   switch(theMsgID)
   {
   case UIInitMsgID:
    {
   CXInitContextStripPal(theDlg);
   handled = TRUE;
   break;
     }
 case UIDisposeMsgID:
     {
     CXDisposeContextStripPal(theDlg);
     handled = TRUE;
     break;
     }
 case UITrackMsgID:
     {
     CVErr err=0;
     UIContextStripDlgData *dlgData;
     long i;
     dlgData=CXGetDlgData(theDlg);
     if (theItemID>=kFirstContextItemID)
         {
        handled = false;
         for (i=0;i<dlgData->numItems;i++)
            {
            if (dlgData->items[i].itemID==theItemID)
                {
                CXTrackMsg trackMsg;
                if (dlgData->items[i].cmpHandler)
                   {
                       trackMsg.cxitem = dlgData->items[i].cxitem;
                       trackMsg.theItemID = theItemID;
                       trackMsg.parent = theDlg;
                       handled=SendCmpMsg(dlgData-
                       >items[i].cmpHandler, 0, CXTrackMsgID, &trackMsg);
                   }
                break;
                }
            }
         }
     else
         {
        handled = false;
         }
     break;
     }
 case UICommandMsgID:
     {
     CVErr err=0;
     UIContextStripDlgData *dlgData;
     long i;
     LogUsageTrackerEvent("CXCommandMsgSent");
     dlgData=CXGetDlgData(theDlg);
     if (theItemID>=kFirstContextItemID)
         {
        err=sDSUndo->BeginContext();
        if (!err)
            {
            for (i=0;i<dlgData->numItems;i++)
                {
                if (dlgData->items[i].itemID==theItemID)
                    {
                   CXCommandMsg commandMsg;
                   if (dlgData->items[i].cmpHandler)
                       {
                       commandMsg.cxitem = dlgData->items[i].cxitem;
                       commandMsg.theItemID = theItemID;
                       commandMsg.parent = theDlg;
                       long nRec = sCVAction->CountRecordings();
                       handled=SendCmpMsg(dlgData-
                       >items[i].cmpHandler, 0, CXCommandMsgID, &commandMsg);
                       if (nRec == sCVAction->CountRecordings())
                           CXRecordContextStripOperation(&commandMsg,
                           dlgData->items[i].actionLabel, dlgData->items[i].cmpHandler);
                       }
                   break;
                    }
                }
            err=sDSUndo->EndContext(err);
            }
         }
     else
         {
         short curPage, numPages;
         curPage = CXGetDlgData(gContextStripUIDlg)->cxCurPage;
         numPages = CXGetDlgData(gContextStripUIDlg)->cxTotalPage;
         switch(theItemID)
            {
            case kPageLeftItemID:
                {
                if (curPage>1)
                    {
                   curPage--;
                   CXShowPageView(curPage, true);
                    }
                handled=true;
                break;
                }
            case kPageRightItemID:
                {
                if (curPage<numPages)
                    {
                    curPage++;
                   CXShowPageView(curPage, true);
                    }
                break;
                }
            case kDynamicHelpTextID:
                {
                ContextMode curContext;
                char helpStrBuf[kMaxDynamicHelpStringLen];
                sCXStrip->CXGetCurrentContext(&curContext);
                break;
                }
            case kDynamicHelpCloseID:
                {
                UIHide(gContextStripUIDlg, kDynamicHelpTextID);
             UIHide(gContextStripUIDlg, kDynamicHelpCloseID);
             CXWriteDynamicHelpChanges();
             CXShowContextStripWindow(-1, 0);
             break;
             }
         case kDynamicHelpOpenID:
             {
             CXShowContextStripWindow(-1, 1);
             break;
             }
          }
      }
  break;
  }
  case UIKeyDownMsgID:
  {
  UIKeyDownMsg *msgData = (UIKeyDownMsg *)theMsgData;
  if ((msgData->key.ui == kUIReturnKey) | | (msgData->key.ui ==
  kUIEnterKey))
      {
      UISetFocus(theDlg, theItemID);
      msgData->handled=true;
      handled=true;
      }
  else
      handled=false;
  break;
  }
  case UIGetBalloonInfoMsgID:
  {
  UIGetBalloonInfoMsg * pBalloonInfoData =
  (UIGetBalloonInfoMsg *) theMsgData;
  UIBalloonInfo *pBalloonInfo = &(pBalloonInfoData-
  >balloonInfo);
  CXGetHelpStringMsg helpStringMsg;
  UIContextStripDlgData *dlgData;
  long i;
  CXItemID cxitem=0;
  dlgData=CXGetDlgData(theDlg);
  handled=false;
  if (theItemID>=kFirstContextItemID)
      {
      for (i=0;i<dlgData->numItems;i++)
          {
         if (dlgData->items[i].itemID==theItemID)
             {
             cxitem=dlgData->items[i].cxitem;
             break;
             }
          }
      if (cxitem && dlgData->items[i].cmpHandler)
          {
         helpStringMsg.parent= theDlg;
         helpStringMsg.theItemID= theItemID;
          helpStringMsg.cxitem = cxitem;
          helpStringMsg.helpstr[0]=0;
          handled=SendCmpMsg(dlgData->items[i].cmpHandler, 0,
          CXGetHelpStringMsgID, &helpStringMsg);
           }
       }
   else
       {
       }
   if (handled)
       {
       long len = strlen(helpStringMsg.helpStr)+1;
       pBalloonInfo->hBalloonText = NewHandClear(len);
       if (pBalloonInfo->hBalloonText)
           {
          strcpy(DerefHand(pBalloonInfo->hBalloonText),
          helpStringMsg.helpStr);
          pBalloonInfo->sLength = len;
          pBalloonInfo->handled=true;
           }
       }
   break;
   }
   case UIAdjustPopupMenuItemMsgID:
   {
   handled = TRUE;
   UIContextStripDlgData *dlgData = CXGetDlgData(theDlg);
   long i = 0;
   CXItemID cxitem = 0;
   if(theItemID >= kFirstContextItemID)
       {
       for(i = 0; i < dlgData->numItems; i++)
           {
          if(dlgData->items[i].itemID == theItemID)
              {
              cxitem = dlgData->items[i].cxitem;
              break;
              }
           }
       }
   if(cxitem)
       {
       assert(theMsgData);
       CXAdjustPopupMenuItemMsg adjustMenuData;
       adjustMenuData.cxitem = cxitem;
       adjustMenuData.parent = theDlg;
       adjustMenuData.theItemID = theItemID;
       adjustMenuData.menuref =
       ((UIAdjustPopupMenuItemMsg*)theMsgData)->theMenu;
       adjustMenuData.adjusted = false;
       if (SendCmpMsg(dlgData->items[i].cmpHandler, 0,
       CXAdjustPopupMenuItemMsgID, &adjustMenuData))
           {
          handled = adjustMenuData.adjusted;
           }
      }
  break;
  }
  default:
  {
  handled = FALSE;
  break;
  }
  }
  return handled;
  }
  void CXCreateContextString(ContextMode *context, char *buff, long
  maxLen)
  {
  char tag[64];
  buff[0]=0;
  switch(context->GetContextType())
  {
  case ContextType_DrawTool:
  {
  strncat(buff, "DrawTool: ", maxLen);
  TBOXMapDrawToolIDToTag(context->GetContextDrawTool(), tag);
  strncat(buff, tag, maxLen);
  break;
  }
  case ContextType_EditSession:
  {
  strncat(buff, "EditSession: ", maxLen);
  CVMapEditSessionIDToTag(context->GetContextEditSession(),
  tag);
  strncat(buff, tag, maxLen);
  strncat(buff, " DrawTool: ", maxLen);
  TBOXMapDrawToolIDToTag(context->GetContextDrawTool(), tag);
  strncat(buff, tag, maxLen);
  break;
  }
  case ContextType_ObjectType:
  {
  strncat(buff, "ObjectType: ", maxLen);
  CVMapObjectTypeToTag(context->GetContextObjectType(),
  context->GetContextExtObjectType(), tag);
  strncat(buff, tag, maxLen);
  break;
  }
  case ContextType_Default_NoSelection:
  {
  strncat(buff, "Default No Selection", maxLen);
  break;
  }
  case ContextType_Default_MultipleSelection:
   {
  strncat(buff, "Default Multiple Selection", maxLen);
  break;
  }
 default:
    {
    strncat(buff, "ERROR: INVALID CONTEXT", maxLen);
    break;
    }
 }
 }
 void PurgeCachedItems()
 {
 long i, n, expireSecs;
 UIContextItemCache *cacheItem;
 if (gContextStripUIDlg)
 {
 long secsBetweenPurge = GetSecondsBetweenItemPurge();
 if ((CXGetDlgData(gContextStripUIDlg)-
 >lastCachePurgeTime+secsBetweenPurge)<UIGetSecs())
    {
    CXGetDlgData(gContextStripUIDlg)-
    >lastCachePurgeTime=UIGetSecs();
    expireSecs = UIGetSecs()-secsBetweenPurge;
    n = CXCountUICacheItems();
    for (i=1;i<=n;i++)
        {
       cacheltem = CXGetUIContextCacheItem(i, false);
       if (cacheItem->lastAccessTime<expireSecs)
           {
           if (cacheItem->itemID)
              UIDisposeItem(gContextStripUIDlg, cacheItem-
              >itemID) ;
           if (cacheItem->labelID)
              UIDisposeItem(gContextStripUIDlg, cacheItem-
              >labelID) ;
           if (cacheItem->unitLabelID)
              UIDisposeltem(gContextStripUIDlg, cacheItem-
              >unitLabelID) ;
           cacheItem->itemID=0;
           cacheItem->labelID=0;
           cacheItem->unitLabelID=0;
           }
        }
    }
 }
 }
 void CXDeactivateContextStrip()
 {
 long i, n;
 if (gContextStripUIDlg)
 {
 n = CXGetDlgData(gContextStripUIDlg)->numItems;
 for (i=0;i<n;i++)
    {
    CXItemHide(CXGetDlgData(gContextStripUIDlg)-
    >items[i].itemID);
    }
    CXGetDlgData(gContextStripUIDlg)->numItems=0;
    CXGetDlgData(gContextStripUIDlg)->cxCurPage=1;
    CXGetDlgData(gContextStripUIDlg)->cxTotalPage=1;
    CXGetDlgData(gContextStripUIDlg)->cxPagesCalced=false;
    CXGetDlgData(gContextStripUIDlg)->totalItemWidth=0;
    }
    }
    void CXActivateContextStrip(ContextMode *context)
    {
    UIDlg contextStripDlg=gContextStripUIDlg;
    if (contextStripDlg)
    {
    CXBuildContextStripForContextExt(context);
    }
    }
    void CXNotifyPrePostAdjust (TCmpRef oldHandler, TCmpRef newHandler,
    UIDlg parent)
    {
    assertString(parent, "No context strip window?!");
    CXNotifyMsg msg;
    msg.parent = parent;
    if(oldHandler > 0)
    {
    msg.notice = kCXNotice_PostAdjust;
    SendCmpMsg(oldHandler, 0, CXNotifyMsgID, &msg);
    }
    if(newHandler > 0)
    {
    msg.notice = kCXNotice_PreAdjust;
    SendCmpMsg(newHandler, 0, CXNotifyMsgID, &msg);
    }
    return;
    }
    void CXAdjustContextStrip(CXBehaviorFlags adjustBehavior, void
    *behaviorData, ContextMode *curContext)
    {
    long i, j, numItems;
    UIContextStripDlgData *dlgData;
    short cvSelectionLocked=-1;
    short cvLayerLocked=-1;
    TCmpRef curHandler = 0;
    if (gContextStripUIDlg)
    {
    dlgData = CXGetDlgData(gContextStripUIDlg) ;
    numltems=dlgData->numItems;
    for (i=0;i<numItems;i++)
  dlgData->items[i].adjusted=false;
  for (i=0;i<numItems;i++)
  {
  dlgData = CXGetDlgData(gContextStripUIDlg) ;
  if (dlgData->items[i].cmpHandler && dlgData-
  >items[i].cxGroupItem && !dlgData->items[i].adjusted &&
      (!adjustBehavior||dlgData-
      >items[i].behavior&adjustBehavior))
      {
      CXItemID theGroupID=dlgData->items[i].cxGroupItem;
      long numChild=0;
      short childList[kMaxContextStripItems];
      CXItemID cxItemList[kMaxContextStripItems];
      TCmpID itemIDList[kMaxContextStripItems];
      for (j=0;j<numItems;j++)
          {
          if (dlgData->items[j].cxGroupItem==theGroupID)
             {
             childList[numChild]=j;
             cxItemList[numChild]=dlgData->items[j].cxitem;
             itemIDList[numChild]=dlgData->items[j].itemID;
             numChild++;
             assert(dlgData->items[j].cmpHandler==dlgData-
             >items[i].cmpHandler);
             }
          }
      if(curHandler != dlgData->items[i].cmpHandler)
          {
          CXNotifyPrePostAdjust(curHandler, dlgData-
          >items[i].cmpHandler, gContextStripUIDlg);
          curHandler = dlgData->items[i].cmpHandler;
          }
      CXAdjustGroupMsg msg;
      msg.cxGroupItem = theGroupID;
      msg.parent = gContextStripUIDlg;
      msg.numItems = numChild;
      msg.cxItemList=cxItemList;
      msg.itemIDList=itemIDList;
      msg.adjustBehavior=adjustBehavior;
      msg.behaviorData=behaviorData;
      if (SendCmpMsg(dlgData->items[i].cmpHandler, 0,
      CXAdjustGroupMsgID, &msg))
          {
          dlgData = CXGetDlgData(gContextStripUIDlg);
          for (j=0;j<numChild;j++)
              {
             dlgData->items[childList[j]].adjusted=true;
              }
          }
      }
   }
   for (i=0;i<numItems;i++)
   {
  dlgData = CXGetDlgData(gContextStripUIDlg);
  if (!adjustBehavior||dlgData-
  >items[i].behavior&adjustBehavior)
      {
      if (dlgData->items[i].cmpHandler && !dlgData-
      >items[i].adjusted)
          {
          if(curHandler != dlgData->items[i].cmpHandler)
               {
               CXNotifyPrePostAdjust(curHandler, dlgData-
               >items[i].cmpHandler, gContextStripUIDlg);
               curHandler = dlgData->items[i].cmpHandler;
               }
           CXAdjustMsg msg;
           msg.cxitem = dlgData->items[i].cxitem;
           msg.theItemID = dlgData->items[i].itemID;
           msg.parent = gContextStripUIDlg;
           msg.adjustBehavior=adjustBehavior;
           msg.behaviorData=behaviorData;
            SendCmpMsg(dlgData->items[i].cmpHandler, 0,
            CXAdjustMsgID, &msg);
            }
        if (dlgData->items[i].behavior &
        kCXBehavior_AutoDisableOnLockedLayer)
            {
           CVLayerRef curLayer;
            sCVPage->GetCurrentLayer(&curLayer);
            if (cvLayerLocked==-1)
               cvLayerLocked=!sCVPage->IsLayerModifiable(curLayer) ;
           if(!cvLayerLocked)
               UIEnable(gContextStripUIDlg, dlgData-
               >items[i].itemID);
           else
               UIDisable(gContextStripUIDlg, dlgData-
               >items[i].itemID);
            }
        if (dlgData->items[i].behavior &
        kCXBehavior_AutoDisableOnLockedSelection)
            {
           if(!(dlgData->items[i].behavior &
           kCXBehaviorAutoDisableOnLockedLayer && cvLayerLocked))
               {
               if (cvSelectionLocked==-1)
                   cvSelectionLocked=CVIsLockedObjInSelected(false,
                   false);
               if (cvSelectionLocked)
                   UIDisable(gContextStripUIDlg, dlgData-
                   >items[i].itemID);
               else
                   UIEnable(gContextStripUIDlg, dlgData-
                   >items[i].itemID);
               }
            }
    }
    CXNotifyPrePostAdjust(curHandler, 0, gContextStripUIDlg);
    curHandler = 0;
 if (gDynamicHelpWindowHeight)
     {
    const char *helpStr=0;
    ContextMode theContext;
    if(!curContext)
        {
      CXGetCurrentContextExt(&theContext, true);
      curContext = &theContext;
      }
  helpStr=CXGetDynamicHelpString(curContext);
  if (helpStr)
         UISetTextRTF(gContextStripUIDlg, kDynamicHelpTextID,
         (char *)helpStr);
  else
      {
      }
  }
  }
  }
  STATIC_CVAPI TCmpID CXFindContextItem(UIDlg parent, CXItemID cxitem)
  {
  TCmpID itemID=0;
  long i, numItems;
  UIContextStripDlgData *dlgData;
  dlgData = CXGetDlgData(parent);
  numItems=dlgData->numItems;
  for (i=0;i<numItems;i++)
  {
  if (dlgData->items[i].cxitem==cxitem)
   {
  itemID = dlgData->items[i].itemID;
  break;
   }
   }
   return itemID;
   }
   STATIC_CVAPI void CXAdjustContextItem(UIDlg parent, CXItemID cxitem)
   {
   TCmpID itemID=0;
   long i, numItems;
   UIContextStripDlgData *dlgData;
   dlgData = CXGetDlgData(parent);
   numItems=dlgData->numItems;
   for (i=0;i<numItems;i++)
   {
   if (dlgData->items[i].cxitem==cxitem)
   {
  CXAdjustMsg msg;
  itemID = dlgData->items[i].itemID;
  msg.cxitem = dlgData->items[i].cxitem;
  msg.theItemID = dlgData->items[i].itemID;
  msg.parent = gContextStripUIDlg;
  msg.behaviorData = 0;
  msg.adjustBehavior = 0;
  SendCmpMsg(dlgData->items[i].cmpHandler, 0, CXAdjustMsgID,
  &msg) ;
  break;
   }
   if (dlgData->items[i].cxGroupItem==cxitem)
   {
   CXItemID cxItemList[kMaxContextStripItems];
   TCmpID itemIDList[kMaxContextStripItems];
   long numChild=0, j;
   for (j=0;j<numItems;j++)
       {
       if (dlgData->items[j].cxGroupItem==cxitem)
          {
          cxItemList[numChild]=dlgData->items[j].cxitem;
          itemIDList[numChild]=dlgData->items[j].itemID;
          numChild++;
          }
       }
   CXAdjustGroupMsg msg;
   msg.cxGroupItem = cxitem;
   msg.parent = gContextStripUIDlg;
   msg.numItems = numChild;
   msg.cxItemList=cxItemList;
   msg.itemIDList=itemIDList;
   msg.behaviorData = 0;
   msg.adjustBehavior = 0;
   SendCmpMsg(dlgData->items[i].cmpHandler, 0,
   CXAdjustGroupMsgID, &msg);
   break;
   }
   }
   }
   STATIC_CVAPI void CXItemEnable(CXItemID cxitem)
   {
   long i, numItems;
   CXItemID testItem;
   numItems=CXGetDlgData(gContextStripUIDlg)->numItems;
   for (i=0;i<numItems;i++)
   {
   testltem = CXGetDlgData(gContextStripUIDlg)->items[i].cxitem;
   if (testItem==cxitem || testItem==-cxitem)
   {
   UIEnable(gContextStripUIDlg,
   CXGetDlgData(gContextStripUIDlg)->items[i].itemID);
   }
   }
   }
   STATIC_CVAPI void CXItemDisable(CXItemID cxitem)
   long i, numItems;
   CXItemID testItem;
   numItems=CXGetDlgData(gContextStripUIDlg)->numItems;
   for (i=0;i<numItems;i++)
   {
   testltem = CXGetDlgData(gContextStripUIDlg)->items[i].cxitem;
   if (testItem==cxitem || testItem==-cxitem)
   {
   UIDisable(gContextStripUIDlg,
   CXGetDlgData (gContextStripUIDlg)->items[i].itemID);
   }
 }
 }
 STATIC_CVAPI void CXChangeContextItemLabel(CXItemID cxitem, const char
 *label)
 {
 long i, numItems;
 CXItemID testItem;
 numItems=CXGetDlgData(gContextStripUIDlg)->numItems;
 for (i=0;i<numItems;i++)
 {
 testItem = CXGetDlgData(gContextStripUIDlg)->items[i].cxitem;
 if (testItem==-cxitem)
    {
    UIInval(gContextStripUIDlg, CXGetDlgData(gContextStripUIDlg)-
    >items[i].itemID);
    UISetText(gContextStripUIDlg,
    CXGetDlgData(gContextStripUIDIg)->items[i].itemID, (char *)label);
    break;
    }
 }
 }
 static void CXSetChildWindowSizes()
 {
 CXShowPageView(1, true, true);
 if (gDynamicHelpWindowHeight)
 {
 Rect dlgRect, itemRect;
 short totalHeight, cxPartHeight;
 CXGetContextDlgBounds(&dlgRect);
 CXGetContextStripWindowInfo(&totalHeight, 0, &cxPartHeight);
 itemRect.left=5;
 itemRect.top = cxPartHeight+5;
 itemRect.right=dlgRect.right-20;
 itemRect.bottom = totalHeight-5;
 CXItemSetBounds(kDynamicHelpTextID, &itemRect);
 itemRect.left=dlgRect.right-15;
 itemRect.top = cxPartHeight+5;
 itemRect.right=itemRect.left+10;
 itemRect.bottom = itemRect.top+10;
 CXItemSetBounds(kDynamicHelpCloseID, &itemRect);
 }
 }
 LRESULT EXWINPROC ContextStipWindowProc(HWND hwnd, UINT msg, WPARAM
 wParam, LPARAM lParam)
 {
 BOOL result;
 TUIDialogData *data = NULL;
 Handle dataHand=0;
 dataHand = (Handle)CVGetWindowLong(hwnd, FL_EXTDATAHDL);
 if(!dataHand)
 {
 dataHand = NewHandClear(sizeof(TUIDialogData));
 data = (TUIDialogData *) DerefHand(dataHand);
 data->theProc = UIContextStripPalProc;
 data->userParams = NULL;
 data->extraData = NewHandClear(sizeof(UIContextStripDlgData));
 data->regCmpHand = NULL;
 CVSetWindowLong (hwnd,FL_EXTDATAHDL, (long)dataHand);
 }
 else
 {
 data = (TUIDialogData *) DerefHand(dataHand);
 }
 if (data)
 {
 switch(msg)
    {
    case WM_CREATE:
        result = DispatchUIMessages (hwnd, WM_INITDIALOG, 0, 0,
        data);
       break;
    case WM_SIZE:
        if (LOWORD(lParam)>50)
           {
           CXSetChildWindowSizes();
           }
       break;
    case WM_PAINT:
        {
        result = DispatchUIMessages (hwnd, msg, wParam, lParam,
        data);
        short height, pos, y=0, cxPartHeight;
        POINT p1, p2;
        RECT r;
       GetClientRect(hwnd, &r);
        CXGetContextStripWindowInfo(&height, &pos, &cxPartHeight);
       HDC hdc = GetDC(hwnd);
       if (pos!=3)
           {
           p1.x=0;
           p2.x=r.right-r.left;
           y=0;
           p1.y=y; p2.y=y;
           DrawShadowedLine(hdc, p1, p2);
           y=height-1;
           p1.y=y; p2.y=y;
           DrawShadowedLine(hdc, p1, p2);
           }
        if (cxPartHeight != height)
           {
           p1.x=0;
           p2.x=r.right-r.left;
           y=cxPartHeight-1;
           p1.y=y; p2.y=y;
           DrawShadowedLine(hdc, p1, p2);
           }
       ReleaseDC(hwnd, hdc);
       break;
        }
    case WM_NCDESTROY:
       {
       if (dataHand)
           {
           if (data->extraData)
              DisposeHand(data->extraData);
           if (data->regCmpHand)
              DisposeHand (data->regCmpHand);
           DisposeHand(dataHand);
           }
       CVSetWindowLong (hwnd,FL_EXTDATAHDL,0);
       break;
       }
    default:
       result = DispatchUIMessages (hwnd, msg, wParam, lParam,
       data);
       break;
    }
 }
 return result;
 }
 UIDlg CXShowContextStripWindow(short pos, short showDynamicHelp)
 {
 UIDlg theDlg=0;
 showDynamicHelp = 0;
 pos = 0;
 if (pos>=0)
 CVSetAppData_Integer('CXST', "CXStripPos", pos);
 else
 {
 long val=1;
 CVGetAppData_Integer('CXST', "CXStripPos", &val);
 pos=val;
 }
 if (showDynamicHelp==-1)
 {
 long val=1;
 CVGetAppData_Integer('CXST', "CXDynamicHelp", &val);
 showDynamicHelp=val;
 }
 if (showDynamicHelp)
 {
 CXEnableDynamicHelpEngine();
 gDynamicHelpWindowHeight=kDynamicHelpHeight;
 CVSetAppData_Integer('CXST', "CXDynamicHelp", 1);
 }
 else
 {
 CXDisableDynamicHelpEngine();
 gDynamicHelpWindowHeight=0;
 CVSetAppData_Integer('CXST', "CXDynamicHelp", 0);
 }
 HWND parent = GetApplWindow();
 if (gContextStripUIDlg)
    {
     HWND floatWnd = GetFloatWndFromChild(gContextStripUIDlg);
     if (floatWnd)
         {
        if (pos!=3)
            {
            UIDispose(floatWnd);
            assert(!gContextStripUIDlg);
            }
         }
     else
         {
         if (pos!=1 && pos!=2)
            {
            UIDispose(gContextStripUIDlg);
            assert(!gContextStripUIDlg);
            }
         }
     }
 switch (pos)
     {
     case 1:
     case 2:
         {
         long wsExCompFlag = (CVGetOS() >= CVOS_WINXP) ?
         WS_EX_COMPOSITED : 0;
         if (!gContextStripUIDlg)
             {
            theDlg = CreateWindowEx(wsExCompFlag,
            "ContextStripClass", NULL,
                   WS_CHILDWINDOW | WS_VISIBLE | WS_CLIPSIBLINGS,
            } 0, 0, 0, 0, parent, 0, Instance, NULL);
         else
             {
            theDlg=gContextStripUIDlg;
             }
         break;
         }
     case 3:
         {
         if (!gContextStripUIDlg)
             {
            CVWINFloatDialogInfo dialogData;
            dialogData.hInst = ResInstance;
            dialogData.resID = kContextStripDlgID;
            dialogData.theProc = UIContextStripPalProc;
            dialogData.userData = NULL;
            dialogData.size = sizeof(UIContextStripDlgData);
            strcpy(dialogData.windowname, "Context Strip");
            theDlg = CVWINCreateFloatDialog(&dialogData);
             }
         else
             {
            theDlg=gContextStripUIDlg;
             }
        if (theDlg)
            {
           short height, pos;
           CXGetContextStripWindowInfo(&height, &pos);
           MoveWindow(theDlg, 10,650, 1000,
           height+FW_SYSMENUSIZE+(CalcFWFrameHeight(0)*2), true);
            }
        break;
        }
    default:
        if (gContextStripUIDlg)
            {
           UIDispose(gContextStripUIDlg);
           gContextStripUIDlg=0;
           theDlg=0;
            }
        break;
    }
    if (theDlg)
 {
 Rect itemRect;
 UIButtonInfoData buttonInfo;
 itemRect.left=itemRect.right=itemRect.top=itemRect.bottom=0;
 buttonInfo.theTool=0;
 buttonInfo.upIconID = ICO_ContextStripHelp;
 buttonInfo.resInstance=0;
 buttonInfo.iconSize=s16x16;
 buttonInfo.isFlatButton=true;
 UICreatePushButton(gContextStripUIDlg, &itemRect,
 kDynamicHelpOpenID, "?", &buttonInfo);
 UICreatePushButton(gContextStripUIDlg, &itemRect,
 kPageLeftItemID, "<", 0);
 UICreatePushButton(gContextStripUIDlg, &itemRect,
 kPageRightItemID, ">", 0);
 if (gDynamicHelpWindowHeight)
    {
    if (!UIFindItem(gContextStripUIDlg, kDynamicHelpTextID))
        {
        CVBoolean readOnly = IsShiftKeyDown() ? false:true;
           UICreateRTFItem(gContextStripUIDlg, &itemRect,
           kDynamicHelpTextID, readOnly, 0);
           UICreatePushButton(gContextStripUIDlg, &itemRect,
           kDynamicHelpCloseID, "X", 0);
        }
    UIShow(gContextStripUIDlg, kDynamicHelpTextID);
    UIShow(gContextStripUIDlg, kDynamicHelpCloseID);
    }
    if (parent && (!theDlg && pos==0) || (theDlg && pos!=0))
        {
        RECT theRect;
        GetClientRect (parent, &theRect);
        SendMessage (parent, WM_SIZE, SIZE_RESTORED
        ,MAKELONG(theRect.right, theRect.bottom));
        }
 CXHandleContextChange(true);
 }
 else
 {
   if (parent && pos==0)
       {
       RECT theRect;
       GetClientRect (parent, &theRect);
       SendMessage (parent, WM_SIZE, SIZE_RESTORED
       ,MAKELONG(theRect.right, theRect.bottom));
       }
       }
       return theDlg;
       }
       void CXCloseContextStripWindow()
       {
       if (gContextStripUIDlg)
       {
       UIDispose(gContextStripUIDlg);
       gContextStripUIDlg=0;
       }
       }
       void CXSetDockedContextStripWindowPos(short x, short y, short width)
       {
       short height, pos;
       CXGetContextStripWindowInfo(&height, &pos);
       if (!gContextStripUIDlg)
 {
 CXShowContextStripWindow(pos);
 }
 if (gContextStripUIDlg)
    {
   UIDlg fWnd = gContextStripUIDlg;
   if (fWnd)
       {
       if (pos==3)
           {
           height += FW_SYSMENUSIZE+(CalcFWFrameHeight(0)*2);
           }
       MoveWindow(fWnd, x, y, width, height, true);
       }
    }
    }
    void CXGetContextStripWindowInfo(short *totalHeight, short *pos, short
    *cxPartHeight)
    {
    long p, h;
    p=1;
    h=50;
    CVGetAppData_Integer('CXST', "CXStripHeight", &h);
    CVGetAppData_Integer('CXST', "CXStripPos", &p);
    if (pos) *pos=p;
    if (cxPartHeight) *cxPartHeight = h;
    if (totalHeight) *totalHeight=h+gDynamicHelpWindowHeight;
    }
    static CVErr CXExecuteContextStripCommand(CXItemID cxitem)
    {
    CVErr err=0;
    UIContextStripDlgData *dlgData;
    long i;
    dlgData=CXGetDlgData(gContextStripUIDlg);
    err=sDSUndo->BeginContext();
    if (!err)
    {
    for (i=0;i<dlgData->numItems;i++)
   {
   if (dlgData->items[i].cxitem==cxitem)
       {
       CXCommandMsg commandMsg;
       if (dlgData->items[i].cmpHandler)
          {
          commandMsg.cxitem = dlgData->items[i].cxitem;
          commandMsg.theItemID = dlgData->items[i].itemID;
          commandMsg.parent = gContextStripUIDlg;
          SendCmpMsg(dlgData->items[i].cmpHandler, 0,
          CXCommandMsgID, & commandMsg);
          }
       break;
       }
   }
   err=sDSUndo->EndContext(err);
   }
   return err;
   }
   CVErr CXPlayContextStripOperation(CXActionData *actData)
   {
   CVErr err=0;
   ContextMode curContext;
   CXHandleContextChange(true);
   if (1)
   {
   TCmpID itemID;
   itemID = CXFindContextItem(gContextStripUIDlg, actData->cxItem);
   assert(itemID);
   if (itemID)
   {
   if (actData->valueText[0])
       UISetText(gContextStripUIDlg, itemID, actData->valueText);
   else
       UISetValue(gContextStripUIDlg, itemID, actData->value);
   err=CXExecuteContextStripCommand(actData->cxItem) ;
   }
   }
   else
   {
   assert(0);
   err=-1;
   }
   return err;
   }
   static const CVActionID kCXActionID = 100;
   class CXAction : public Action
   {
   public:
   CXAction();
   CXAction(const CXActionData& cxData);
   ∼CXAction() {}
   virtual CVErr WriteDescription(CVAction* pAction) const;
   virtual CVErr ReadDescription(CVAction action);
   virtual void SetDefault();
   virtual CVErr Perform();
   private:
   enum
   {
   kVersionIDKey = 1,
   kContextIDKey,
   kContextItemKey,
   kContextTextKey,
   kContextValueKey
   };
   CXActionData m_cxData;
   };
   CXAction::CXAction()
   : Action(kContextStripToolID, kCXActionID, FALSE, FALSE,
   rstring(kCXActionNameStrID))
   {
   SetDefault();
   }
   CXAction::CXAction(const CXActionData& cxData)
   : Action(kContextStripToolID, kCXActionID, FALSE, FALSE,
   rstring(kCXActionNameStrID)), m_cxData(cxData)
   {
   }
   CVErr CXAction::WriteDescription(CVAction* pAction) const
   {
   CVErr err = noErr;
   ActionWriter aw = sCVAction->BeginWriteAction();
   if (aw)
   {
   err = sCVAction->WriteLabeledInteger(aw, kVersionIDKey,
   kCVActionCurrentVersion, "", kNoUnit, "");
   if (!err)
   err = sCVAction->WriteLabeledFloat(aw, kContextIDKey,
   m_cxData.contextID, "", kNoUnit, "");
   if (!err)
   err = sCVAction->WriteLabeledInteger(aw, kContextItemKey,
   m_cxData.cxItem, "", kNoUnit, "");
   if (!err)
 {
   if (strlen(m_cxData.valueText) > 0)
   { err = sCVAction->WriteLabeledString(aw, kContextTextKey,
   m_cxData.valueText, m_cxData.actionLabel, kNoUnit, "");
      if (!err)
          err = sCVAction->WriteLabeledFPValue(aw,
          kContextValueKey, m_cxData.value, "", kNoUnit, "");
   }
   else
   {
      err = sCVAction->WriteLabeledFPValue(aw, kContextValueKey,
      m_cxData.value, m_cxData.actionLabel, kNoUnit, "");
   }
   }
   err = sCVAction->EndWriteAction(err, aw, pAction);
   }
   else
   {
   err = -1;
   assert(0);
   }
   return err;
   }
   CVErr CXAction::ReadDescription(CVAction actionData)
   {
   CVErr err = noErr;
   ActionReader ar = sCVAction->BeginReadAction(actionData, 0);
   if (ar)
   {
   CVErr err = noErr;
   DescriptorKeyID key;
   DescriptorTypeID type;
   long version = 0;
   if (sCVAction->ReadKey(ar, &key, &type) && sCVAction-
   >DecodeDescriptor(key) == kVersionIDKey)
   {
   assert(type == typeInteger);
   err = sCVAction->ReadLabeledInteger(ar, &version, 0, NULL);
   }
   else
   {
   assert(0) ;
   err = -1;
   }
   while (sCVAction->ReadKey(ar, &key, &type) && !err)
   {
   CVDesc desc = sCVAction->DecodeDescriptor(key);
   switch (desc)
   {
   case kContextIDKey:
      {
          assert(type == typeFloat);
          err = sCVAction->ReadLabeledFloat(ar,
          &m_cxData.contextID, 0, NULL) ;
          break;
      }
  case kContextItemKey:
      {
          assert(type == typeInteger);
          err = sCVAction->ReadLabeledInteger(ar,
          &m_cxData.cxItem, 0, NULL);
         break;
      }
  case kContextTextKey:
      {
          assert(type == typeString);
          err = sCVAction->ReadLabeledString(ar, 255,
          m_cxData.valueText, 0, NULL);
         break;
      }
  case kContextValueKey:
      {
          assert(type == typeFPValue);
          err = sCVAction->ReadLabeledFPValue(ar,
          &m_cxData.value, 0, NULL) ;
          break;
      }
  default:
      {
          assert(0);
          err = -1;
      }
   }
   }
   err = sCVAction->EndReadAction(err, ar);
   }
   return err;
   }
   void CXAction::SetDefault()
   {
   m_cxData.valueText[0] = 0;
   }
   CVErr CXAction::Perform()
   {
   CVErr err = noErr;
   err = CXPlayContextStripOperation(&m_cxData);
   return err;
   }
   void CXRecordContextStripOperation(CXCommandMsg *msgData, char
   *actionLabel, TCmpRef itemCmpHandler)
   {
   CVErr err = noErr;
   CXActionData actData;
   ContextMode curContext;
   if (sCVAction->IsRecording())
   {
   if (actionLabel[0])
   {
   strncpy(actData.actionLabel, actionLabel, 64);
    }
    else
    {
   CXGetHelpStringMsg helpStringMsg;
   helpstringMsg.parent= msgData->parent;
   helpStringMsg.theItemID= msgData->theItemID;
   helpStringMsg.cxitem = msgData->cxitem;
   helpStringMsg.helpStr[0]=0;
   if (SendCmpMsg(itemCmpHandler, 0, CXGetHelpStringMsgID,
   &helpStringMsg) && helpStringMsg.helpStr[0]!=0)
       strncpy(actData.actionLabel, helpStringMsg.helpStr, 64);
   else
       strncpy(actData.actionLabel, rstring(kDescValueKeyID),
       64);
    }
    actData.actionLabel[63] = 0;
    sCXStrip->CXGetCurrentContext(&curContext);
    actData.contextID = curContext.GetContextID();
    actData.cxItem = msgData->cxitem;
    UIGetText(msgData->parent, msgData->theItemID,
    actData.valueText, sizeof(actData.valueText));
    int sz = strlen(actData.actionLabel);
    if (sz > 0 && actData.actionLabel[sz-1] == ':')
   actData.actionLabel[sz-1] = 0;
   actData.value=UIGetValue(msgData->parent, msgData->theItemID);
   CXAction action(actData);
   action.Record(NULL);
 }
 }
 static CVErr PlayCXAction(CVAction* pAction, ActionDisplayState
 displayState)
 {
 CXAction action;
 return action.Play(pAction, displayState);
 }
 void DoPlayAction(PlayActionMsg* pMsg)
 {
 switch (pMsg->id)
 {
 case kCXActionID:
 {
   pMsg->err = PlayCXAction(pMsg->pAction,
   static_cast<ActionDisplayState>(pMsg->displayState));
   break;
   }
   default:
   {
   pMsg->err = -1;
   assert(0) ;
   }
   }
   }
```

## Claims

1. A method for managing a context-dependent display bar, comprising:
identifying a graphical object currently displayed by a graphics software application operated by a user through a graphical user interface to process an image, wherein the image is a vector image or a raster image or a combination vector and raster image;
identifying a current edit mode in which the user is working;
identifying whether or not the user has selected the identified graphical object for editing;
identifying a tool for editing graphical objects currently activated by the user;
determining a current context in which the user is working, the context depending upon the identified graphical object, the identified edit mode, whether or not the user has selected the identified graphical object for editing, and the identified tool;
identifying at least one control associated with the current context, wherein different contexts generally have at least one different control associated therewith;
displaying the image; and
displaying the at least one control associated with the current context within a display bar of the graphics software application, each time that the current context changes.

2. The method of claim 1 wherein a control has a corresponding handler, and wherein the handler modifies the displayed graphical object.

3. The method of claim 2 further comprising:
receiving notification of an event triggered by the user performing an input action on a selected one of the displayed controls; and
notifying the handler of the selected control.

4. The method of claim 1 wherein a context has a unique identifier, and wherein said identifying at least one control comprises accessing a look-up table keyed on identifiers for contexts.

5. A user interface for managing a context-dependent display bar, comprising:
a context processor comprising:
a state identifier for identifying (i) a graphical object being displayed by a graphics software application operated by a user to process an image, wherein the image is a vector image or a raster image or a combination vector and raster image, (ii) an edit mode within which the user is working, wherein the edit mode indicates whether or not the user has selected the identified graphical object for editing, (iii) a tool for editing graphical objects activated by the user, and (iv) at least one control associated with a current context in which a user is working; and
a context identifier for determining the current context, the current context depending upon the identified graphical object, the identified edit mode, whether or not the user has selected the identified graphical object for editing, and the identified tool, wherein different contexts generally have at least one different control associated therewith; and
a display manager operatively coupled with said context processor for displaying (i) the image, and (ii) a display bar including the at least one control associated with the current context, each time that the current context changes.

6. The user interface of claim 5 wherein a control has a corresponding handler, and wherein the handler modifies the displayed graphical object.

7. The user interface of claim 6 further comprising:
a message receiver for receiving notification of an event triggered by the user performing an input action on a selected one of the displayed controls; and
a message sender for notifying the handler of the selected control.

8. The user interface of claim 5 wherein a context has a unique identifier, and wherein said state identifier accesses a look-up table keyed on identifiers for contexts.

9. A computer readable storage medium storing program code for causing a computer to perform the method of any of claims 1 to 4.

## Patentansprüche

1. Verfahren zum Verwalten eines kontextabhängigen Anzeigebalkens, umfassend:
Identifizieren eines grafischen Objekts, das gegenwärtig durch eine Grafik-Software-Anwendung angezeigt wird, die von einem Benutzer über eine grafische Benutzerschnittstelle zur Verarbeitung eines Bildes betrieben wird, wobei das Bild ein Vektorbild oder ein Rasterbild oder eine Kombination aus einem Vektor- und Rasterbild ist;
Identifizieren eines aktuellen Editiermodus, in dem der Benutzer arbeitet;
Identifizieren, ob der Benutzer das identifizierte grafische Objekt zum Editieren gewählt hat oder nicht;
Identifizieren eines Werkzeugs zum Editieren grafischer Objekte, die gegenwärtig vom Benutzer aktiviert sind;
Bestimmen eines aktuellen Kontexts, in dem der Benutzer arbeitet, wobei der Kontext vom identifizierten grafischen Objekt, dem identifizierten Editiermodus, ob der Benutzer das identifizierte grafische Objekt zum Editieren gewählt hat oder nicht und dem identifizierten Werkzeug abhängt;
Identifizieren mindestens einer Steuerung, die mit dem aktuellen Kontext assoziiert ist, wobei verschiedene Kontexte im Allgemeinen mindestens mit einer unterschiedlichen Steuerung assoziiert sind;
Anzeigen des Bildes; und
Anzeigen der mindestens einen Steuerung, die mit dem aktuellen Kontext assoziiert ist, innerhalb eines Anzeigebalkens der Grafik-Software-Anwendung immer dann, wenn sich der aktuelle Kontext ändert.

2. Verfahren nach Anspruch 1, wobei eine Steuerung ein entsprechendes Steuerungsprogramm hat und wobei das Steuerungsprogramm das angezeigte grafische Objekt modifiziert.

3. Verfahren nach Anspruch 2, weiterhin umfassend:
Empfangen einer Meldung über ein Ereignis, das durch den Benutzer ausgelöst wurde, der eine Eingabe an einer ausgewählten der angezeigten Steuerungen vornimmt; und
Benachrichtigen des Steuerungsprogramms über die ausgewählte Steuerung.

4. Verfahren nach Anspruch 1, wobei ein Kontext eine einzigartige Kennung hat und wobei das Identifizieren mindestens einer Steuerung einen Zugriff auf eine Verweistabelle umfasst, die mit Kennungen für Kontexte verknüpft ist.

5. Benutzerschnittstelle zum Verwalten eines kontextabhängigen Anzeigebalkens, umfassend:
einen Kontextprozessor, umfassend:
eine Zustandskennung zum Identifizieren (i) eines grafischen Objekts, das durch eine Grafik-Software-Anwendung angezeigt wird, die von einem Benutzer betrieben wird, um ein Bild zu verarbeiten, wobei das Bild ein Vektorbild oder ein Rasterbild oder eine Kombination aus einem Vektor- und Rasterbild ist, (ii) eines Editiermodus, in dem der Benutzer arbeitet, wobei der Editiermodus anzeigt, ob der Benutzer das identifizierte grafische Objekt zum Editieren gewählt hat oder nicht, (iii) eines Werkzeugs zum Editieren grafischer Objekte, die durch den Benutzer aktiviert wurden, und (iv) mindestens einer Steuerung, die mit einem aktuellen Kontext, in dem der Benutzer arbeitet, assoziiert ist; und
eine Kontextkennung zum Bestimmen des aktuellen Kontexts, wobei der aktuelle Kontext vom identifizierten grafischen Objekt, dem identifizierten Editiermodus, ob der Benutzer das identifizierte grafische Objekt zum Editieren gewählt hat oder nicht und dem identifizierten Werkzeug abhängt, wobei verschiedene Kontexte im Allgemeinen mindestens mit einer unterschiedlichen Steuerung assoziiert sind; und
einen Anzeigemanager, der betriebsbereit mit dem Kontextprozessor zum Anzeigen (i) des Bildes und (ii) eines Anzeigebalkens, enthaltend die mindestens eine Steuerung, die mit dem aktuellen Kontext assoziiert ist, immer dann, wenn sich der aktuelle Kontext ändert, gekoppelt ist.

6. Benutzerschnittstelle nach Anspruch 5, wobei eine Steuerung ein entsprechendes Steuerungsprogramm hat und wobei das Steuerungsprogramm das angezeigte grafische Objekt modifiziert.

7. Benutzerschnittstelle nach Anspruch 6, weiterhin umfassend:
einen Nachrichtenempfänger zum Empfangen einer Meldung über ein Ereignis, das durch den Benutzer ausgelöst wurde, der eine Eingabe an einer ausgewählten der angezeigten Steuerungen vornimmt; und
einen Nachrichtensender zum Benachrichtigen des Steuerungsprogramms über die ausgewählte Steuerung.

8. Benutzerschnittstelle nach Anspruch 5, wobei ein Kontext eine einzigartige Kennung hat und wobei die Zustandskennung auf eine Verweistabelle zugreift, die mit Kennungen für Kontexte verknüpft ist.

9. Computerlesbares Speichermedium, das einen Programmcode speichert, um einen Computer zu veranlassen, das Verfahren von einem der Ansprüche 1 bis 4 auszuführen.

## Revendications

1. Procédé de gestion d'une barre d'affichage dépendante du contexte, comprenant :
l'identification d'un objet graphique actuellement affiché par une application logicielle graphique exploitée par un utilisateur à travers une interface utilisateur graphique pour traiter une image, dans lequel l'image est une image vectorielle ou une image matricielle ou une combinaison d'images vectorielle et matricielle ;
l'identification d'un mode d'édition actuel dans lequel l'utilisateur travaille ;
l'identification que l'utilisateur a sélectionné ou non l'objet graphique identifié pour édition ;
l'identification d'un outil pour éditer des objets graphiques actuellement activés par l'utilisateur ;
la détermination d'un contexte actuel dans lequel l'utilisateur travaille, le contexte dépendant de l'objet graphique identifié, du mode d'édition identifié, de la sélection ou non, par l'utilisateur, de l'objet graphique identifié pour édition, et de l'outil identifié ;
l'identification d'au moins une commande associée au contexte actuel, dans lequel différents contextes ont généralement au moins une commande différente associée à ceux-ci ;
l'affichage de l'image ; et
l'affichage de la au moins une commande associée au contexte actuel à l'intérieur d'une barre d'affichage de l'application logicielle graphique chaque fois que le contexte actuel change.

2. Procédé selon la revendication 1 dans lequel une commande a un manipulateur correspondant, et dans lequel le manipulateur modifie l'objet graphique associé.

3. Procédé selon la revendication 2, comprenant en outre :
la réception d'une notification d'un événement déclenché par l'utilisateur en réalisant une action d'entrée sur l'une sélectionnée des commandes affichées ; et
la notification au manipulateur de la commande sélectionnée.

4. Procédé selon la revendication 1, dans lequel un contexte a un identifiant unique et dans lequel ladite identification d'au moins une commande comprend l'accès à une table de correspondance basée sur des identifiants pour des contextes.

5. Interface utilisateur pour la gestion d'une barre d'affichage dépendante du contexte, comprenant :
un processeur de contexte comprenant :
un identifiant d'état pour l'identification (i) d'un objet graphique étant affiché par une application logicielle graphique exploitée par un utilisateur pour traiter une image, dans laquelle l'image est une image vectorielle ou une image matricielle ou une combinaison d'images vectorielle et matricielle, (ii) un mode d'édition à l'intérieur duquel l'utilisateur travaille, dans laquelle le mode d'édition indique si l'utilisateur a sélectionné ou non l'objet graphique identifié pour édition, (iii) un outil pour l'édition d'objets graphiques activés par l'utilisateur, et (iv) au moins une commande associée à un contexte actuel dans lequel l'utilisateur travaille ; et
un identifiant de contexte pour la détermination du contexte actuel, le contexte actuel dépendant de l'objet graphique identifié, du mode d'édition identifié, de la sélection ou non, par l'utilisateur, de l'objet graphique sélectionné identifié pour édition, et de l'outil identifié, dans lequel différents contextes ont généralement au moins une commande différente associée à ceux-ci ; et
un gestionnaire d'affichage couplé de manière fonctionnelle audit processeur de contexte pour affichage (i) de l'image, et (ii) une barre d'affichage incluant la au moins une commande associée au contexte actuel chaque fois que le contexte actuel change.

6. Interface utilisateur selon la revendication 5 dans laquelle une commande a un manipulateur correspondant, et dans laquelle le manipulateur modifie l'objet graphique affiché.

7. Interface utilisateur selon la revendication 6, comprenant en outre :
un récepteur de message pour la réception d'une notification d'un événement déclenché par l'utilisateur réalisant une action d'entrée sur l'une sélectionnée des commandes affichées ; et
un émetteur de message pour la notification au manipulateur de la commande sélectionnée.

8. Interface utilisateur selon la revendication 5, dans laquelle un contexte a un identifiant unique, et dans laquelle ledit identifiant d'état accède à une table de correspondance basée sur des identifiants pour des contextes.

9. Support de stockage lisible par ordinateur stockant du code de programme pour amener un ordinateur à réaliser le procédé selon l'une quelconque des revendications 1 à 4.
